# EUROPEAN PATENT APPLICATION

(11) **EP 4 572 572 A1**
(43) Date of publication of application: **18.06.2025**
(21) Application number: 24219274.8
(22) Date of filing: 12.12.2024
(51) Int. Cl.: H10H 20/83, H10H 20/831, H10H 20/84, H10H 20/85, H10H 29/01, H10H 29/14, H10H 29/80

(54) **ELECTRONIC DEVICE, SEMICONDUCTOR CHIP, AND MANUFACTURING METHOD OF ELECTRONIC DEVICE**

(30) Priority: 13.12.2023 US 202363609351 P; 18.12.2023 US 202363611214 P; 15.01.2024 US 202463620889 P; 15.01.2024 US 202463621092 P; 15.01.2024 US 202463621090 P; 15.01.2024 US 202463620892 P; 15.01.2024 US 202463620895 P
(71) Applicant: InnoLux Corporation, Jhunan Town Miao li 35053 (TW)
(72) Inventor: KUO, Shu-Ming, 35053 Jhunan Town, Miaoli County (TW); HSIEH, Tsau-Hua, 35053 Jhunan Town, Miaoli County (TW); YANG, Jan-Hsiang, 35053 Jhunan Town, Miaoli County (TW); YAN, Tzu-Min, 35053 Jhunan Town, Miaoli County (TW); SHIH, Jian-Jung, 35053 Jhunan Town, Miaoli County (TW); CHENG, Kai, 35053 Jhunan Town, Miaoli County (TW); LIN, Ming-Chang, 35053 Jhunan Town, Miaoli County (TW); LIN, Fang-Ying, 35053 Jhunan Town, Miaoli County (TW); CHIEN, Wei-Chen, 35053 Jhunan Town, Miaoli County (TW); YEH, Hsin-Liang, 35053 Jhunan Town, Miaoli County (TW)
(74) Representative: Becker, Eberhard

(57) **Abstract**

An electronic device (10') includes a substrate (210'), a circuit layer (220"), and a semiconductor chip (100"). The circuit layer (220") is disposed on the substrate (210'). The semiconductor chip (100") is disposed on the substrate (210') and electrically connected to the circuit layer (220"). The semiconductor chip (100") includes a semiconductor die (110'), a filler layer (120), a first electrode (130A), a second electrode (140A), and a reflective layer (150A). The semiconductor die (110') includes a first type semiconductor layer (111), an active layer (112), and a second type semiconductor layer (113) stacked in sequence. The filler layer (120) surrounds the semiconductor die (110'). The first electrode (130A) is electrically connected to the first type semiconductor layer (111). The second electrode (140A) is electrically connected to the second type semiconductor layer (113). Additionally, a semiconductor chip (100") and a method for manufacturing an electronic device (10') are provided.

## Description

### BACKGROUND

### Field of the Disclosure

The present disclosure relates to an electronic device, a semiconductor chip, and a method of manufacturing an electronic device.

### Description of Related Art

In horizontal-type semiconductor chips, two electrodes (for example, the P-type electrode and the N-type electrode) are situated on the same side of the chip, whereas in vertical-type semiconductor chips, two electrodes are positioned on opposite sides (for instance, on the upper and lower sides) of the chip. Consequently, vertical-type semiconductor chips facilitate more readily the miniaturization of area. However, subsequent to mass transfer, in the design of vertical-type semiconductor chips, the two electrodes are situated on opposite sides of the chip, which therefore presents difficulties in direct electrical measurement, thereby impeding yield monitoring.

Electronic devices or spliced electronic devices have been widely applied in various fields such as communications, display technologies, automotive applications, and aviation. With the rapid development of electronic devices, there is a trend towards miniaturization and thinning of these devices. Consequently, the requirements for reliability and quality of electronic devices have become increasingly stringent.

Electronic elements may be transferred to a target substrate through mass transfer technology. However, in existing mass transfer technologies, using a stamp transfer method to transfer electronic elements may result in insufficient randomness in the distribution of electronic elements on the target substrate, leading to regional disparities in the performance of electronic elements on the target substrate, namely, non-uniform performance overall, thereby causing a decrease in product performance. On the other hand, the stamp transfer method may also encounter issues of incomplete transfer of electronic elements, thereby increasing production costs. Therefore, how to improve the performance of electronic devices formed through mass transfer technology or reduce the production costs of electronic devices formed through mass transfer technology is one of the important issues in this field.

### SUMMARY OF THE DISCLOSURE

This disclosure provides an electronic device, a semiconductor chip, and a method of manufacturing an electronic device, which contribute to improving at least one of the aforementioned issues.

According to an embodiment of the disclosure, a semiconductor chip includes a semiconductor die, a filler layer, a first electrode, a second electrode, and a reflective layer. The semiconductor die includes a first type semiconductor layer, an active layer, and a second type semiconductor layer stacked in sequence. The filler layer surrounds the semiconductor die. The first electrode is electrically connected to the first type semiconductor layer. The second electrode is electrically connected to the second type semiconductor layer. The reflective layer is disposed on the filler layer.

According to an embodiment of the disclosure, the electronic device includes a substrate, a circuit layer, and a semiconductor chip. The circuit layer is disposed on the substrate. The semiconductor chip is disposed on the substrate and electrically connected to the circuit layer. The semiconductor chip includes a semiconductor die, a filler layer, a first electrode, a second electrode, and a reflective layer. The semiconductor die includes a first type semiconductor layer, an active layer, and a second type semiconductor layer stacked in sequence. The filler layer surrounds the semiconductor die. The first electrode is electrically connected to the first type semiconductor layer. The second electrode is electrically connected to the second type semiconductor layer. The reflective layer is disposed on the filler layer.

According to an embodiment of the disclosure, a method for manufacturing an electronic device includes: providing a plurality of semiconductor dies; performing a packaging process on the plurality of semiconductor dies to form a plurality of semiconductor chips, wherein the packaging process includes: respectively disposing a plurality of filler material layers on a sidewall of each of the plurality of semiconductor dies; disposing a first electrode on a first surface of each of the plurality of semiconductor dies; and disposing a conductive layer on the sidewall of each of the plurality of filler material layers; providing a substrate including a plurality of work regions, wherein each of the plurality of work regions includes at least one first recess; and disposing the plurality of semiconductor chips in the at least one first recess of the plurality of work regions by means of fluidic transfer.

To facilitate a clearer and more comprehensible elucidation of the aforementioned characteristics and advantages of this disclosure, exemplary embodiments shall be presented hereinafter, accompanied by detailed explanations in conjunction with the appended drawings.

### BRIEF DESCRIPTION OF THE DRAWINGS

The accompanying drawings are incorporated to provide a further understanding of the present disclosure, and are incorporated in and constitute a part of this specification. The drawings illustrate embodiments of the disclosure and, together with the description, serve to explain principles of the disclosure.
FIG. 1 and FIG. 3 are cross-sectional schematic views of two semiconductor chips according to some embodiments of the present disclosure.
FIG. 2, FIG. 4, FIG. 5, FIG. 6, FIG. 7, FIG. 8, and FIG. 9 are cross-sectional schematic views of seven semiconductor devices according to some embodiments of the present disclosure.
FIG. 10 to FIG. 15 are cross-sectional schematic views of electronic devices according to some embodiments of the present disclosure.
FIG. 16A, FIG. 17, FIG. 18A, FIG. 19, FIG. 20, FIG. 21, and FIG. 22A are top view schematic views of semiconductor chips according to some embodiments of the present disclosure.
FIG. 16B is a cross-sectional schematic view of the semiconductor chip of FIG. 16A taken along the section line I-I'.
FIG. 16C is a light-emitting perspective view of the semiconductor chip of FIG. 16A.
FIG. 18B is a light-emitting perspective view of the semiconductor chip of FIG. 18A.
FIG. 22B is a light-emitting perspective view of the semiconductor chip of FIG. 22A.
FIG. 23 illustrates an application of an electronic device according to an embodiment of the present disclosure.
FIG. 24 to FIG. 26 are cross-sectional schematic views of semiconductor chips according to some embodiments of the present disclosure.
FIG. 27 and FIG. 28 are cross-sectional schematic views of electronic devices according to some embodiments of the present disclosure.
FIG. 29A to FIG. 29D are cross-sectional schematic views illustrating a method of manufacturing a semiconductor chip according to an embodiment of the present disclosure.
FIG. 30A to FIG. 30E are cross-sectional schematic views illustrating a method of manufacturing a semiconductor chip according to another embodiment of the present disclosure.
FIG. 31A to FIG. 31C are cross-sectional schematic views illustrating a method of manufacturing a semiconductor chip according to yet another embodiment of the present disclosure.
FIG. 32 is a cross-sectional schematic view of a semiconductor chip according to an embodiment of the present disclosure.
FIG. 33 is a cross-sectional schematic view of a semiconductor chip according to another embodiment of the present disclosure.
FIG. 34A to FIG. 34B are cross-sectional schematic views of a semiconductor chip according to still another embodiment of the present disclosure.
FIG. 35A to FIG. 35B are cross-sectional schematic views of a semiconductor chip according to a further embodiment of the present disclosure.
FIG. 36 is a flow chart diagram illustrating a method of manufacturing an electronic device according to an embodiment of the present disclosure.
FIG. 37 is a schematic view illustrating a fluidic transfer process according to an embodiment of the present disclosure.
FIG. 38 is a schematic top view of a substrate and an electronic unit according to an embodiment of the present disclosure.
FIG. 39 is a schematic view illustrating the placement of remedial electronic unit according to an embodiment of the present disclosure.
FIG. 40 is a schematic view illustrating a variant embodiment of placement of remedial electronic unit according to an embodiment of the present disclosure.
FIG. 41 is a schematic top view of a substrate and an electronic unit after a remedial process according to an embodiment of the present disclosure.
FIG. 42 is a flow chart diagram illustrating a method of manufacturing an electronic device according to another embodiment of the present disclosure.
FIG. 43 illustrates a schematic view of transferring electronic unit from a first substrate using a stamp transfer method.
FIG. 44 is a schematic view illustrating a fluidic transfer process according to another embodiment of the present disclosure.
FIG. 45 is a schematic view illustrating the transfer of electronic units from a second substrate to a third substrate according to another embodiment of the present disclosure.
FIG. 46 is a schematic view illustrating a variant embodiment of transferring electronic units from a second substrate to a third substrate according to another embodiment of the present disclosure.
FIG. 47 is a cross-sectional schematic view of an electronic device according to another embodiment of the present disclosure.
FIG. 48 is a schematic top view of a substrate and an electronic unit according to another embodiment of the present disclosure.
FIG. 49 is a flow chart diagram illustrating a method of manufacturing electronic units for an electronic device according to an embodiment of the present disclosure.
FIG. 50 is a schematic view of a process of electronic units for an electronic device according to an embodiment of the present disclosure.
FIG. 51 is a cross-sectional schematic view of electronic units for an electronic device according to an embodiment of the present disclosure.
FIG. 52 is a cross-sectional schematic view of electronic units for an electronic device according to another embodiment of the present disclosure.
FIG. 53 is a schematic view illustrating a variant embodiment of a fluidic transfer process according to still another embodiment of the present disclosure.
FIG. 54 is a top view of a semiconductor chip according to an embodiment of the present disclosure.
FIG. 55 is a cross-sectional view corresponding to the cross-sectional line II-II' in FIG. 54.
FIG. 56 and FIG. 57 are partial cross-sectional views of two types of semiconductor chips according to other embodiments of the present disclosure.
FIG. 58 and FIG. 59 are top views of two types of semiconductor chips according to other embodiments of the present disclosure.

### DESCRIPTION OF EMBODIMENTS

Reference shall now be made in detail to exemplary embodiments, examples of which are illustrated in the accompanying drawings. Where possible, the same reference numerals are used in the drawings and the description to refer to the same or like parts.

Throughout the specification and the accompanying claims, certain terminology are employed to refer to specific elements. Those skilled in the art should understand that electronic device manufacturers may use different nomenclature to refer to the same elements. The specification does not intend to distinguish between elements that have the same function but different names. In the following specification and claims, the terms "comprising" and "including" are open-ended terms and should be interpreted as meaning "including, but not limited to...".

The directional terms mentioned in this document, such as "above," "below," "front," "back," "left," "right," and the like, are solely in reference to the orientation depicted in the accompanying figures. Therefore, the use of such directional terminology is for descriptive purposes and is not intended to be limiting in nature. In the accompanying figures, each illustration represents the general characteristics of the methods, structures, and/or materials employed in specific embodiments. However, these figures should not be construed as defining or limiting the scope or nature of the embodiments described herein. For instance, the relative dimensions, thicknesses, and positions of various layers, regions, and/or structures may be reduced or enlarged for clarity of presentation.

In this disclosure, when one structure (or layer, element, substrate) is described as being "on" or "above" another structure (or layer, element, substrate), it may refer to the two structures being adjacent and directly connected, or it may indicate that the two structures are adjacent but not directly connected. The absence of direct connection implies the presence of at least one intermediate structure (or intermediate layer, intermediate element, intermediate substrate, intermediate spacing) between the two structures. In such cases, the lower surface of one structure is adjacent to or directly connected to the upper surface of the intermediate structure, while the upper surface of the other structure is adjacent to or directly connected to the lower surface of the intermediate structure. The intermediate structure may be composed of single or multiple layers of physical or non-physical structures, without limitation. In this disclosure, when a structure is described as being "on" other structures, it may indicate that the structure is "directly" on the other structures, or that the structure is "indirectly" on the other structures, meaning that there is at least one structure interposed between the structure and the other structures.

The terms "approximately," "substantially," or "about" shall generally be construed to mean within 10% of the stated value or range, or alternatively within 5%, 3%, 2%, 1%, or 0.5% of the stated value or range. Furthermore, the phrases "ranging from a first value to a second value" or "in the range between a first value and a second value" shall be interpreted to include the first value, the second value, and all values therebetween.

The ordinal numbers such as "first," "second," and so forth, used in the specification and claims to modify elements, do not in themselves imply or represent any previous ordinal for that element or those elements, nor do they represent the order of one element in relation to another element, or the order in a manufacturing process. The use of such ordinal numbers is solely for the purpose of clearly distinguishing between elements that bear the same name. The terminology used in the claims need not be identical to that used in the specification; consequently, an element referred to as the first element in the specification may be designated as the second element in the claims.

The electrical connections or couplings described in this disclosure may refer to either direct connections or indirect connections. In the case of direct connections, the terminals of elements on two circuits are directly connected or interconnected by a conductive segment. In the case of indirect connections, there may be switches, diodes, capacitors, inductors, resistors, other appropriate elements, or combinations thereof between the terminals of elements on two circuits, but not limited to these elements.

In some embodiments disclosed herein, optical microscopes (OM), scanning electron microscopes (SEM), α-step profilometers, ellipsometers, or other suitable methods may be employed to measure the area, width, thickness, or height of various elements, or the distance or spacing between elements. Specifically, according to some embodiments, a scanning electron microscope may be utilized to obtain cross-sectional structural images of the elements to be measured, and to measure the area, width, thickness, or height of various elements, or the distance or spacing between elements. Furthermore, a certain margin of error may exist between any two values or directions used for comparison. Additionally, the phrases "a given range is from a first value to a second value," "a given range falls within the range of a first value to a second value," or "a given range is between a first value and a second value" indicate that the given range includes the first value, the second value, and other values between them. If a first direction is perpendicular to a second direction, the angle between the first direction and the second direction may be between 80 degrees and 100 degrees; if a first direction is parallel to a second direction, the angle between the first direction and the second direction may be between 0 degrees and 10 degrees.

Unless otherwise defined, all terms (including technical and scientific terms) used herein have the same meaning as commonly understood by one of ordinary skill in the art to which this disclosure belongs. It is to be understood that terms, such as those defined in commonly used dictionaries, should be interpreted as having a meaning that is consistent with their meaning in the context of the relevant art and this disclosure and should not be interpreted in an idealized or overly formal sense unless expressly so defined herein.

In this disclosure, electronic devices may include, but are not limited to, semiconductor devices, display devices, backlight devices, antenna devices, packaging devices, sensing devices, or spliced devices. The electronic devices may be flexible or bendable electronic devices. Display devices may be non-self-emissive or self-emissive display devices. Display devices may include, for example, liquid crystal, light-emitting diodes, fluorescence, phosphor, quantum dots (QD), other suitable display media, or combinations thereof. Antenna devices may include, for example, Reconfigurable Intelligent Surfaces (RIS), Frequency Selective Surfaces (FSS), RF-Filters, polarizers, resonators, or antennas. Antennas may be liquid crystal-based antennas or varactor diodes antennas. Sensing devices may be devices that sense capacitance, light, thermal energy, or ultrasound, but are not limited thereto. In this disclosure, electronic devices may include electronic elements, which may include passive and active elements, such as capacitors, resistors, inductors, diodes, and transistors. Diodes may include light-emitting diodes, varactor diodes, or photodiodes. Light-emitting diodes may include, for example, organic light-emitting diodes (OLED), mini LEDs, micro LEDs, or quantum dot LEDs, but are not limited thereto. Spliced devices may include, for example, display spliced devices or antenna spliced devices, but are not limited thereto. It should be noted that electronic devices may be any combination of the aforementioned, but are not limited thereto. Packaging devices may be applicable to Wafer-Level Package (WLP) technology or Panel-Level Package (PLP) technology, such as chip-first or chip-last process packaging devices. Furthermore, the shape of the electronic devices may be rectangular, circular, polygonal, with curved edges, or other suitable shapes. Electronic devices may have peripheral systems such as driving systems, control systems, and light source systems to support display devices, antenna devices, wearable devices (including augmented reality or virtual reality), vehicular devices (including car windshields), or spliced devices.

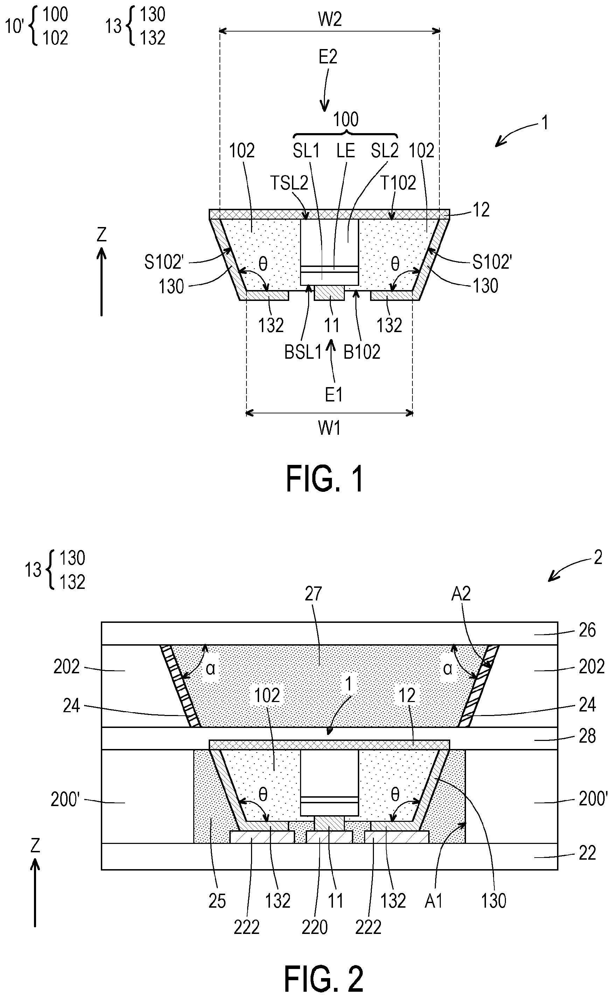

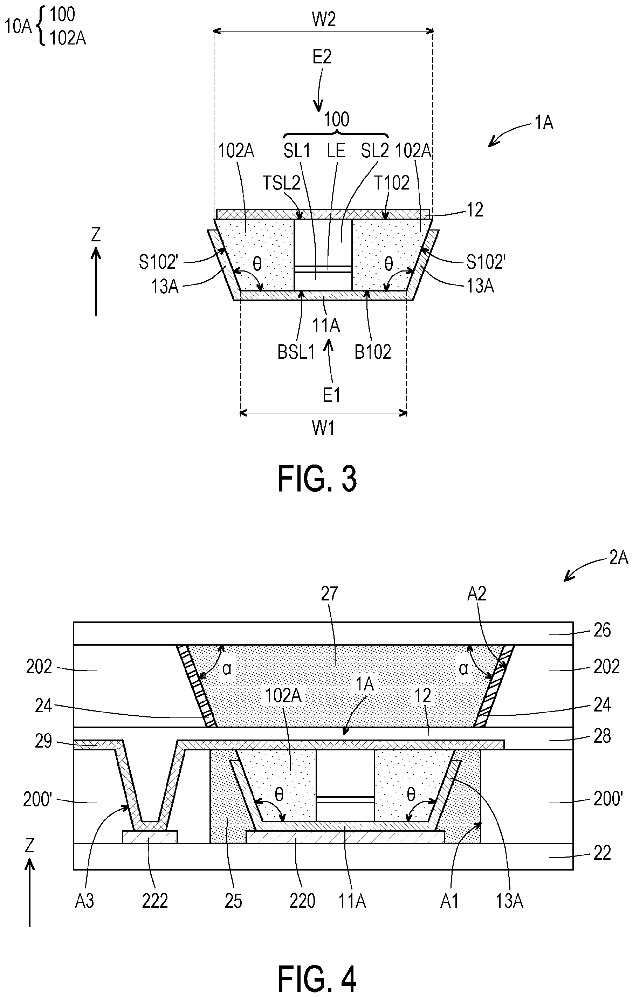

FIG. 1 and FIG. 3 are cross-sectional schematic views of two types of semiconductor chips according to some embodiments of the present disclosure. FIG. 2, FIG. 4, FIG. 5, FIG. 6, FIG. 7, FIG. 8, and FIG. 9 are cross-sectional schematic views of seven types of semiconductor devices according to some embodiments of the present disclosure. It should be noted that in the following exemplary embodiments, features from several different embodiments may be substituted, recombined, or mixed to complete other embodiments without departing from the spirit of the present disclosure. Features between various embodiments may be arbitrarily combined and used as long as they do not contravene the inventive concept or conflict with each other.

Please refer to FIG. 1. The semiconductor chip 1 may include a semiconductor unit 10', a first electrode 11, a second electrode 12, and a reflective layer 13. The semiconductor unit 10' includes a semiconductor die 100 and a filler layer 102. The semiconductor die 100 includes a first type semiconductor layer SL1, an active layer LE, and a second type semiconductor layer SL2 stacked in sequence. The filler layer 102 surrounds the semiconductor die 100. The first electrode 11 is disposed on the first side E1 (as shown on the lower side in FIG. 1) of the semiconductor unit 10' and is electrically connected to the first type semiconductor layer SL1. The second electrode 12 is disposed on the second side E2 (as shown on the upper side in FIG. 1) of the semiconductor unit 10' and is electrically connected to the second type semiconductor layer SL2. The material of the second electrode 12 includes a transparent conductive material. The reflective layer 13 is disposed on the lateral surface S102' of the filler layer 102. In the cross-sectional view, as shown in FIG. 1, the lateral surface S102' of the filler layer 102 is connected to the top surface T102 of the filler layer 102. In this disclosure, the semiconductor device is, for example, a light-emitting device, the semiconductor chip is, for example, a light-emitting chip, the semiconductor unit is, for example, a light-emitting unit, and the semiconductor die is, for example, a light-emitting diode.

In more detail, the semiconductor die 100 of the semiconductor unit 10' is designed to provide light, such as visible or non-visible light, without limitation. Within the semiconductor die 100, the first type semiconductor layer SL1, the active layer LE, and the second type semiconductor layer SL2 are stacked in sequence, for example, along the thickness direction (e.g., direction Z) of the semiconductor chip 1. In other words, the active layer LE is positioned between the first type semiconductor layer SL1 and the second type semiconductor layer SL2. In some embodiments, the active layer LE may include a light-emitting layer, a photosensitive layer, or an intrinsic layer.

The first type semiconductor layer SL1 and the second type semiconductor layer SL2 may respectively be a P-type semiconductor layer and an N-type semiconductor layer. Alternatively, the first type semiconductor layer SL1 and the second type semiconductor layer SL2 may respectively be an N-type semiconductor layer and a P-type semiconductor layer. The active layer LE may include a quantum well layer or a plurality of quantum well (MQW) layer, which shall not be construed as limiting herein.

The filler layer 102 of the semiconductor unit 10' surrounds the semiconductor die 100. By way of example, the filler layer 102 may at least contact the lateral surface of the semiconductor die 100. For the sake of clarity in the illustration, FIG. 1 does not label the lateral surface of the semiconductor die 100. The lateral surface of the semiconductor die 100 may include, for instance, the lateral surface of the first type semiconductor layer SL1, the lateral surface of the active layer LE, and the lateral surface of the second type semiconductor layer SL2.

The filler layer 102 may expose at least a portion of the bottom surface BSL1 of the first type semiconductor layer SL1, facilitating electrical connection between the first type semiconductor layer SL1 and the first electrode 11. For example, the first electrode 11 may be disposed on the bottom surface BSL1 exposed by the filler layer 102, but is not limited thereto. In some embodiments, as illustrated in FIG. 1, the filler layer 102 may partially cover the bottom surface BSL1 of the first type semiconductor layer SL1, such that the bottom surface B102 of the filler layer 102 is lower than the bottom surface BSL1 of the first type semiconductor layer SL1. However, the present disclosure is not limited to this configuration.

The filler layer 102 may expose at least a portion of the top surface TSL2 of the second type semiconductor layer SL2, facilitating electrical connection between the second type semiconductor layer SL2 and the second electrode 12. For example, the second electrode 12 may be disposed on the top surface TSL2 exposed by the filler layer 102, but is not limited thereto. In some embodiments, as shown in FIG. 1, the top surface T102 of the filler layer 102 may be aligned with the top surface TSL2 of the second type semiconductor layer SL2. In embodiments where the second electrode 12 is further disposed on the top surface T102 of the filler layer 102, as illustrated in FIG. 1, the coplanar design of the top surface T102 of the filler layer 102 and the top surface TSL2 of the second type semiconductor layer SL2 helps reduce the probability of disconnection in the second electrode 12 due to surface discontinuities. It should be understood that the filler layer 102 may be a single-layer structure or a multi-layer structure. The second electrode 12 is at least partially disposed on the top surface T102 of the filler layer 102.

The lateral surface S102' of the filler layer 102, for example, connects the top surface T102 of the filler layer 102 and the bottom surface B102 of the filler layer 102, and the lateral surface S102' of the filler layer 102 is provided to support the reflective layer 13. In some embodiments, the cross-sectional shape of the filler layer 102 may approximate an inverted trapezoid with a hollow center. For instance, as shown in the cross-sectional view in FIG. 1, the semiconductor unit 10' has a first width W1 on the first side E1 and a second width W2 on the second side E2, wherein the second width W2 is greater than the first width W1. Furthermore, the angle θ between the lateral surface S102' and the bottom surface B102 of the filler layer 102 is, for example, greater than or equal to 100 degrees and less than or equal to 170 degrees, greater than or equal to 90 degrees and less than or equal to 135 degrees, or greater than or equal to 110 degrees and less than or equal to 150 degrees. By changing the angle θ, the inclination angle of the reflective layer 13 positioned on the lateral surface S102' of the filler layer 102 may be modified, thereby potentially enhancing light extraction efficiency, altering the light pattern or modifying the light intensity distribution of the light emitted from the semiconductor unit 10'.

The material for the filler layer 102 may be selected from transparent dielectric materials to reduce the propagation loss of light within the filler layer 102. For example, the material of the filler layer 102 may include acrylic-based materials, siloxane materials, photoresists, silica, or other materials with a transmittance greater than 80% or even 90%. For instance, when the semiconductor die 100 provides visible light (e.g., light with wavelengths between 400 nm and 700 nm), the material for the filler layer 102 may be selected from materials with a transmittance greater than 80% or even 90% for visible light.

The first electrode 11 is, for example, disposed on the bottom surface BSL1 of the first type semiconductor layer SL1 and in contact with the bottom surface BSL1 of the first type semiconductor layer SL1. In some embodiments, an ohmic contact layer (not shown) may be present between the first type semiconductor layer SL1 and the first electrode 11. The ohmic contact layer may include a metal oxide. The metal oxide may include indium tin oxide (ITO), indium zinc oxide (IZO), aluminum tin oxide, aluminum zinc oxide, indium germanium zinc oxide, or other metal oxides. In some embodiments, the material of the first electrode 11 may include silver, aluminum, or other metals and/or alloys with high reflectivity, for instance, metals or alloys with reflectivity higher than 60% for visible light, but not limited thereto. In other embodiments, the material of the first electrode 11 may include gold, copper, or other metals and/or alloys with high conductivity, and a non-conductive reflective layer, such as a distributed Bragg reflector (DBR), may be formed on the inner side (the side closer to the semiconductor unit 10') of the highly conductive metal and/or alloy, but not limited thereto.

The second electrode 12 is, for example, disposed on the top surface TSL2 of the second type semiconductor layer SL2 and the top surface T102 of the filler layer 102, as well as in contact with the top surface TSL2 of the second type semiconductor layer SL2 and the top surface T102 of the filler layer 102. In some embodiments, an ohmic contact layer (not shown) may be present between the second type semiconductor layer SL2 and the second electrode 12. The material of the second electrode 12 includes a transparent conductive material, allowing light to pass through the second electrode 12. The transparent conductive material may include metal oxides, graphene, metal, other suitable transparent conductive materials, or combinations thereof. The metal oxides may include indium tin oxide, indium zinc oxide, aluminum tin oxide, aluminum zinc oxide, indium germanium zinc oxide, or other metal oxides. Alternatively, the transparent conductive material may include thin metal or metal mesh, for instance, a very thin metal layer (e.g., magnesium layer or silver layer) may be formed, or a metal mesh layer with light-transmitting openings may be formed through screen printing or other patterning processes, allowing light to pass through the second electrode 12.

The reflective layer 13 serves to reflect light, enabling the semiconductor chip 1 to emit more light. In some embodiments, the reflective layer 13 may further function as an extension electrode of the second electrode 12. By means of the reflective layer 13, the bonding terminal of the second electrode 12 may be relocated to a side (such as the first side E1) where the first electrode 11 is located, forming a flip-chip bonding structure. Such configuration facilitates the reduction of difficulties in electrical measurements after mass transfer, making yield monitoring more manageable. As illustrated in FIG. 1, the second electrode 12 may be electrically connected to the reflective layer 13; for instance, the second electrode 12 may extend further onto the reflective layer 13 and connect with the reflective layer 13, but this is not limited to this configuration. Furthermore, the reflective layer 13 may include a first portion 130 and a second portion 132. The first portion 130 is disposed on the lateral surface S102' of the filler layer 102, while the second portion 132 is situated on the bottom surface B102 of the filler layer 102. The second electrode 12 may be disposed on the top surface TSL2 of the second type semiconductor layer SL2 and the top surface T102 of the filler layer 102, connecting with the first portion 130. The second portion 132 is separated from the first electrode 11 to maintain independent electrical properties, and the second portion 132 may be electrically connected to the second electrode 12 through the first portion 130. In some embodiments, the reflective layer 13 and the first electrode 11 may include the same material and be fabricated through the same photolithography process. The first electrode 11 and the second portion 132 are disposed on the same side of the semiconductor die 100.

The angle between the first portion 130 and the second portion 132 is equal to or approximately equal to the angle θ between the lateral surface S102' and the bottom surface B102 of the filler layer 102. In some embodiments, the angle (angle Θ) between the first portion 130 and the second portion 132 is, for example, greater than or equal to 100 degrees and less than or equal to 170 degrees, greater than or equal to 90 degrees and less than or equal to 135 degrees, or greater than or equal to 110 degrees and less than or equal to 150 degrees. Furthermore, the material of the reflective layer 13 may include, but is not limited to, silver, aluminum, tin, indium, gold, or a combination thereof.

FIG. 2 depicts a semiconductor device 2 including the semiconductor chip 1 of FIG. 1. Referring to FIG. 2, the semiconductor device 2, in addition to the semiconductor chip 1, may further include at least one light-converging element positioned above the semiconductor chip 1. As exemplified in FIG. 2, the aforementioned light-converging element may be a combination of a reflective layer 24, a filler layer 27, and a bank layer 202. In some embodiments, as illustrated in FIG. 2, the semiconductor device 2 may further incorporate a circuit substrate 22, wherein the semiconductor chip 1 and the at least one light-converging element (e.g., the reflective layer 24, filler layer 27, and bank layer 202) are disposed on the circuit substrate 22. The circuit substrate 22 includes a first pad 220 electrically connected to the first electrode 11 and a second pad 222 electrically connected to the second electrode 12. The materials constituting the first pad 220 and the second pad 222 may include gold, tin, indium, copper, or other suitable conductive materials.

In some embodiments, as shown in FIG. 2, the semiconductor device 2 may further include a unit defining layer 200', which is positioned on the circuit substrate 22 and has a first opening A1. The semiconductor chip 1 is situated within the first opening A1. A bank layer 202 is positioned on the unit defining layer 200' and has a second opening A2 that overlaps with the first opening A1. The materials of the unit defining layer 200' and the bank layer 202 may include organic photoresist, and the color of the unit defining layer 200' and the bank layer 202 may be transparent, black, white, or other colors, but is not limited thereto. In some embodiments, a reflective layer 24 may be formed on the inner wall of the bank layer 202 to enhance light extraction efficiency. The material of the reflective layer 24 may include silver, aluminum, or other materials with high reflectivity (e.g., distributed Bragg reflector). In some embodiments, the filler layer 27 is disposed within the second opening A2. Reference of the material of the filler layer 27 may be made to the material of the filler layer 102, which will not be reiterated herein.

In some embodiments, as illustrated in FIG. 2, the first pad 220 and the second pad 222 are situated within the first opening A1. The second electrode 12 is additionally positioned on the top surface T102 of the filler layer 102, and the second electrode 12 may be electrically connected to the second pad 222 through the reflective layer 13. Specifically, when the semiconductor chip 1 is bonded to the circuit substrate 22, the first pad 220 and the second pad 222 may be respectively bonded to the first electrode 11 and the second portion 132 of the reflective layer 13. Moreover, the second electrode 12 may be electrically connected to the second pad 222 through the first portion 130 and the second portion 132. Given that the second portion 132 and the first electrode 11 are located on the same side (e.g., the lower side) of the semiconductor chip 1, this configuration facilitates the reduction of difficulties in electrical measurements subsequent to mass transfer, thereby rendering yield monitoring more manageable.

In some embodiments, as illustrated in FIG. 2, the semiconductor device 2 may further include a filler layer 25, a substrate 26, and an adhesive layer 28, but is not limited thereto. Depending on various requirements, the semiconductor device 2 may incorporate or omit one or more elements or film layers.

The filler layer 25 is disposed within the first opening A1. The filler layer 25 may enhance the adhesion between the semiconductor chip 1 and the circuit substrate 22. The material of the filler layer 25 may be referenced to the material of the filler layer 102, which will not be reiterated herein.

The substrate 26 is a transparent substrate, and the substrate 26 may be used to support the at least one light-converging element (for example, including the bank layer 202, the reflective layer 24, and the filler layer 27). Specifically, the bank layer 202, the reflective layer 24, and the filler layer 27 may be formed on the substrate 26 and then bonded to the circuit substrate 22 through the adhesive layer 28. The substrate 26 may be a rigid substrate or a flexible substrate. The material of the substrate 26 may include, but is not limited to, glass, quartz, ceramic, sapphire, or plastic. The plastic may include, but is not limited to, polycarbonate (PC), polyimide (PI), polypropylene (PP), polyethylene terephthalate (PET), other suitable flexible materials, or combinations thereof. The material of the adhesive layer 28 may include, but is not limited to, optical clear adhesive (OCA) or optical clear resin (OCR).

In some embodiments, the angle α between the substrate 26 and the reflective layer 24 is, for example, greater than or equal to 10 degrees and less than or equal to 80 degrees, or greater than or equal to 30 degrees and less than or equal to 70 degrees. By changing the angle α, the inclination angle of the reflective layer 24 may be modified, thereby potentially enhancing light extraction efficiency, altering the light pattern or modifying the light intensity distribution of the light emitted from the semiconductor device 2.

In other embodiments, although not illustrated, the bank layer 202 may be directly formed on the unit defining layer 200'. Consequently, the semiconductor device 2 may not include the adhesive layer 28 and the substrate 26. Alternatively, the at least one light-converging element may not include the filler layer 27.

Based on a simulation result, compared to conventional semiconductor chips, the design of semiconductor chip 1 contributes to increasing the luminous intensity from 100% to greater than 250% and reducing the angle of the full width at half maximum (FWHM) of the light pattern from ±65° to ±35°. Furthermore, the design of the semiconductor chip 1 in conjunction with the at least one light-converging element contributes to increasing the luminous intensity from 100% to greater than 550% and reducing the angle of the full width at half maximum (FWHM) of the light pattern from ±65° to ±25°.

Please refer to FIG. 3. The main differences between the semiconductor chip 1A and the semiconductor chip 1 in FIG. 1 are explained as follows. In the semiconductor chip 1A, the second electrode 12 is electrically insulated from the reflective layer 13A. For example, the second electrode 12 and the reflective layer 13A may be separated from each other to maintain independent electrical properties. Furthermore, the first electrode 11A is, for instance, disposed on the bottom surface BSL1 of the first type semiconductor layer SL1 and the bottom surface B102 of the filler layer 102A, and is connected to the reflective layer 13A. In some embodiments, the first electrode 11A and the reflective layer 13A may be formed together, for example, using the same material and the same process, but this is not limited thereto. In other embodiments, the first electrode 11A and the reflective layer 13A may be formed separately. The angle between the first electrode 11A and the reflective layer 13A is equal or approximately equal to the angle θ between the lateral surface S102' and the bottom surface B102 of the filler layer 102A. In some embodiments, the angle (angle θ) between the first electrode 11A and the reflective layer 13A is, for example, greater than or equal to 100 degrees and less than or equal to 170 degrees, greater than or equal to 90 degrees and less than or equal to 135 degrees, or greater than or equal to 110 degrees and less than or equal to 150 degrees. In some embodiments, as shown in FIG. 2, the filler layer 102A may expose the entire bottom surface BSL1 of the first type semiconductor layer SL1, and the bottom surface B102 of the filler layer 102Amay be aligned with the bottom surface BSL1 of the first type semiconductor layer SL1, thereby reducing the probability of disconnection of the first electrode 11A due to surface discontinuity. In some embodiments, although not shown, the second electrode 12 is connected to the reflective layer 13A, the reflective layer 13A does not extend to the bottom surface B102 of the filler layer 102A, and the reflective layer 13A is not connected to the first electrode 11A. In the aforementioned embodiments, the semiconductor chip 1A remains a vertical type semiconductor chip and is not converted into a horizontal type semiconductor chip through the reflective layer 13A.

FIG. 4 illustrates a semiconductor device 2A, which includes the semiconductor chip 1A shown in FIG. 3. Referring to FIG. 4, the main differences between the semiconductor device 2A and the semiconductor device 2 of FIG. 2 are explained as follows. In the semiconductor device 2A, the first pad 220 is located within the first opening A1. The unit defining layer 200' further has a third opening A3, which partially exposes the second pad 222. Additionally, the semiconductor device 2A further includes a connecting line 29 positioned on the unit defining layer 200' and within the third opening A3. Furthermore, the second electrode 12 is electrically connected to the second pad 222 through this connecting line 29. Specifically, when the semiconductor chip 1A is bonded to the circuit substrate 22, the first pad 220 and the second pad 222 may be bonded to the first electrode 11A and the connecting line 29, respectively. Consequently, the second electrode 12 may be electrically connected to the second pad 222 through the connecting line 29. In some embodiments, the second electrode 12 and the connecting line 29 may be formed simultaneously, for example, using the same material and manufacturing process, though this is not a limitation.

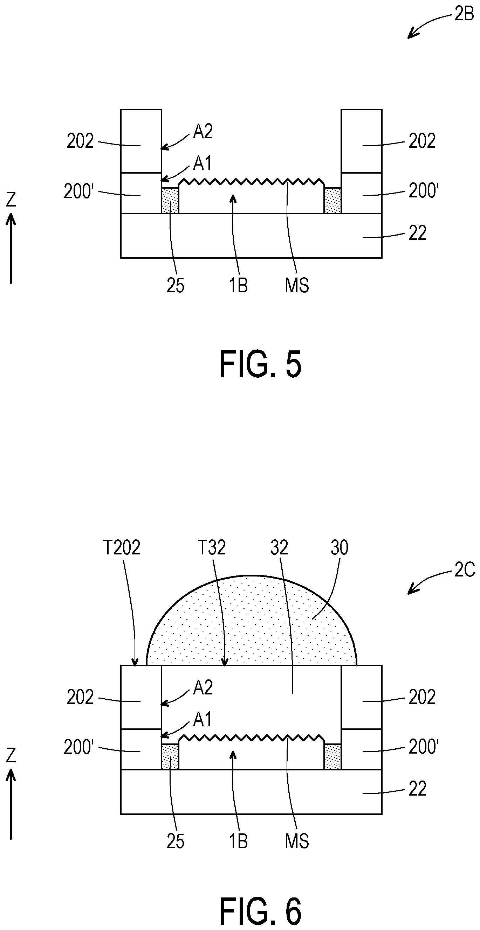

FIG. 5 to FIG. 9 are cross-sectional schematic views of various semiconductor devices according to other embodiments of the present disclosure. For the sake of clarity in the drawings, the first pad 220 and the second pad 222 are omitted from FIG. 5 to FIG. 9. Additionally, the detailed structure of the semiconductor chip 1B and the electrical connection details between the semiconductor chip 1B and the circuit substrate 22 are not shown. Depending on specific requirements, the semiconductor chip 1B in FIG. 5 to FIG. 9 may utilize the semiconductor chip 1 or the semiconductor chip 1A. For details regarding the electrical connection between the semiconductor chip 1B and the circuit substrate 22, reference may be made to the descriptions of FIG. 2 or FIG. 4, which will not be reiterated herein.

Please refer to FIG. 5. The primary differences between the semiconductor device 2B and the semiconductor device 2 or the semiconductor device 2A are elucidated as follows. The semiconductor device 2B does not incorporate the substrate 26, the filler layer 27, and the adhesive layer 28 as depicted in FIG. 2 or FIG. 4. Furthermore, the light-emitting surface (such as the top surface of semiconductor chip 1B) of the semiconductor chip 1B is configured with a plurality of microstructures MS. The plurality of microstructures MS are exemplarily formed by roughening or patterning the top portion of the semiconductor chip 1B, but are not limited to this method of formation. In some embodiments, the plurality of microstructures MS are formed through epitaxial growth on a patterned sapphire substrate.

In other embodiments, although not illustrated, the unit defining layer 200' and the bank layer 202 may be replaced with a single-layer structure. For example, the reflective element may be constituted by a single layer of the photoresist layer, and the single layer of the photoresist layer may be formed with an opening to accommodate the semiconductor chip 1B. All subsequent embodiments may be similarly modified, and this will not be reiterated hereafter. In some embodiments, the unit defining layer 200' and the bank layer 202 are reflective.

Based on a simulation result, compared to directly placing the semiconductor chip on the circuit substrate, the present embodiment, by establishing a reflective unit defining layer 200' and a bank layer 202 around the semiconductor chip 1B, may increase the brightness from 100% to 161% and the luminous flux from 100% to 108%.

Please refer to FIG. 6. The main differences between the semiconductor device 2C and the semiconductor device 2B in FIG. 5 are explained as follows. In the semiconductor device 2C, the at least one light-converging element further includes a lens element 30. The lens element 30 is disposed above the bank layer 202 and the semiconductor chip 1B. The material of the lens element 30 may include photoresist, and the lens element 30 may be formed by methods such as molding, photolithography, or stamping, but is not limited thereto. In some embodiments, a filler layer 32 may be disposed on the filler layer 25 and the semiconductor chip 1B, and located within the first opening A1 and the second opening A2. The top surface T32 of the filler layer 32 may be aligned with the top surface T202 of the bank layer 202, so as to provide a plane for supporting the lens element 30. The material of the filler layer 32 may be referenced to the material of the filler layer 25, which will not be reiterated herein.

In other embodiments, although not illustrated, a single filler layer may replace both the filler layer 25 and the filler layer 32.

Through the implementation of the lens element 30, refraction may be utilized to narrow or converge the light emitted from the semiconductor device 2C, thereby increasing the brightness of the semiconductor device 2C or reducing the divergence angle of light. According to a simulation result, compared to directly placing the semiconductor chip on the circuit substrate, the present embodiment, by positioning at least one light-converging element (e.g., filler layer 32, bank layer 202, and lens element 30) above the semiconductor chip 1B and arranging a reflective unit defining layer 200' around the semiconductor chip 1B, may enhance the brightness from 100% to 277% and increase the luminous flux from 100% to 103%.

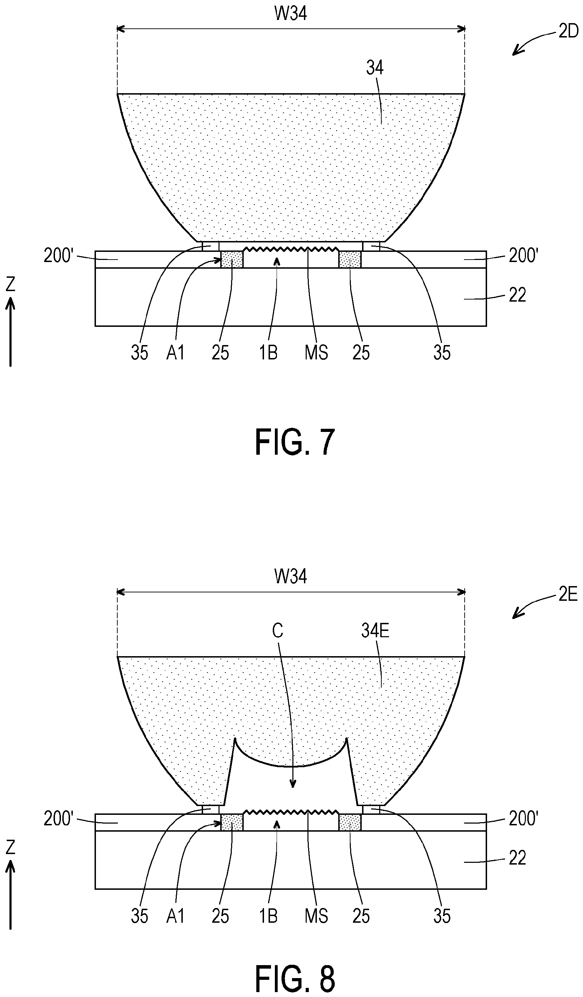

Please refer to FIG. 7. The main differences between the semiconductor device 2D and the semiconductor device 2B in FIG. 5 are explained as follows. The semiconductor device 2D does not include the bank layer 202, and the filler layer 25 fully fills the space in the first opening A1 not occupied by the semiconductor chip 1B. The at least one light-converging element includes a reflector cup element 34, and the reflector cup element 34 is positioned above the unit defining layer 200' and the semiconductor chip 1B. For example, the semiconductor device 2D may further include an adhesive layer 35, and the reflector cup element 34 may be bonded to the unit defining layer 200' through the adhesive layer 35, but is not limited thereto. In other embodiments, the reflector cup element 34 may be secured on the unit defining layer 200' through other fixing mechanisms (e.g., snap-fit structures or other mechanical elements). The reflector cup element 34 may be a parabolic reflector cup, but is not limited thereto. The material of the reflector cup element 34 may include acrylic resin, but is not limited thereto. The material of the adhesive layer 35 may be referenced to the material of the adhesive layer 28, which will not be reiterated herein.

Through the configuration of the reflector cup element 34, refraction may be utilized to narrow or converge the light emitted from the semiconductor device 2D, thereby increasing the brightness of the semiconductor device 2D, reducing the divergence angle of light, or altering the light pattern. In some embodiments, the brightness or light pattern may be modified by adjusting the maximum width W34 of the reflector cup element 34. For instance, the maximum width W34 of the reflector cup element 34 may be 100 micrometers (µm) or 150 µm, but is not limited thereto. According to a simulation result, compared to directly placing the semiconductor chip on the circuit substrate, this embodiment, by placing at least one light-converging element (e.g., the reflector cup element 34) above the semiconductor chip 1B and a reflective unit defining layer 200' around the semiconductor chip 1B, may increase the brightness from 100% to 984% and the luminous flux from 100% to 245%. Furthermore, if the maximum width W34 of the reflector cup element 34 is increased (e.g., the maximum width W34 is increased from 100 µm to 150 µm), the brightness may be increased from 100% to 2507% and the luminous flux from 100% to 180%.

Please refer to FIG. 8. The main differences between the semiconductor device 2E and the semiconductor device 2D shown in FIG. 7 are described as follows. In the semiconductor device 2E, the reflector cup element 34E has a cavity C that overlaps with the semiconductor chip 1B on the surface facing the semiconductor chip 1B. The cavity C contains, for example, air.

Through the design of the cavity C, the probability of light emitted directly from the semiconductor chip 1B exiting the reflector cup element 34E is reduced. Furthermore, refraction and reflection may be utilized to effectively converge the light, thereby enhancing the brightness of the semiconductor device 2D. According to a simulation result, compared to directly placing the semiconductor chip on the circuit substrate, this embodiment, by positioning at least one light-converging element (e.g., reflector cup element 34E) above the semiconductor chip 1B and arranging a unit defining layer 200' around the semiconductor chip 1B, may increase the brightness from 100% to 1344% and the luminous flux from 100% to 250%.

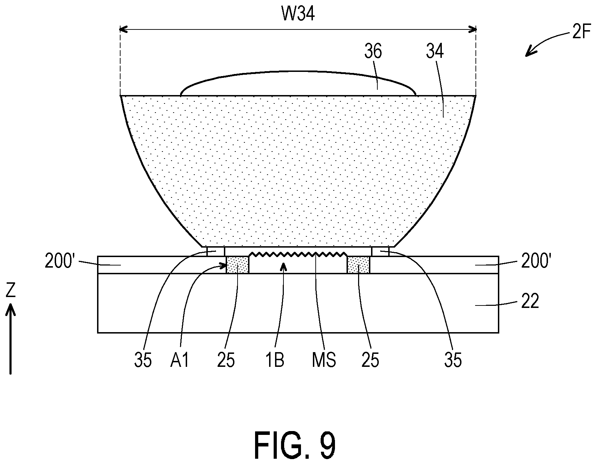

Please refer to FIG. 9. The main differences between the semiconductor device 2F and the semiconductor device 2D in FIG. 7 are described as follows. In the semiconductor device 2F, the at least one light-converting element further includes a lens element 36, wherein the lens element 36 is disposed on the reflector cup element 34. The material of the lens element 36 may be consistent with the aforementioned materials of the lens element 30, which shall not be reiterated herein.

The design of incorporating a lens element 36 on the reflector cup element 34 not only further enhances the brightness of the semiconductor device 2F but also contributes to reducing the overall area of the light-converging element, making it more suitable for high-resolution products. According to a simulation result, compared to directly placing the semiconductor chip on the circuit substrate, this embodiment, by positioning at least one light-converging element (e.g., the reflector cup element 34 and the lens element 36) above the semiconductor chip 1B and arranging a reflective unit defining layer 200' around the semiconductor chip 1B, may increase the brightness from 100% to 4666% and the luminous flux from 100% to 178%.

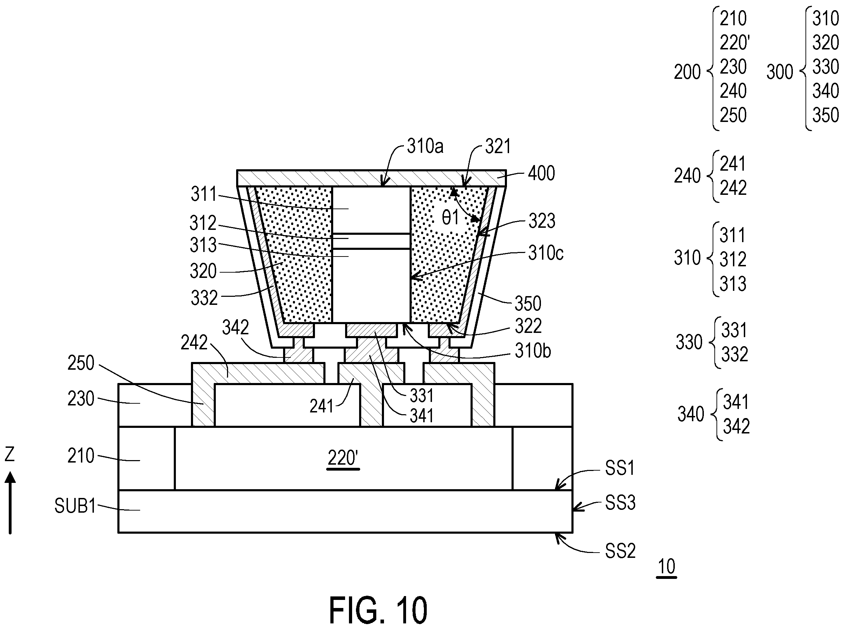

FIG. 10 to FIG. 15 respectively illustrate cross-sectional schematic views of electronic devices according to some embodiments of the present disclosure. Referring first to FIG. 10, the electronic device 10 of the present embodiment includes a first substrate SUB1, a first circuit layer 200, a semiconductor chip 300, and a transparent conductive layer 400.

Specifically, the first substrate SUB1 includes a first surface SS1, a second surface SS2, and a lateral surface SS3. The first surface SS1 is opposite to the second surface SS2, and the lateral surface SS3 connects the first surface SS1 and the second surface SS2. In the present embodiment, the first substrate SUB1 may include a rigid substrate, a flexible substrate, or a combination thereof. By way of example, the material of the first substrate SUB1 may include glass, quartz, sapphire, ceramic, polycarbonate (PC), polyimide (PI), polyethylene terephthalate (PET), other suitable substrate materials, or a combination thereof, but is not limited thereto.

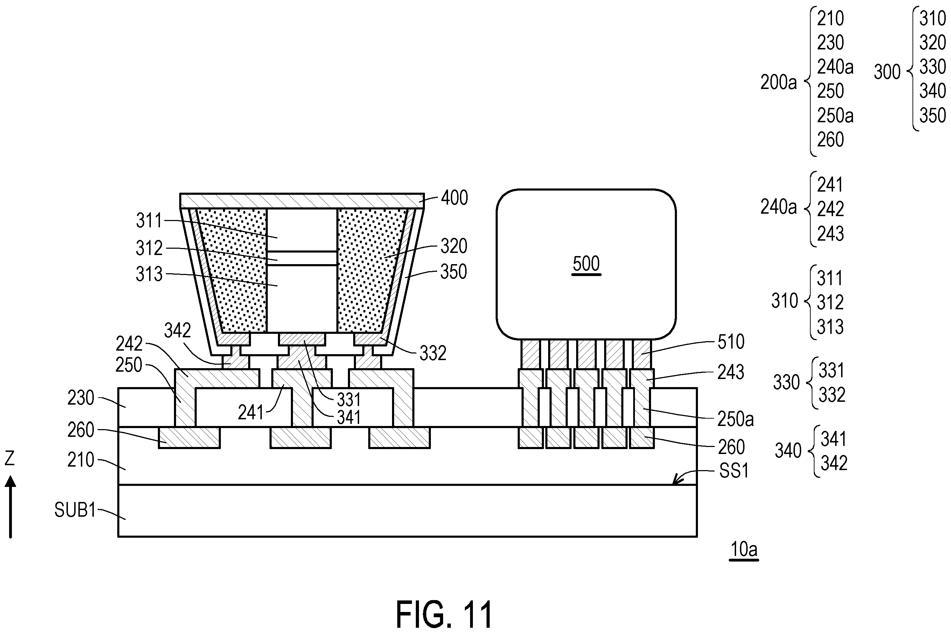

The first circuit layer 200 is disposed on the first surface SS1 of the first substrate SUB 1. The first circuit layer 200 includes an insulating layer 210, a thin film transistor 220', an insulating layer 230, a conductive layer 240, and a conductive via 250. The insulating layer 210 is disposed on the first surface SS1. The thin film transistor 220' is disposed within the insulating layer 210. The insulating layer 230 is disposed on the insulating layer 210. The conductive layer 240 is disposed on the insulating layer 230, and the conductive layer 240 may include a pad 241 and a pad 242. The conductive via 250 penetrates through the insulating layer 230 to connect the conductive layer 240 with the thin film transistor 220', thereby enabling the conductive layer 240 to be electrically connected to the thin film transistor 220' through the conductive via 250. Furthermore, although the first circuit layer 200 of this embodiment may be designed as an active driving circuit, it is not limited thereto. In some embodiments, the first circuit layer may also be designed as a passive driving circuit (as shown in FIG. 11).

The semiconductor chip 300 is disposed on the first surface SS1 of the first substrate SUB1. The semiconductor chip 300 is positioned on the first circuit layer 200, and the semiconductor chip 300 is electrically connectable to the thin film transistor 220' of the first circuit layer 200. The semiconductor chip 300 includes a semiconductor die 310, a filler layer 320, a reflective layer 330, an electrode layer 340, and an insulating layer 350. Specifically, the semiconductor die 310 has a surface 310a, the other surface 310b, and a lateral surface 310c. The surface 310a is opposite to the other surface 310b. The other surface 310b faces the first circuit layer 200, and the other surface 310b is closer to the first circuit layer 200 than the surface 310a. The lateral surface 310c connects the surface 310a and the other surface 310b.

In the present embodiment, the semiconductor die 310 may be a vertical type semiconductor die (vertical type chip). Specifically, along the direction Z (for example, the normal direction of the electronic device 10 or the normal direction of the first substrate SUB1), the semiconductor die 310 includes, from top to bottom, a first type semiconductor layer 311, an active layer 312, and a second type semiconductor layer 313. The first type semiconductor layer 311 is positioned farther from the first circuit layer 200 than the second type semiconductor layer 313, and the active layer 312 is disposed between the first type semiconductor layer 311 and the second type semiconductor layer 313.

In the present embodiment, the semiconductor die 310 may be a light-emitting element (such as, but not limited to, an organic light-emitting diode, sub-millimeter light-emitting diode, micro-light-emitting diode, or quantum dot light-emitting diode), but is not limited thereto. In this embodiment, the first type semiconductor layer 311 may be a P-type semiconductor layer, and the second type semiconductor layer 313 may be an N-type semiconductor layer, but is not limited thereto. In some embodiments, the first type semiconductor layer may also be an N-type semiconductor layer, and the second type semiconductor layer may also be a P-type semiconductor layer. In the present embodiment, the active layer 312 may be a light-emitting layer, but is not limited thereto.

The filler layer 320 surrounds the semiconductor die 310. The filler layer 320 may be in contact with the lateral surface 310c of the semiconductor die 310. The filler layer 320 has an upper surface 321, a lower surface 322, and a lateral surface 323. The upper surface 321 and the lower surface 322 are opposite to each other. The lower surface 322 faces the first circuit layer 200, and the lower surface 322 is closer to the first circuit layer 200 than the upper surface 321. The lateral surface 323 connects the upper surface 321 and the lower surface 322. In this embodiment, the angle θ1 between the upper surface 321 and the lateral surface 323 has a taper angle. The angle θ1 may range from 10 degrees to 80 degrees, or from 30 degrees to 70 degrees, for the purpose of converging the light emitted from the semiconductor die 310, reducing the light emission angle of the semiconductor die 310, or improving the light output efficiency of the semiconductor die 310, but is not limited thereto.

The reflective layer 330 is disposed on the filler layer 320 and the semiconductor die 310. The reflective layer 330 includes a first portion 331 and a second portion 332. The first portion 331 is disposed on the other surface 310b of the semiconductor die 310. The first portion 331 may be in contact with and be electrically connected to the second type semiconductor layer 313 of the semiconductor die 310. The second portion 332 is disposed on the filler layer 320. The second portion 332 is disposed on the lower surface 322 and the lateral surface 323 of the filler layer 320. The second portion 332 is separated from the first portion 331. The second portion 332 may be electrically connected to the first type semiconductor layer 311 of the semiconductor die 310. In this embodiment, the material of the reflective layer 330 may include a material with high reflectivity, for the purpose of converging the light emitted by the semiconductor die 310, reducing the light emission angle of the semiconductor die 310, or improving the light output efficiency of the semiconductor die 310.

The electrode layer 340 is disposed between the reflective layer 330 of the semiconductor chip 300 and the conductive layer 240 of the first circuit layer 200, thereby enabling the semiconductor chip 300 to be bonded and electrically connected to the first circuit layer 200 through the electrode layer 340. The electrode layer 340 may include a first electrode 341 and a second electrode 342. The first electrode 341 and the second electrode 342 are separated from each other, and both the first electrode 341 and the second electrode 342 are disposed on the same side of the semiconductor chip 300. The first electrode 341 may be in contact with and electrically connect to the first portion 331, while the second electrode 342 may be in contact with and electrically connect to the second portion 332. The first electrode 341 may be in contact with and electrically connect to the pad 241 of the conductive layer 240, while the second electrode 342 may be in contact with and electrically connect to the pad 242 of the conductive layer 240. In this embodiment, the material of the electrode layer 340 may include, but is not limited to, gold, tin, copper, other suitable electrode materials, or combinations thereof.

In the present embodiment, the first electrode 341 may be an N-type electrode, and the second electrode 342 may be a P-type electrode; however, this configuration is not limited thereto. In some embodiments, the first electrode may alternatively be a P-type electrode, and the second electrode may alternatively be an N-type electrode. Herein, an N-type electrode refers to an electrode electrically connected to an N-type semiconductor layer, whereas a P-type electrode refers to an electrode electrically connected to a P-type semiconductor layer.

The insulating layer 350 surrounds the reflective layer 330, and the insulating layer 350 may separate the first portion 331 from the second portion 332 of the reflective layer 330. In the present embodiment, the material of the insulating layer 350 may include, but is not limited to, acrylic-based compounds, epoxy-based compounds, siloxane, silica, silicon nitride, silicon oxynitride, other suitable insulating materials, or combinations thereof.

The transparent conductive layer 400 is disposed on the surface 310a of the semiconductor die 310 and on the upper surface 321 of the filler layer 320. The transparent conductive layer 400 may be connected to the second portion 332 of the reflective layer 330, and the transparent conductive layer 400 may be in contact with and electrically connect to the first type semiconductor layer 311 of the semiconductor die 310. Consequently, such configuration enables the first type semiconductor layer 311 of the semiconductor die 310 to be electrically connected to the second electrode 342 through the transparent conductive layer 400 and the second portion 332. In this embodiment, the material of the transparent conductive layer 400 may be identical to the transparent conductive material, and therefore will not be reiterated herein.

In the present embodiment, due to the fact that the first type semiconductor layer 311 and the second type semiconductor layer 313 of the vertical type semiconductor die 310 may be electrically connected to the second electrode 342 and the first electrode 341 respectively, and the second electrode 342 and the first electrode 341 may be disposed on the same side of the semiconductor chip 300, such configuration enables the semiconductor chip 300 in the electronic device 10 to be directly tested or subjected to process monitoring after being transferred onto the first circuit layer 200, thereby potentially improving the transfer yield. In some embodiments, a width of the semiconductor die 310 ranges from 1 to 10µm, and a width of the semiconductor chip 300 ranges from 10 to 50µm. In some embodiments, a projection area of the first electrode 341 and the second electrode 342 on an X-Y plane is greater than a projection area of the semiconductor die 310 on the same X-Y plane, which facilitates the subsequent bonding process of the semiconductor chip 300.

In this embodiment, as the semiconductor chip 300 may be a vertical embedded flip-chip (VEFC), it is possible for the semiconductor chip 300 in the electronic device 10 to be directly tested or subjected to process monitoring after being transferred onto the first circuit layer 200, thereby potentially improving the transfer yield.

The following shall enumerate additional embodiments for illustrative purposes. It must be noted that the subsequent embodiments herein utilize the element designations and partial content from the preceding embodiments, wherein identical designations are employed to denote identical or substantially similar elements, and explanations of identical technical content are omitted. For elucidation regarding the omitted portions, reference may be made to the aforementioned embodiments; the subsequent embodiments shall not reiterate such information.

Please refer to both FIG. 11 and FIG. 10. The electronic device 10a of the present embodiment is similar to the electronic device 10 in FIG. 10, with the following differences: in the electronic device 10a of the present embodiment, the first circuit layer 200a may be designed as a passive driving circuit. Additionally, the electronic device 10a further includes a driving chip 500.

Specifically, with reference to FIG. 11, the first circuit layer 200a includes an insulating layer 210, a conductive layer 260, an insulating layer 230, a conductive layer 240a, a conductive via 250, and a conductive via 250a. The insulating layer 210 is disposed on the first surface SS1 of the first substrate SUB 1. The conductive layer 260 is disposed within the insulating layer 210. The insulating layer 230 is disposed on the insulating layer 210. The conductive layer 240a is disposed on the insulating layer 230, and the conductive layer 240a may include pads 241, 242, and 243. The conductive via 250 and 250a respectively penetrate through the insulating layer 230. The pad 241 (or pad 242) may be electrically connected to a portion of the conductive layer 260 through the conductive via 250, and the pad 243 may be electrically connected to another portion of the conductive layer 260 through the conductive via 250a.

The driving chip 500 is positioned on the first circuit layer 200a. The driving chip 500 may be bonded and electrically connected to the pad 243 of the first circuit layer 200a through the conductive element 510. The driving chip 500 may be electrically connected to the semiconductor chip 300 through the conductive element 510, the pad 243, the conductive via 250a, the conductive layer 260, the conductive via 250, the pad 241 (or the pad 242), and the electrode layer 340. Consequently, this configuration enables the driving chip 500 to drive the semiconductor chip 300 through the first circuit layer 200a.

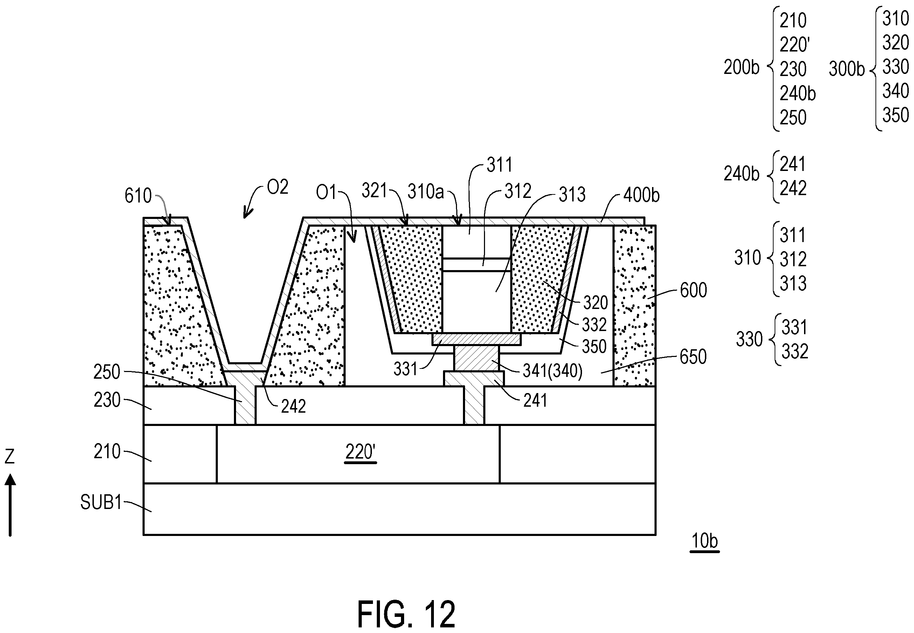

Please refer to both FIG. 12 and FIG. 10. The electronic device 10b of the present embodiment is similar to the electronic device 10 shown in FIG. 10, with the following distinctions: the electronic device 10b of the present embodiment additionally includes a unit defining layer 600 and an underfill 650.

Specifically, with reference to FIG. 12, the unit defining layer 600 is disposed on the first circuit layer 200b. The unit defining layer 600 includes a first opening O1 and a second opening 02. The first opening O1 may expose a portion of the insulating layer 230 in the first circuit layer 200b and the pad 241 of the conductive layer 240b, while the second opening O2 may expose the pad 242 of the conductive layer 240b. In the present embodiment, the material of the unit defining layer 600 may include organic photoresist, and the color of the unit defining layer 600 may be transparent, black, gray, or white, but is not limited thereto.

The semiconductor chip 300b is positioned within the first opening O1. The semiconductor chip 300b may be bonded and electrically connected to the pad 241 of the first circuit layer 200b through the first electrode 341 of the electrode layer 340.

The transparent conductive layer 400b is disposed on the surface 310a of the semiconductor die 310, on the upper surface 321 of the filler layer 320, on the surface 610 of the unit defining layer 600 facing away from the first circuit layer 200b, and within the second opening 02. The transparent conductive layer 400b may be electrically connected to the pad 242 of the first circuit layer 200b through the second opening O2. Consequently, the transparent conductive layer 400b may be considered as the second electrode, enabling the first type semiconductor layer 311 of the semiconductor die 310 to be electrically connected to the first circuit layer 200b through the transparent conductive layer 400b.

The underfill 650 is disposed within the gap between the semiconductor chip 300b situated in the first opening O1 and the unit defining layer 600 (or within the gap between the semiconductor chip 300b and the first circuit layer 200b), such that the underfill 650 may be utilized to secure the semiconductor chip 300b within the first opening O1. In the present embodiment, the material of the underfill 650 may include, but is not limited to, acrylic-based compounds, epoxy-based compounds, siloxane, silica, other suitable adhesive materials, or combinations thereof.

In this embodiment, the semiconductor chip 300b may be a vertical embedded chip (VEC). The first type semiconductor layer 311 and the second type semiconductor layer 313 of the vertical type oriented semiconductor die 310 may be electrically connected to the transparent conductive layer 400b and the first electrode 341, respectively. Furthermore, the transparent conductive layer 400b may be electrically connected to the pad 242 of the first circuit layer 200b through the second opening O2.

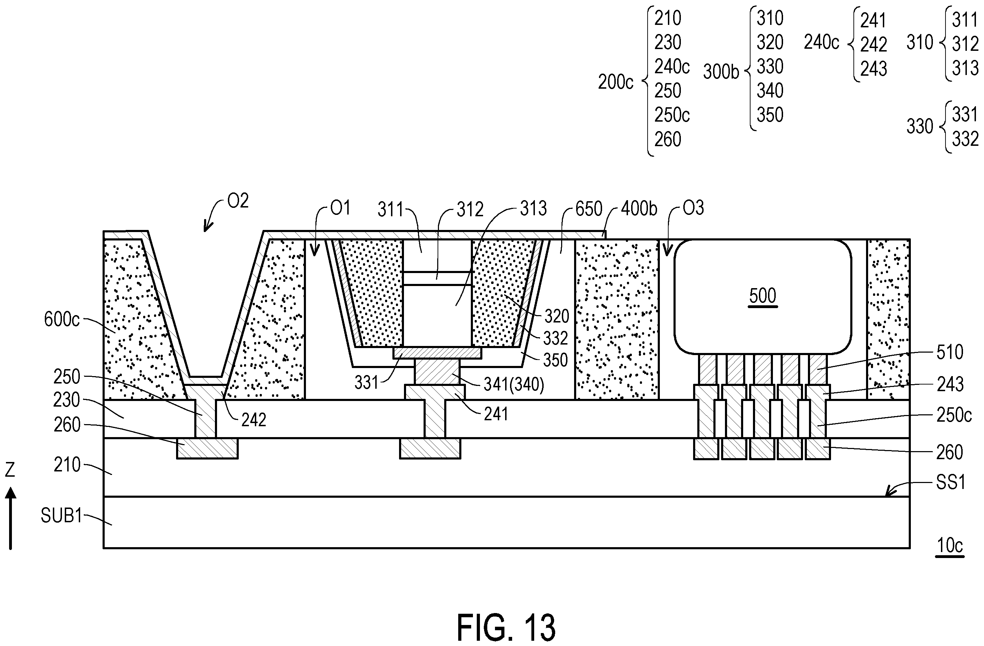

Please refer to both FIG. 13 and FIG. 12. The electronic device 10c of the present embodiment is similar to the electronic device 10b in FIG. 12, with the following distinctions as follows: in the present embodiment, the electronic device 10c is configured such that the first circuit layer 200c may be designed as a passive driving circuit. Additionally, the electronic device 10c further includes a driving chip 500.

Specifically, with reference to FIG. 13, the first circuit layer 200c includes an insulating layer 210, a conductive layer 260, an insulating layer 230, a conductive layer 240c, a conductive via 250, and a conductive via 250c. The insulating layer 210 is disposed on the first surface SS1 of the first substrate SUB 1. The conductive layer 260 is disposed within the insulating layer 210. The insulating layer 230 is disposed on the insulating layer 210. The conductive layer 240c is disposed on the insulating layer 230, and the conductive layer 240c may include pads 241, 242, and 243. The conductive via 250 and the conductive via 250c respectively penetrate through the insulating layer 230. The pad 241 (or pad 242) may be electrically connected to a portion of the conductive layer 260 through the conductive via 250, and the pad 243 may be electrically connected to another portion of the conductive layer 260 through the conductive via 250c.

The unit defining layer 600c further includes a third opening O3. The third opening O3 may expose a portion of the insulating layer 230 in the first circuit layer 200 as well as the pad 243 of the conductive layer 240c.

The driving chip 500 is positioned on the first circuit layer 200c and within the third opening O3. The driving chip 500 may be bonded and electrically connected to the pad 243 of the first circuit layer 200c through the conductive element 510. The driving chip 500 may be electrically connected to the semiconductor chip 300b through the conductive element 510, the pad 243, the conductive via 250c, the conductive layer 260, the conductive via 250, the pad 241 (or the pad 242), and the electrode layer 340 (or the transparent conductive layer 400b). Consequently, such configuration enables the driving chip 500 to drive the semiconductor chip 300b through the first circuit layer 200c.

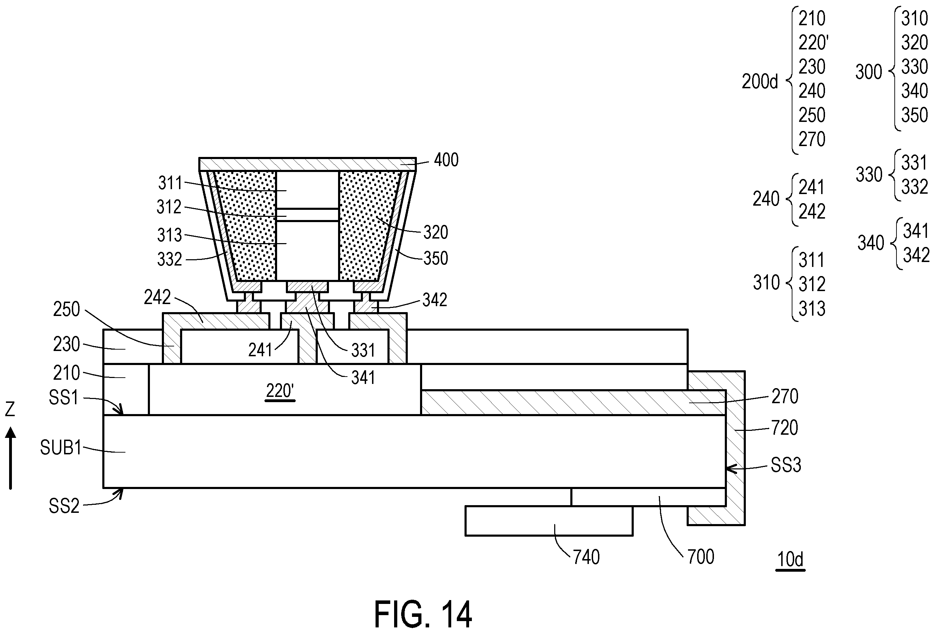

Please refer to both FIG. 14 and FIG. 10. The electronic device 10d of this embodiment is similar to the electronic device 10 in FIG. 10, with the following distinctions: the electronic device 10d of this embodiment additionally includes a second circuit layer 700, a lateral circuitry 720, and a circuit board 740.

Specifically, with reference to FIG. 14, the first circuit layer 200d further includes a conductive layer 270. The conductive layer 270 is disposed within the insulating layer 210, and the conductive layer 270 is capable of being electrically connected to the thin film transistor 220'.

The second circuit layer 700 is disposed on the second surface SS2 of the first substrate SUB1. The second circuit layer 700 at least includes a conductive layer (not shown).

The lateral circuitry 720 is disposed on the lateral surface SS3 of the first substrate SUB1. The lateral circuitry 720 is capable of electrically connecting the conductive layer 270 of the first circuit layer 200d with the second circuit layer 700.

In some embodiments, the lateral circuitry 720 and the second circuit layer 700 may be composed of the same conductive layer, whereby the conductive layer is subsequently patterned through distinct fabrication processes to form the lateral circuitry 720 and the second circuit layer 700, respectively.

The circuit board 740 is positioned on the second surface SS2 of the first substrate SUB 1 and on the second circuit layer 700. The circuit board 740 may be electrically connected to the thin film transistor 220' through the second circuit layer 700, the lateral circuitry 720, and the conductive layer 270. In this embodiment, the circuit board 740 may be a flexible printed circuit (FPC) or a printed circuit board (PCB), but is not limited thereto.

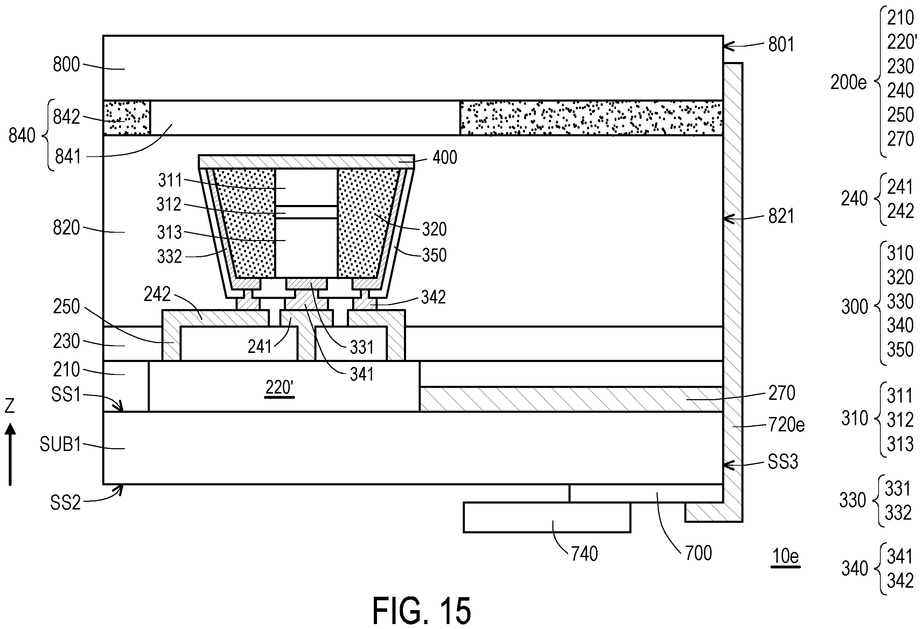

Please refer to both FIG. 15 and FIG. 14. The electronic device 10e of the present embodiment is similar to the electronic device 10d of FIG. 14, with the following distinctions: the electronic device 10e of the present embodiment additionally includes a second substrate 800, an adhesive layer 820, and a light conversion unit 840.

Specifically, with reference to FIG. 15, the second substrate 800 is disposed opposite to the first substrate SUB1. In the present embodiment, the second substrate 800 may include a rigid substrate, a flexible substrate, or a combination thereof. By way of example and not limitation, the material of the second substrate 800 may include glass, quartz, sapphire, ceramic, polycarbonate, polyimide, polyethylene terephthalate, other suitable substrate materials, or combinations thereof.

The adhesive layer 820 is disposed between the first substrate SUB1 and the second substrate 800. The adhesive layer 820 is positioned on the first circuit layer 200e, and the adhesive layer 820 may surround the semiconductor chip 300. In the present embodiment, the material of the adhesive layer 820 may include optically clear adhesive (OCA), optical clear resin (OCR), other suitable transparent materials, or a combination thereof, but is not limited thereto.

The light conversion unit 840 is positioned between the second substrate 800 and the adhesive layer 820. The light conversion unit 840 includes a light conversion layer 841 and a separation layer 842. In the direction Z, the light conversion layer 841 overlaps with the semiconductor chip 300, whereas the separation layer 842 does not overlap with the semiconductor chip 300. The light conversion unit 840 may include light conversion materials, color filter layers, or a combination thereof.

The lateral circuitry 720e is disposed on the lateral surface SS3 of the first substrate SUB1, the lateral surface of the first circuit layer 200e, the lateral surface 821 of the adhesive layer 820, the lateral surface of the light conversion unit 840, and the lateral surface 801 of the second substrate 800. The lateral circuitry 720e may be utilized to protect the lateral surface 821 of the adhesive layer 820.

In some embodiments, the lateral circuitry 720e and the second circuit layer 700 may be the same conductive layer, whereby the conductive layer is subsequently patterned through distinct fabrication processes to form the lateral circuitry 720e and the second circuit layer 700, respectively.

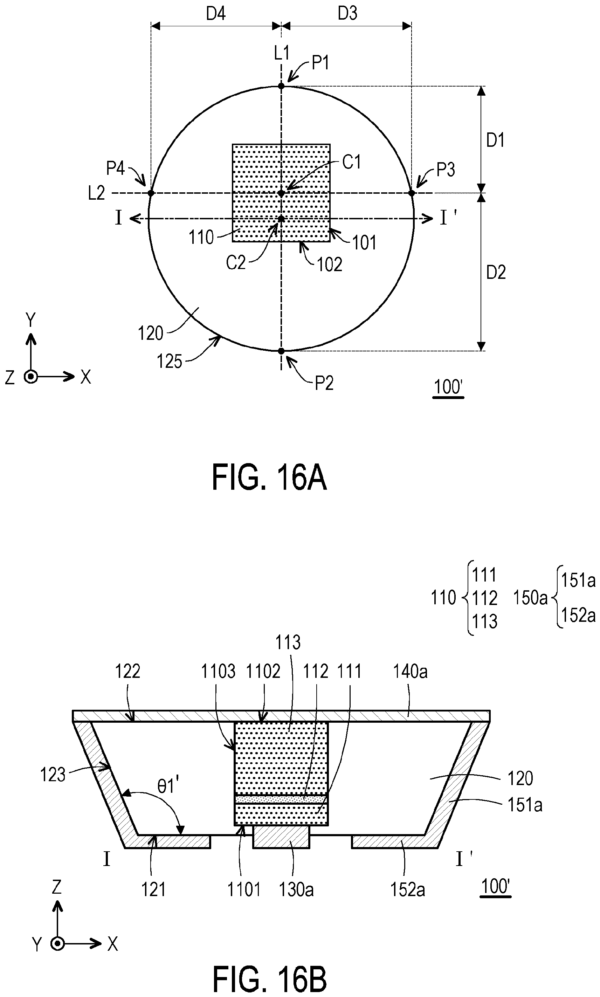

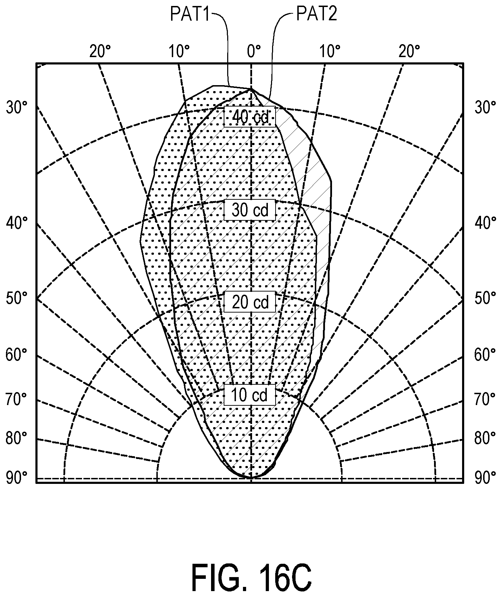

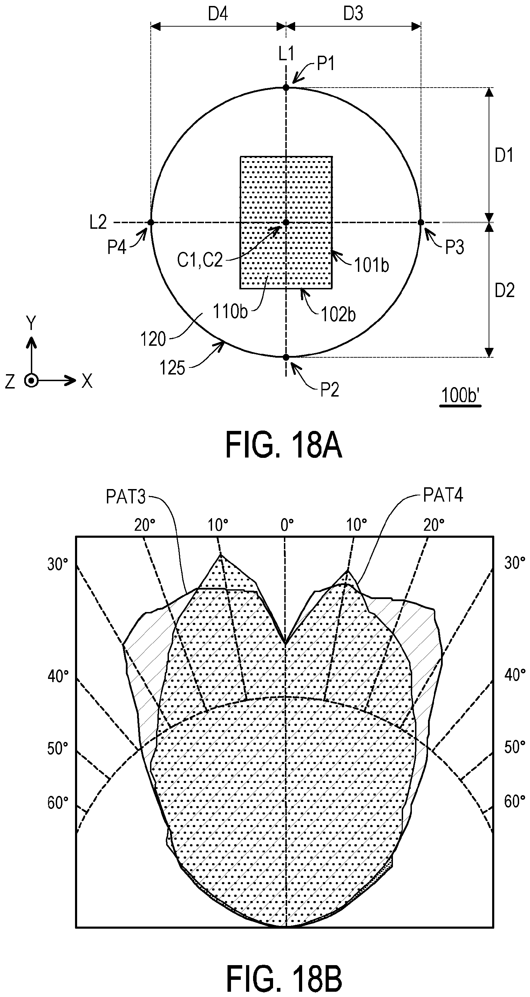

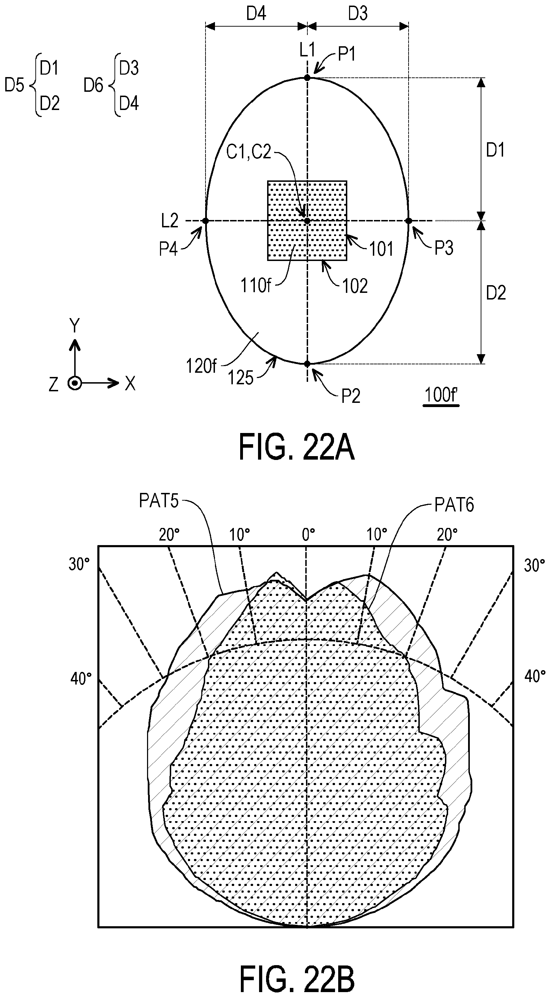

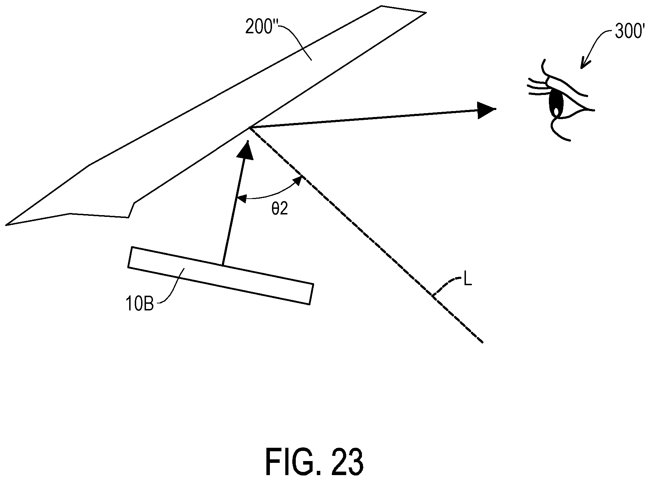

FIG. 16A, FIG. 17, FIG. 18A, FIG. 19, FIG. 20, FIG. 21, and FIG. 22A respectively illustrate top views of semiconductor chips according to various embodiments of the present disclosure. FIG. 16B depicts a cross-sectional view of the semiconductor chip of FIG. 16A taken along the section line I-I'. FIG. 16C presents a light-emitting perspective view of the semiconductor chip of FIG. 16A. FIG. 18B shows a light-emitting perspective view of the semiconductor chip of FIG. 18A. FIG. 22B illustrates a light-emitting perspective view of the semiconductor chip of FIG. 22A. FIG. 23 demonstrates an application of an electronic device according to an embodiment of the present disclosure. For clarity and ease of explanation, some elements of the semiconductor chips have been omitted from the top views.

Please refer to FIG. 16A and FIG. 16B. The semiconductor chip 100' of the present embodiment includes: a semiconductor die 110, a filler layer 120, a first electrode 130a, a second electrode 140a, and a reflective layer 150a.

Specifically, with reference to FIG. 16B, the semiconductor die 110 has a first side 1101, a second side 1102, and a lateral surface 1103. The first side 1101 is opposite to the second side 1102, and the first side 1101 faces the first electrode 130a. The second side 1102 is closer to the second electrode 140a than the first side 1101. The lateral surface 1103 connects the first side 1101 and the second side 1102. In this embodiment, the semiconductor die 110 may be a vertical type semiconductor die (vertical type chip). Specifically, in the direction Z (for example, the normal direction of the semiconductor chip 100'), the semiconductor die 110 includes a first type semiconductor layer 111, an active layer 112, and a second type semiconductor layer 113 stacked in sequence. The first type semiconductor layer 111 is closer to the first electrode 130a than the second type semiconductor layer 113, and the active layer 112 is disposed between the first type semiconductor layer 111 and the second type semiconductor layer 113.

In the present embodiment, direction X, direction Y, and direction Z are respectively different directions. By way of example, direction X may be the extension direction of the cross-sectional line I-I', direction Z may be the normal direction of the semiconductor chip 100', direction X is perpendicular to direction Z, and both direction X and direction Z are perpendicular to direction Y, but the disclosure is not limited thereto.

In the present embodiment, the semiconductor die 110 may be a light-emitting element (e.g., organic light-emitting diode, sub-millimeter light-emitting diode, micro-light-emitting diode, or quantum dot light-emitting diode, but not limited thereto), and the active layer 112 may be a light-emitting layer, but not limited thereto. In the present embodiment, the first type semiconductor layer 111 may be a P-type semiconductor layer, and the second type semiconductor layer 113 may be an N-type semiconductor layer, but not limited thereto. In some embodiments, the first type semiconductor layer may also be an N-type semiconductor layer, and the second type semiconductor layer may also be a P-type semiconductor layer.

Please refer to FIG. 16B, the filler layer 120 surrounds the semiconductor die 110. The filler layer 120 may be in contact with the lateral surface 1103 of the semiconductor die 110. The filler layer 120 has a first surface 121, a second surface 122, and a lateral surface 123. The first surface 121 and the second surface 122 are opposite to each other, with the first surface 121 facing the first electrode 130a. The second surface 122 is closer to the second electrode 140a than the first surface 121. The lateral surface 123 is located between the first surface 121 and the second surface 122, and the lateral surface 123 connects the first surface 121 to the second surface 122. In this embodiment, the angle θ1' of the lateral surface 123 relative to the first surface 121 has a taper angle, and the angle θ1' may range between 90 degrees and 150 degrees, between 90 degrees and 135 degrees, between 100 degrees and 170 degrees, between 110 degrees and 150 degrees, or between 120 degrees and 160 degrees. This configuration allows the filler layer 120 to form a bowl-like structure, which, in conjunction with the reflective layer 150a, may converge the light emitted from the semiconductor die 110, reduce the light emission angle of the semiconductor die 110, or improve the light output efficiency of the semiconductor die 110, but is not limited thereto.

Referring to FIG. 16A, in a top view of the semiconductor chip 100', the contour of the semiconductor die 110 may be square, and the contour of the filler layer 120 may be circular, but is not limited thereto. In other words, in the top view of the semiconductor chip 100', the lengths of two adjacent sides (namely, side 101 and side 102) of the semiconductor die 110 are equal. In some embodiments not shown, the contour of the semiconductor die may also take other shapes, such as rectangular, hexagonal, circular, or elliptical. In some embodiments not shown, the contour of the filler layer may also take other shapes, such as elliptical.

Please refer to FIG. 16A, in the top view of the semiconductor chip 100', the semiconductor die 110 has a center C1, and the filler layer 120 has a center C2. The center C1 of the semiconductor die 110 does not overlap with the center C2 of the filler layer 120 in the direction Z. Specifically, in the top view of the semiconductor chip 100', a first virtual line segment L1 may pass through the center C1 of the semiconductor die 110 and intersect with the edge 125 of the filler layer 120 at a first point P1 and a second point P2. A second virtual line segment L2 may pass through the center C1 of the semiconductor die 110 and intersect with the edge 125 of the filler layer 120 at a third point P3 and a fourth point P4. The second virtual line segment L2 may be perpendicular to the first virtual line segment L1. In this embodiment, the first virtual line segment L1 may be substantially parallel to the direction Y, and the second virtual line segment L2 may be substantially parallel to the direction X, but is not limited thereto.

In the present embodiment, the position of the center C1 of the semiconductor die 110 may be offset relative to the position of the center C2 of the filler layer 120. Specifically, in a top view of the semiconductor chip 100', the distance D1 between the center C1 of the semiconductor die 110 and the first point P1 may differ from the distance D2 between the center C1 of the semiconductor die 110 and the second point P2. Furthermore, the distance D3 between the center C1 of the semiconductor die 110 and the third point P3 may be substantially equal to the distance D4 between the center C1 of the semiconductor die 110 and the fourth point P4, but this is not limited thereto. In this embodiment, the distance D1 is exemplified as the minimum distance measured along the direction Y between the center C1 and the first point P1, the distance D2 is exemplified as the minimum distance measured along the direction Y between the center C1 and the second point P2, the distance D3 is exemplified as the minimum distance measured along the direction X between the center C1 and the third point P3, and the distance D4 is exemplified as the minimum distance measured along the direction X between the center C1 and the fourth point P4.

In the present embodiment, the distance D2 may be greater than the distance D1 (i.e., D1 < D2), and the ratio of the distance D2 to the distance D1 may be greater than 1 and less than or equal to 2 (i.e., 1 < D2/D1 ≤ 2), but is not limited thereto.

Please refer to FIG. 16B. The first electrode 130a is disposed on the first side 1101 of the semiconductor die 110. The first electrode 130a may be electrically connected to the first type semiconductor layer 111 of the semiconductor die 110. In some embodiments, an ohmic contact layer (not shown) may be present between the first electrode 130a and the first type semiconductor layer 111, and the ohmic contact layer may include transparent conductive oxides (TCO). In the present embodiment, the material of the first electrode 130a may include a conductive material with high reflectivity, enabling the first electrode 130a to converge the light emitted from the semiconductor die 110, reduce the light emission angle of the semiconductor die 110, or enhance the light output efficiency of the semiconductor die 110.

Please refer to FIG. 16B. The second electrode 140a is disposed on the second side 1102 of the semiconductor die 110 and the second surface 122 of the filler layer 120. The second electrode 140a may be connected to the reflective layer 150a. The second electrode 140a may be electrically connected to the second type semiconductor layer 113 of the semiconductor die 110. In some embodiments, an ohmic contact layer (not shown) may be present between the second electrode 140a and the second type semiconductor layer 113, and the ohmic contact layer may include transparent conductive oxides. In the present embodiment, the material of the second electrode 140a may include a transparent conductive material.

Please refer to FIG. 16B. The reflective layer 150a is disposed on the filler layer 120, and the reflective layer 150a is separated from the first electrode 130a. The reflective layer 150a includes a first portion 151a and a second portion 152a. The first portion 151a is disposed on the lateral surface 123 of the filler layer 120, and the second portion 152a is disposed on the first surface 121 of the filler layer 120. One side of the first portion 151a may be connected to the second electrode 140a, and the other side of the first portion 151a may be connected to the second portion 152a; thereby enabling the second portion 152a to be electrically connected to the second type semiconductor layer 113 of the semiconductor die 110 through the first portion 151a and the second electrode 140a. In this embodiment, the material of the reflective layer 150a may include a conductive material with high reflectivity, allowing the reflective layer 150a to be used for converging the light emitted by the semiconductor die 110, reducing the light emission angle of the semiconductor die 110, or improving the light output efficiency of the semiconductor die 110. In this embodiment, the material of the reflective layer 150a may include, but is not limited to, silver, aluminum, tin, indium, gold, or a combination thereof.

In the present embodiment, due to the fact that the first type semiconductor layer 111 and the second type semiconductor layer 113 of the vertical type semiconductor die 110 may be electrically connected to the first electrode 130a and the second portion 152a of the reflective layer 150a respectively, and that the first electrode 130a and the second portion 152a may be disposed on the same side (or in the same horizontal plane) of the semiconductor chip 100', making it possible for the semiconductor chip 100' to be a vertical embedded flip-chip (VEFC). This configuration facilitates the detection and mass transfer of the semiconductor chip 100'. In some embodiment, a width of the semiconductor die 110 may range from 1 to 10 micrometers, and a width of the semiconductor chip 100' may range from 10 to 50 micrometers. In some embodiments, a projection area of the first electrode 130a and the second part 152a on an X-Y plane is greater than a proj ection area of the semiconductor die 110 on the same X-Y plane, which facilitates the subsequent bonding process of the semiconductor chip 100'.

Please refer to FIG. 16C, which depicts a light-emitting perspective view of the semiconductor chip 100'. In this diagram, the meridian lines represent the viewing angles, measured in degrees (°); the latitude lines represent the luminous intensity, measured in candelas (cd); the pattern PAT1 illustrates the luminous distribution or light emission pattern of the semiconductor chip 100' as observed from the direction Y; and the pattern PAT2 illustrates the luminous distribution or light emission pattern of the semiconductor chip 100' as observed from the direction X.

In detail, referring simultaneously to FIG. 16B and FIG. 16C, due to the fact that the distance D1 differs from the distance D2, the luminous distribution of the pattern PAT1 exhibits an asymmetrical configuration when the normal viewing angle (0-degree angle) is considered as the axis of symmetry. Within the pattern PAT1, the maximum light intensity does not occur at the normal viewing angle but rather at an oblique viewing angle (for instance, at approximately 10 degrees). Furthermore, given that the distance D3 is substantially equivalent to the distance D4, the luminous distribution of the pattern PAT2 presents a symmetrical configuration when the normal viewing angle (0-degree angle) is considered as the axis of symmetry. Within the pattern PAT2, the maximum light intensity occurs at the normal viewing angle rather than at an oblique viewing angle.

Based on the foregoing, it may be ascertained that when the distance D1 between the center C1 of the semiconductor die 110 and the first point P1 differs from the distance D2 between the center C1 of the semiconductor die 110 and the second point P2 (or when the position of the center C1 of the semiconductor die 110 is offset relative to the position of the center C2 of the filler layer 120), the light emission pattern of the semiconductor chip 100' may be altered (i.e., the pattern PAT1 differs from the pattern PAT2). This modification enables electronic devices incorporating the semiconductor chip 100' to achieve optimal light intensity or brightness at specific viewing angles.

The following shall enumerate additional embodiments for illustrative purposes. It must be noted that the subsequent embodiments herein retain the element designations and partial content from the preceding embodiments. Identical numerals are employed to denote identical or substantially similar elements, and explanations of identical technical content have been omitted. For elucidation on the omitted portions, reference may be made to the foregoing embodiments. The ensuing embodiments shall not reiterate the aforementioned content.

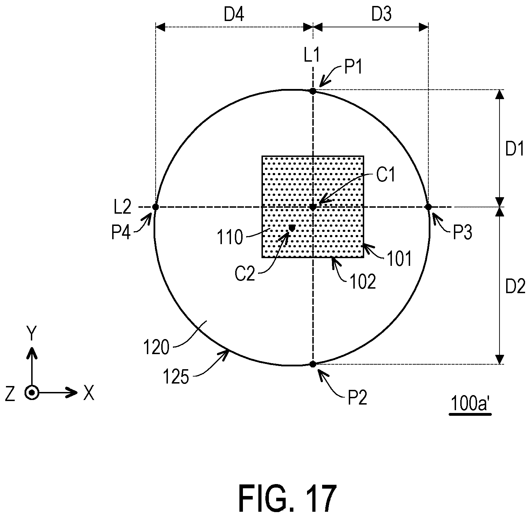

Please refer to FIG. 17 and FIG. 16A concurrently. The semiconductor chip 100a' of the present embodiment is similar to the semiconductor chip 100' in FIG. 16A, with the following distinction: in the top view of the semiconductor chip 100a' of the present embodiment, the distance D3 between the center C1 of the semiconductor die 110a and the third point P3 differs from the distance D4 between the center C1 of the semiconductor die 110a and the fourth point P4. In this embodiment, the distance D4 may be greater than the distance D3 (i.e., D3 < D4), and the ratio of the distance D4 to the distance D3 may be greater than 1 and less than or equal to 2 (i.e., 1 < D4/D3 ≤ 2), but is not limited thereto.

Please refer to FIG. 18A to FIG. 18B and FIG. 16A to FIG. 16C concurrently. The semiconductor chip 100b' of the present embodiment is similar to the semiconductor chip 100' depicted in FIG. 16A, with the following distinctions: in the top view of the semiconductor chip 100b' of the present embodiment, the contour of the semiconductor die 110b is rectangular. Furthermore, the center C1 of the semiconductor die 110b overlaps with the center C2 of the filler layer 120 along the direction Z.

Specifically, with reference to FIG. 18A, in the top view of the semiconductor chip 100b', the distance D1 between the center C1 of the semiconductor die 110b and the first point P1 is substantially equivalent to the distance between the center C1 of the semiconductor die 110b and the second point P2. Furthermore, the distance D3 between the center C1 of the semiconductor die 110b and the third point P3 is substantially equivalent to the distance D4 between the center C1 of the semiconductor die 110b and the fourth point P4.

In the present embodiment, as viewed from a top view of the semiconductor chip 100b', the lengths of two adjacent sides (namely, side 101b and side 102b) of the semiconductor die 110b are dissimilar. Specifically, the side 101b may constitute the longer side of a rectangle and may be substantially parallel to the direction Y, while the side 102b may constitute the shorter side of the rectangle and may be substantially parallel to the direction X. Furthermore, the length of the side 101b may be greater than that of the side 102b; however, this configuration is not limited to the aforementioned description.

Please refer to FIG. 18B. The pattern PAT3 represents the luminous distribution or light emission pattern of the semiconductor chip 100b' as observed in the direction Y, while the pattern PAT4 represents the luminous distribution or light emission pattern of the semiconductor chip 100b' as observed in the direction X.

In more detail, referring concurrently to FIG. 18A and FIG. 18B, given that the distance D1 is substantially equivalent to the distance D2, and the distance D3 is substantially equivalent to the distance D4, the light emission patterns PAT3 and PAT4 both exhibit symmetrical characteristics when the normal viewing angle (0-degree angle) is considered as the axis of symmetry. Furthermore, although the maximum light intensity for both the patterns PAT3 and PAT4 does not occur at the normal viewing angle but rather at oblique angles, due to the rectangular contour of the semiconductor die 110b, the maximum light intensity for the pattern PAT3 occurs at approximately 10 to 30 degrees viewing angle, while for the pattern PAT4 it occurs at approximately 10 degrees viewing angle.

Based on the foregoing, it may be inferred that when the lengths of adjacent sides 101b and 102b of the semiconductor die 110b are different, the light emission pattern of the semiconductor chip 100b' may be altered (i.e., the pattern PAT3 differs from the pattern PAT4). This modification enables an electronic device incorporating the semiconductor chip 100b' to achieve optimal light intensity or brightness at specific viewing angles.

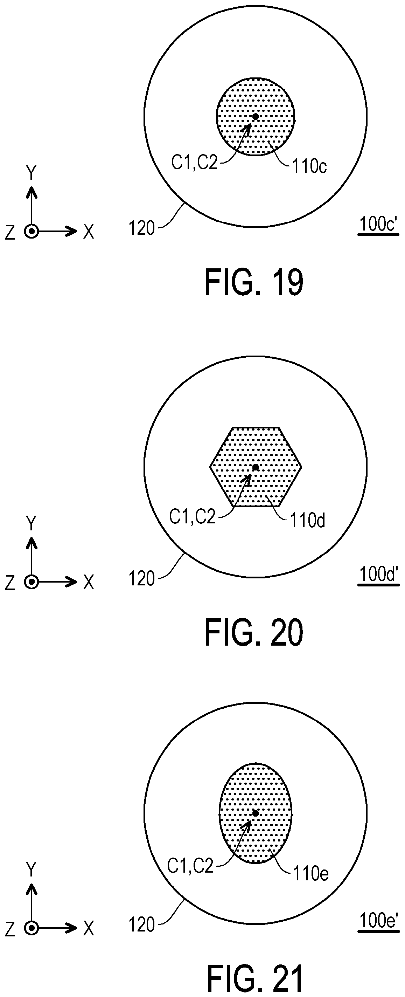

Please refer to both FIG. 19 and FIG. 18A. The semiconductor chip 100c' in this embodiment is similar to the semiconductor chip 100b' in FIG. 18A, with the following distinction: in the top view of the semiconductor chip 100c' in this embodiment, the contour of the semiconductor die 110c is circular.

Please refer to both FIG. 20 and FIG. 18A. The semiconductor chip 100d' in this embodiment is similar to the semiconductor chip 100b' in FIG. 18A, with the following distinction: in the top view of the semiconductor chip 100d' in this embodiment, the contour of the semiconductor die 110d is hexagonal.

Please refer to both FIG. 21 and FIG. 18A. The semiconductor chip 100e' in this embodiment is similar to the semiconductor chip 100b' shown in FIG. 18A, with the following distinction: in the top view of the semiconductor chip 100e' in this embodiment, the contour of the semiconductor die 110e is elliptical.

Please refer to FIG. 22A to FIG. 22B and FIG. 18A to FIG. 18B concurrently. The semiconductor chip 100f of the present embodiment is similar to the semiconductor chip 100b' depicted in FIG. 18A, with the following distinctions: in the top view of the semiconductor chip 100f of the present embodiment, the contour of the semiconductor die 110f is square-shaped, whereas the contour of the filler layer 120f is elliptical in configuration.

Specifically, referring to FIG. 22A, due to the elliptical contour of the filler layer 120f, the sum D5 of the distances D1 and D2 (i.e., the length of the filler layer 120f measured along the direction Y) differs from the sum D6 of the distances D3 and D4 (i.e., the length of filler layer 120f measured along the direction X). In other words, although the center C1 of the semiconductor die 110f may overlap with the center C2 of the filler layer 120f in the direction Z, the elliptical contour of the filler layer 120f results in the distance D1 between the center C1 of the semiconductor die 110f and the first point P1 being different from the distance D3 between the center C1 of the semiconductor die 110f and the third point P3 (or different from the distance D4 between the center C1 of the semiconductor die 110f and the fourth point P4).

In this embodiment, the distance D1 may be greater than the distance D3 (i.e., D3 < D1), and the distance D2 may be greater than the distance D4 (i.e., D4 < D2). Furthermore, the ratio of the sum D5 to the sum D6 may be greater than 1 and less than or equal to 3 (i.e., 1 < D5/D6 ≤ 3), but is not limited thereto. Additionally, in this embodiment, as the center C1 of the semiconductor die 110f may overlap with the center C2 of the filler layer 120f in the direction Z, the distance D1 is equal to the distance D2, and the distance D3 is equal to the distance D4; however, this configuration is not limited to these specific parameters.

Please refer to FIG. 22B, wherein the pattern PATS represents the luminous distribution or light emission pattern of the semiconductor chip 100f as observed in the direction Y, and the pattern PAT6 represents the luminous distribution or light emission pattern of the semiconductor chip 100f as observed in the direction X.

In more detail, referring to both FIG. 22A and FIG. 22B, since the distance D1 is substantially equal to the distance D2, and the distance D3 is substantially equal to the distance D4, the light emission patterns of the patterns PATS and PAT6 exhibit symmetrical configurations with the normal viewing angle (0-degree angle) serving as the axis of symmetry. Furthermore, although the maximum light intensities of the patterns PATS and PAT6 do not occur at the normal viewing angle but rather at oblique angles, due to the elliptical contour of the filler layer 120f, the maximum light intensities of the patterns PATS and PAT6 occur at approximately 15 degrees and 5 degrees viewing angles, respectively.

Based on the foregoing, it may be ascertained that when the distance D1 between the center C1 of the semiconductor die 110f and the first point P1 differs from the distance D3 between the center C1 of the semiconductor die 110f and the third point P3 (or when the length of the filler layer 120f measured along the direction Y differs from the length of the filler layer 120f measured along the direction X), the light emission pattern of the semiconductor chip 100f may be altered (i.e., the pattern PAT5 differs from the pattern PAT6). This modification enables electronic devices incorporating the semiconductor chip 100f to exhibit improved light intensity or brightness at specific viewing angles, or allows electronic devices incorporating the semiconductor chip 100f to provide varying ranges of observable viewing angles in different observational directions.

Please refer to FIG. 23. In this embodiment, the electronic device 10B may be a head-up display (HUD) or panoramic head-up display (PHUD) for vehicular use, but is not limited thereto.

In the present embodiment, the electronic device 10B may include the semiconductor chip 100' as illustrated in FIG. 16A and FIG. 16B, the semiconductor chip 100a' as illustrated in FIG. 17, the semiconductor chip 100b' as illustrated in FIG. 18A, the semiconductor chip 100c' as illustrated in FIG. 19, the semiconductor chip 100d' as illustrated in FIG. 20, the semiconductor chip 100e' as illustrated in FIG. 21, or the semiconductor chip 100f as illustrated in FIG. 22A. These configurations may provide enhanced light intensity or brightness from specific viewing angles, deliver highly converged light, produce high-brightness illumination, or mitigate the effects of ambient light.

In the present embodiment, with respect to the normal line L of the windshield 200", the image of the electronic device 10B may be projected onto the windshield 200" at an incident angle θ2 of, for example, 30 degrees to 70 degrees, such that the driver 300' may view the image of the electronic device 10B on the windshield 200".

In light of the foregoing, the semiconductor chip disclosed in the present embodiment enables modification of the light emission pattern of the semiconductor chip through one of the following means: establishing a different distance between the center of the semiconductor die and the first point, as compared to the distance between the center of the semiconductor die and the second point; implementing unequal lengths for adjacent sides of the semiconductor die; or creating a difference between the distance from the center of the semiconductor die to the first point and the distance from the center of the semiconductor die to the third point. Consequently, electronic devices incorporating such semiconductor chips may achieve improved light intensity or brightness at specific viewing angles.

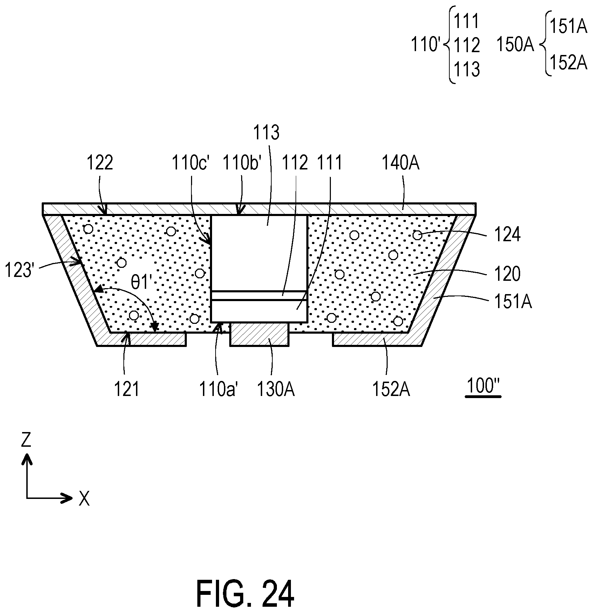

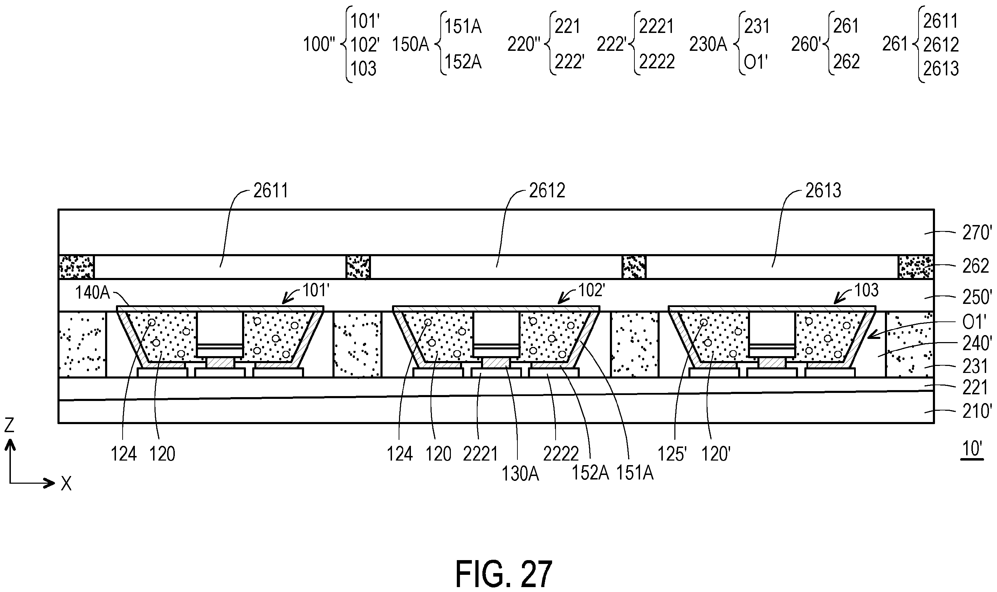

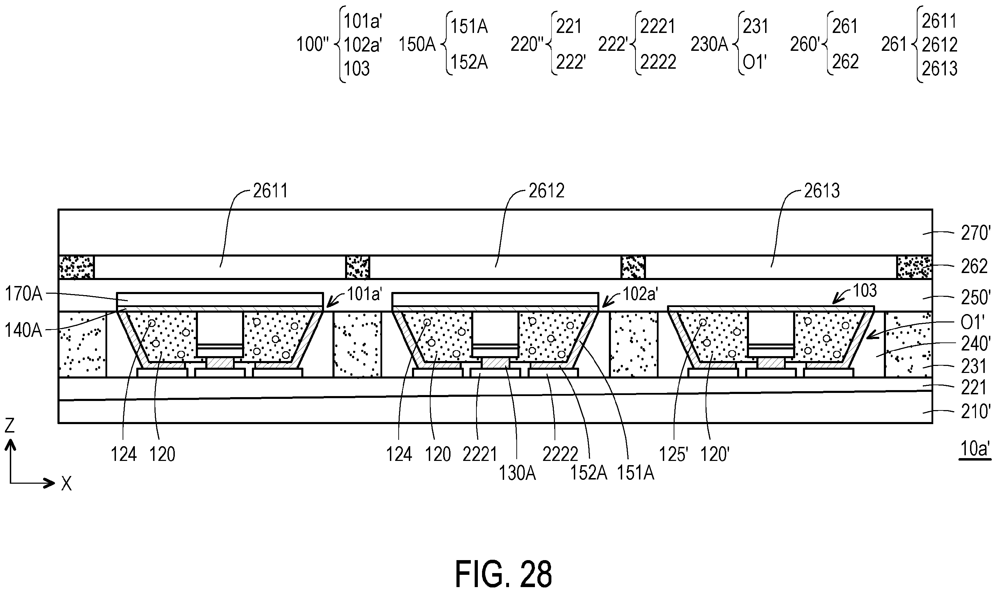

FIG. 24 to FIG. 26 respectively illustrate cross-sectional schematic views of semiconductor chips according to some embodiments of the present disclosure. FIG. 27 and FIG. 28 respectively illustrate cross-sectional schematic views of electronic devices according to some embodiments of the present disclosure. Referring first to FIG. 24, the semiconductor chip 100" of the present embodiment includes the semiconductor die 110', the filler layer 120, the first electrode 130A, the second electrode 140A, and the reflective layer 150A.

Specifically, the semiconductor die 110' has a first side 110a', a second side 110b', and a lateral surface 110c'. The first side 110a' is opposite to the second side 110b', and the first side 110a' faces the first electrode 130A. The second side 110b' is closer to the second electrode 140A than the first side 110a'. The lateral surface 110c' connects the first side 110a' and the second side 110b'. In this embodiment, the semiconductor die 110' may be a vertical type semiconductor die (vertical type chip). Specifically, in the direction Z (for example, the normal direction of the semiconductor chip 100"), the semiconductor die 110' includes a first type semiconductor layer 111, an active layer 112, and a second type semiconductor layer 113 stacked in sequence. The first type semiconductor layer 111 is closer to the first electrode 130A than the second type semiconductor layer 113, and the active layer 112 is disposed between the first type semiconductor layer 111 and the second type semiconductor layer 113.

In the present embodiment, the semiconductor die 110' may be a light-emitting element (such as, but not limited to, an organic light-emitting diode, a sub-millimeter light-emitting diode, a micro light-emitting diode, or a quantum dot light-emitting diode), and the active layer 112 may be a light-emitting layer, but is not limited thereto. In this embodiment, the first type semiconductor layer 111 may be a P-type semiconductor layer, and the second type semiconductor layer 113 may be an N-type semiconductor layer, but is not limited thereto. In some embodiments, the first type semiconductor layer may also be an N-type semiconductor layer, and the second type semiconductor layer may also be a P-type semiconductor layer.

The filler layer 120 surrounds the semiconductor die 110'. The filler layer 120 may be in contact with the lateral surface 110c' of the semiconductor die 110'. The filler layer 120 has a first surface 121, a second surface 122, and a lateral surface 123'. The first surface 121 and the second surface 122 are opposite to each other, with the first surface 121 facing the first electrode 130A. The second surface 122 is closer to the second electrode 140A than the first surface 121. The lateral surface 123' is located between the first surface 121 and the second surface 122, and the lateral surface 123' connects the first surface 121 to the second surface 122. In this embodiment, the angle θ1' of the lateral surface 123' relative to the first surface 121 has a taper angle, and the angle θ1' may range between 90 degrees and 170 degrees, between 90 degrees and 135 degrees, between 90 degrees and 150 degrees, between 100 degrees and 170 degrees, or between 110 degrees and 150 degrees, allowing the filler layer 120 to form a bowl-like structure. This structure enables the filler layer 120 to work in conjunction with the reflective layer 150A to converge the light emitted from the semiconductor die 110', reduce the light emission angle of the semiconductor die 110', or improve the light output efficiency of the semiconductor die 110', but is not limited thereto.

In this embodiment, the filler layer 120 may include a light conversion material 124, which is utilized to convert short-wavelength light (e.g., blue light) emitted by the semiconductor die 110' into long-wavelength light (e.g., red light or green light). In the present embodiment, the light conversion material 124 may include, but is not limited to, quantum dots, phosphors, fluorescent materials, other suitable light conversion materials, or combinations thereof.

The first electrode 130A is positioned on the first side 110a' of the semiconductor die 110'. The first electrode 130A may be in contact with and electrically connect to the first type semiconductor layer 111 of the semiconductor die 110'. In some embodiments, an ohmic contact layer (not shown) is present between the first electrode 130A and the first type semiconductor layer 111. This ohmic contact layer may include transparent conductive oxides. In the present embodiment, the material of the first electrode 130A may include conductive materials with high reflectivity (such as, but not limited to, nickel, aluminum, silver, platinum, or combinations thereof). Such configuration allows the first electrode 130A to reflect light emitted from the semiconductor die 110', thereby enhancing the light extraction efficiency of the semiconductor die 110', or enabling the light emitted from the semiconductor die 110' to fully interact with the light conversion material 124, thus improving the light conversion efficiency.

The second electrode 140A is disposed on the second side 110b' of the semiconductor die 110' and the second surface 122 of the filler layer 120. The second electrode 140A may be connected to the reflective layer 150A. The second electrode 140A may be in contact with and electrically connect to the second type semiconductor layer 113 of the semiconductor die 110'. In the present embodiment, the material of the second electrode 140A may include a transparent conductive material.

The reflective layer 150A is disposed on the filler layer 120, and the reflective layer 150A is separated from the first electrode 130A. The reflective layer 150A includes a first portion 151A and a second portion 152A. The first portion 151A is disposed on the lateral surface 123' of the filler layer 120, while the second portion 152A is disposed on the first surface 121 of the filler layer 120. One side of the first portion 151A may be connected to the second electrode 140A, and the other side of the first portion 151A may be connected to the second portion 152A; thereby enabling the second portion 152A to be electrically connected to the second type semiconductor layer 113 of the semiconductor die 110' through the first portion 151A and the second electrode 140A. In this embodiment, the material of the reflective layer 150A may include a conductive material with high reflectivity, thereby allowing the reflective layer 150A to converge the light emitted from the semiconductor die 110', reduce the light emission angle of the semiconductor die 110', enhance the light output efficiency of the semiconductor die 110', or enable the light emitted from the semiconductor die 110' to fully react with the light conversion material 124, thereby improving the light conversion efficiency. In this embodiment, the material of the reflective layer 150A may be identical to that of the first electrode 130A, but is not limited thereto. The material of the reflective layer 150A may include silver, aluminum, tin, indium, copper, gold, or a combination thereof, but is not limited to these materials.

In this embodiment, the first type semiconductor layer 111 and the second type semiconductor layer 113 of the vertical type semiconductor die 110' may be electrically connected to the first electrode 130A and the second portion 152A of the reflective layer 150A, respectively. The first electrode 130A and the second portion 152A may be disposed on the same side (or in the same horizontal plane) of the semiconductor chip 100". Consequently, such configuration enables the semiconductor chip 100" to be a vertical embedded flip-chip (VEFC), facilitating the detection and mass transfer of the semiconductor chip 100".

The following will enumerate additional embodiments for illustrative purposes. It must be noted that the subsequent embodiments retain the element designations and partial content from the preceding embodiments. Identical numerals are employed to denote identical or analogous elements, and explanations of identical technical content have been omitted. For elucidation on the omitted portions, reference may be made to the aforementioned embodiments. The ensuing embodiments shall not reiterate redundant information.

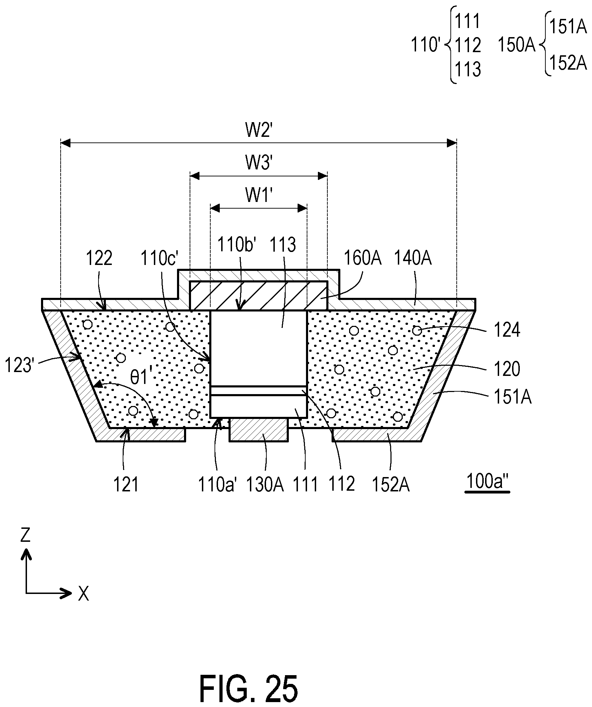

Please refer to FIG. 25 and FIG. 24 concurrently. The semiconductor chip 100a" of the present embodiment is similar to the semiconductor chip 100" depicted in FIG. 24, with the distinction being that the semiconductor chip 100a" of the present embodiment further includes a light-shielding electrode 160A.

Specifically, referring to FIG. 25, the light-shielding electrode 160A is disposed on the second side 110b' of the semiconductor die 110', and the light-shielding electrode 160A is positioned between the second type semiconductor layer 113 and the second electrode 140A. In the direction Z (for example, the normal direction of the semiconductor chip 100a"), the light-shielding electrode 160A may overlap the semiconductor die 110' and at least a portion of the second surface 122 of the filler layer 120. The light-shielding electrode 160Amay be in contact with and electrically connect the second type semiconductor layer 113 with the second electrode 140A. In some embodiments, an ohmic contact layer (not shown) is present between the light-shielding electrode 160A and the second type semiconductor layer 113.

In the present embodiment, the material of the light-shielding electrode 160A may include metal, such as gold, but is not limited thereto. In this embodiment, the transmittance of the light-shielding electrode 160Amay be less than that of the second electrode 140A with respect to the visible light spectrum; consequently, this may reduce the probability of short-wavelength light (e.g., blue light) emitted by the semiconductor die 110' being directly emitted outside the semiconductor chip 100a" without undergoing light conversion. As a result, this may enhance the light conversion efficiency of the semiconductor chip 100a" or improve the color purity of the semiconductor chip 100a".

In this embodiment, the semiconductor die 110' has a width W1', the second surface 122 of the filler layer 120 has a width W2', and the light-shielding electrode 160A has a width W3'. Specifically, the width W1' may be the maximum width of the semiconductor die 110' measured along the direction X, the width W2' may be the maximum width of the second surface 122 of the filler layer 120 measured along the direction X, and the width W3' may be the maximum width of the light-shielding electrode 160A measured along the direction X. The direction X and the direction Z are different directions, and the direction X may be substantially perpendicular to the direction Z, but is not limited thereto. In this embodiment, the width W3' of the light-shielding electrode 160A may be greater than or equal to 30% of the width W1' of the semiconductor die 110', and the width W3' of the light-shielding electrode 160Amay be less than or equal to 50% of the width W2' of the second surface 122 of the filler layer 120 (i.e., 30% × W1' ≤ W3' ≤ 50% × W2'), to reduce the probability of short-wavelength light (e.g., blue light) emitted from the semiconductor die 110' being directly emitted outside the semiconductor chip 100a", but is not limited thereto.

In the present embodiment, in a top view (not shown) of the semiconductor chip 100a", the semiconductor die 110' has an area A1, the second surface 122 of the filler layer 120 has an area A2, and the light-shielding electrode 160A has an area A3. In this embodiment, the area A3 of the light-shielding electrode 160A may be greater than or equal to 10% of the area A1 of the semiconductor die 110', and the area A3 of the light-shielding electrode 160A may be less than or equal to 50% of the area A2 of the second surface 122 of the filler layer 120 (i.e., 10% × A1 ≤ A3 ≤ 50% × A2). This configuration is intended to reduce the probability of short-wavelength light (e.g., blue light) emitted by the semiconductor die 110' from being directly emitted outside the semiconductor chip 100a", but is not limited thereto.

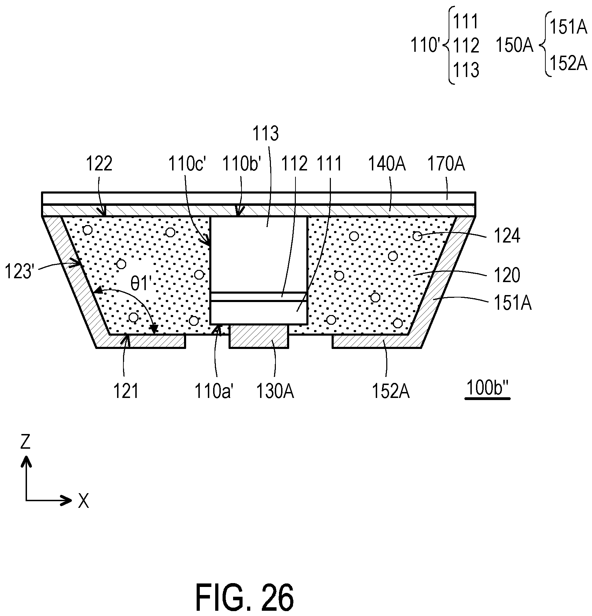

Please refer to both FIG. 26 and FIG. 24. The semiconductor chip 100b" in this embodiment is similar to the semiconductor chip 100" in FIG. 24, with the following distinction: the semiconductor chip 100b" in this embodiment further includes a distributed Bragg reflector (DBR) layer 170A.

Specifically, with reference to FIG. 26, the DBR layer 170A is disposed on the second electrode 140A, and the second electrode 140A is positioned between the DBR layer 170A and the semiconductor die 110'. In this embodiment, the DBR layer 170A may be utilized to reflect short-wavelength light (e.g., blue light) while allowing long-wavelength light (e.g., red or green light) to pass through. This configuration serves to reduce the probability of short-wavelength light emitted by the semiconductor die 110' being directly emitted outside the semiconductor chip 100b" without undergoing light conversion. Consequently, this arrangement may enhance the light conversion efficiency of the semiconductor chip 100b" or improve the color purity of the semiconductor chip 100b".

For example, when the semiconductor die 110' emits blue light, a portion of the blue light directed towards the filler layer 120 containing red light conversion material first undergoes a light conversion process to be converted into red light, which then passes through the DBR layer 170A and is emitted outside the semiconductor chip 100b". Another portion of the blue light directed towards the DBR layer 170A cannot directly pass through the DBR layer 170A and may be reflected by the DBR layer 170A. This reflected blue light will continue to be reflected until the blue light undergoes the light conversion process to be converted into red light, after which the converted light may pass through the DBR layer 170A and be emitted outside the semiconductor chip 100b". This design enables the light emitted from the semiconductor chip 100b" to be predominantly red, thereby reducing the probability of blue light contamination.

Please refer to FIG. 27. The electronic device 10' of the present embodiment includes a substrate 210', a circuit layer 220", a unit defining layer 230A, a semiconductor chip 100", a bottom filler layer 240', an adhesive layer 250', a color filter layer 260', and a substrate 270'.

Specifically, the substrate 210' may include a rigid substrate, a flexible substrate, or a combination thereof. By way of example and not limitation, the material of the substrate 210' may include glass, quartz, sapphire, ceramic, polycarbonate (PC), polyimide (PI), polyethylene terephthalate (PET), other suitable substrate materials, or combinations thereof.

The circuit layer 220" is disposed on the substrate 210'. The circuit layer 220" may be an active driving circuit or a passive driving circuit, for the purpose of driving the semiconductor chip 100". The circuit layer 220" may include an insulating layer 221, a conductive layer 222', and metal traces (not shown), among other elements. The conductive layer 222' is disposed on the insulating layer 221, and the conductive layer 222' may include a pad 2221 and a pad 2222 separated from each other. The metal traces are disposed within the insulating layer 221. In this embodiment, the material of the conductive layer 222' may include gold, tin, copper, other suitable conductive materials, or combinations thereof, but is not limited thereto. The insulating layer 221 may be a single-layer structure or a multi-layer structure, and the material of the insulating layer 221 may include organic materials, inorganic materials, or combinations thereof, but is not limited thereto.

The unit defining layer 230A is disposed on the circuit layer 220". The unit defining layer 230A may include a partition 231 and an opening O1' for accommodating the semiconductor chip 100". The opening O1' may expose a portion of the insulating layer 221 in the circuit layer 220" and the pad 2221 and the pad 2222 of the conductive layer 222'. In this embodiment, the material of the unit defining layer 230A may include organic photoresist, and the color of the unit defining layer 230A may be transparent, black, gray, or white, but is not limited thereto.

The semiconductor chip 100" of this embodiment may be the semiconductor chip shown in FIG. 24, thus repetitive description is omitted. The semiconductor chip 100" is disposed on the substrate 210' and within the opening O1' of the unit defining layer 230A. The semiconductor chip 100" may be bonded and electrically connected to the circuit layer 220" through the conductive layer 222'. Specifically, the first electrode 130A of the semiconductor chip 100" may be in contact with and electrically connect to the pad 2221 of the conductive layer 222', while the second portion 152A of the reflective layer 150A may be in contact with and electrically connect to the pad 2222 of the conductive layer 222'. In this embodiment, the semiconductor chip 100" may include a first semiconductor chip 101', a second semiconductor chip 102', and a third semiconductor chip 103, each emitting light of a different color. For example, the first semiconductor chip 101' may emit red light, the second semiconductor chip 102' may emit green light, and the third semiconductor chip 103 may emit blue light, though this configuration is not limited thereto. The filler layers 120 of the first semiconductor chip 101' and the second semiconductor chip 102' may include a light conversion material 124, while the filler layer 120' of the third semiconductor chip 103 may include scattering particles 125' (e.g., titanium dioxide, though not limited thereto) and does not include the light conversion material.

The bottom filler layer 240' is disposed within the opening O1', and the bottom filler layer 240' may encompass the semiconductor chip 100", thereby securing the semiconductor chip 100" within the opening O1'. In the present embodiment, the material of the bottom filler layer 240' may include, but is not limited to, acrylic-based compounds, epoxy-based compounds, siloxane, silica, other suitable adhesive materials, or a combination thereof.

The adhesive layer 250' is disposed on the unit defining layer 230A. In this embodiment, the material of the adhesive layer 250' may include optically clear adhesive (OCA), optical clear resin (OCR), other suitable transparent materials, or a combination thereof, but is not limited thereto.

The color filter layer 260' is disposed on the semiconductor chip 100" and the adhesive layer 250'. The color filter layer 260' includes a color filter unit 261 and a black matrix layer 262. In the direction Z (for example, the normal direction of the substrate 210' or the normal direction of the electronic device 10'), the color filter unit 261 of the color filter layer 260' may overlap and correspond to the semiconductor chip 100", and the black matrix layer 262 may overlap and correspond to the partition 231 of the unit defining layer 230A. In this embodiment, the color filter units 261 may include a first color filter unit 2611, a second color filter unit 2612, and a third color filter unit 2613, respectively used for transmitting light of different wavelengths; thereby, the arrangement of the color filter unit 261 may further enhance the color purity of the semiconductor chip 100" or improve the ambient contrast ratio. For instance, the first color filter unit 2611 may allow red light to pass through, the second color filter unit 2612 may allow green light to pass through, and the third color filter unit 2613 may allow blue light to pass through, but is not limited thereto.

The substrate 270' is positioned on the color filter layer 260', and the substrate 270' is arranged opposite to the substrate 210'. The substrate 270' may include a rigid substrate, a flexible substrate, or a combination thereof. By way of example and not limitation, the material of the substrate 270' may include glass, quartz, sapphire, ceramic, polycarbonate, polyimide, polyethylene terephthalate, other suitable substrate materials, or a combination thereof.

Please refer to both FIG. 28 and FIG. 27. The electronic device 10a' in this embodiment is similar to the electronic device 10' in FIG. 27, with the following differences: in the electronic device 10a' of the present embodiment, the first semiconductor chip 101a' and the second semiconductor chip 102a' within the semiconductor chip 100" additionally include a DBR layer 170A. Furthermore, the third semiconductor chip 103 within the semiconductor chip 100" does not require the configuration of the DBR layer 170A.

Specifically, referring to FIG. 28, the DBR layer 170A is disposed on the opening O1' of the unit defining layer 230A, and the DBR layer 170A is disposed on the second electrodes 140A of the first semiconductor chip 101a' and the second semiconductor chip 102a'. In the direction Z (for example, the normal direction of the substrate 210' or the normal direction of the electronic device 10'), the DBR layer 170A may overlap and correspond to the first semiconductor chip 101a' and the second semiconductor chip 102a' in the semiconductor chip 100". In this embodiment, the DBR layer 170A may be used to reflect short-wavelength light (e.g., blue light) and allow long-wavelength light (e.g., red or green light) to pass through, thereby reducing the probability of short-wavelength light emitted by the first semiconductor chip 101a' and the second semiconductor chip 102a' being directly emitted without undergoing light conversion, thus enhancing the color purity of the semiconductor chip.

Although FIG. 28 schematically depicts the DBR layer 170A as a single layer, the present disclosure does not impose any limitations on the number of layers in the DBR layer 170A. In some embodiments, a stack of multiple DBR layers may be configured in accordance with design or operational requirements to selectively allow the passage of light of different colors.

The color filter layer 260' is disposed on the DBR layer 170A, and the DBR layer 170A is disposed between the color filter layer 260' and the semiconductor chip 100".

In summation, in the electronic device and semiconductor chip of the disclosed embodiment, owing to the filler layer including light conversion material, and the reflective layer being disposed on the filler layer, the light emitted by the semiconductor die may sufficiently interact with the light conversion material, thereby enhancing the light conversion efficiency. Furthermore, the color purity of the semiconductor chip may be improved by: positioning the light-shielding electrode between the second type semiconductor layer and the second electrode; disposing the DBR layer on the second electrode; or placing the color filter layer on the semiconductor chip.

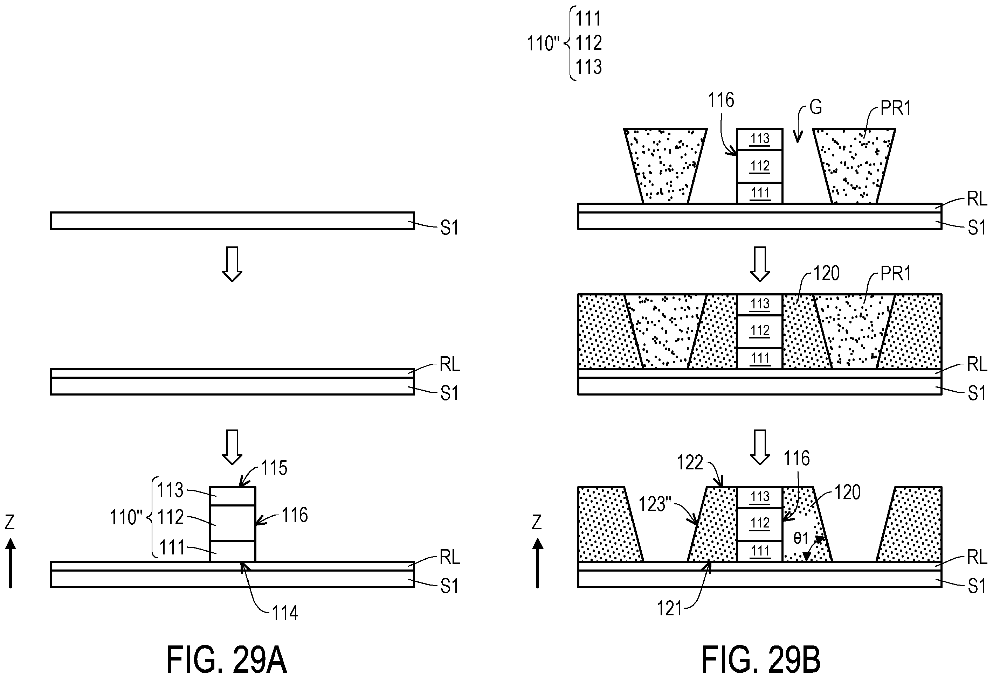

FIG. 29A to FIG. 29D are cross-sectional schematic views illustrating a method of manufacturing a semiconductor chip according to an embodiment of the present disclosure. The method of manufacturing the semiconductor chip 100‴ of this embodiment may include the following steps.

Please refer to FIG. 29A. Firstly, a first carrier S1 is provided; subsequently, a sacrificial layer RL is formed on the first carrier S1; thereafter, the semiconductor die 110" is transferred onto the first carrier S1.

Specifically, in the present embodiment, the first carrier S1 may include a rigid substrate, a flexible substrate, or a combination thereof. By way of example, the material of the first carrier S1 may include, but is not limited to, glass, quartz, sapphire, ceramic, polycarbonate (PC), polyimide (PI), polyethylene terephthalate (PET), epoxy, other suitable carrier materials, or a combination thereof.

A sacrificial layer RL is disposed between the semiconductor die 110" and the first carrier S1. The sacrificial layer RL may be removed together with the first carrier S1 in subsequent steps. In this embodiment, the material of the sacrificial layer RL may include, but is not limited to, an adhesive material that loses its adhesive properties when heated or exposed to ultraviolet light, or easily removable materials such as silicon nitride or silicon oxide.

The semiconductor die 110" may be a vertical type semiconductor die (vertical type chip). In the direction Z (for example, the normal direction of the first carrier S1), the semiconductor die 110" sequentially includes, from bottom to top, a first type semiconductor layer 111, an active layer 112, and a second type semiconductor layer 113. The first type semiconductor layer 111 is closer to the first carrier S1 than the second type semiconductor layer 113, and the active layer 112 is disposed between the first type semiconductor layer 111 and the second type semiconductor layer 113. The semiconductor die 110" has a surface 114, the other surface 115, and a lateral surface 116. The surface 114 and the other surface 115 are opposite to each other, with the surface 114 being closer to the first carrier S1 than the other surface 115, and the lateral surface 116 connecting the surface 114 and the other surface 115. In this embodiment, the semiconductor die 110" may be a light-emitting element (such as an organic light-emitting diode, sub-millimeter light-emitting diode, micro-light-emitting diode, or quantum dot light-emitting diode, but not limited thereto), but is not limited to these examples. In this embodiment, the first type semiconductor layer 111 may be a P-type semiconductor layer, and the second type semiconductor layer 113 may be an N-type semiconductor layer, but is not limited to this configuration. In some embodiments, the first type semiconductor layer may also be an N-type semiconductor layer, and the second type semiconductor layer may also be a P-type semiconductor layer. In this embodiment, the active layer 112 may be a light-emitting layer, but is not limited to this function.

Then, referring to FIG. 29B, a negative photoresist PR1 is formed on the sacrificial layer RL; subsequently, a filler layer 120 is formed on the lateral surface 116 of the semiconductor die 110" and on the sacrificial layer RL exposed by the negative photoresist PR1; thereafter, the negative photoresist PR1 is removed.

Specifically, prior to the formation of the filler layer 120, the negative photoresist PR1 may expose the semiconductor die 110" and a portion of the sacrificial layer RL, with a gap G existing between the negative photoresist PR1 and the semiconductor die 110". The shape of the negative photoresist PR1 may be in the form of an inverted trapezoid. In this embodiment, the material of the negative photoresist PR1 may include, but is not limited to, acrylic-based compounds, epoxy-based compounds, siloxane, and silica.

The filler layer 120 may surround and be in contact with the lateral surface 116 of the semiconductor die 110". The filler layer 120 may include a first surface 121, a second surface 122, and a lateral surface 123". The first surface 121 is opposite to the second surface 122, and the first surface 121 is closer to the first carrier S1 than the second surface 122. The lateral surface 123" is located between the first surface 121 and the second surface 122, and the lateral surface 123" connects the first surface 121 with the second surface 122. In this embodiment, the angle θ1 between the first surface 121 and the lateral surface 123" has a taper angle. The angle θ1 may range from 10 degrees to 80 degrees, or from 30 degrees to 70 degrees, for the purpose of converging the light emitted from the semiconductor die 110", reducing the light emission angle of the semiconductor die 110", or improving the light output efficiency of the semiconductor die 110", but is not limited thereto. In this embodiment, the material of the filler layer 120 may include acrylic-based compounds, epoxy-based compounds, siloxane, silica, other transparent filler materials, or combinations thereof, but the disclosure is not limited thereto.

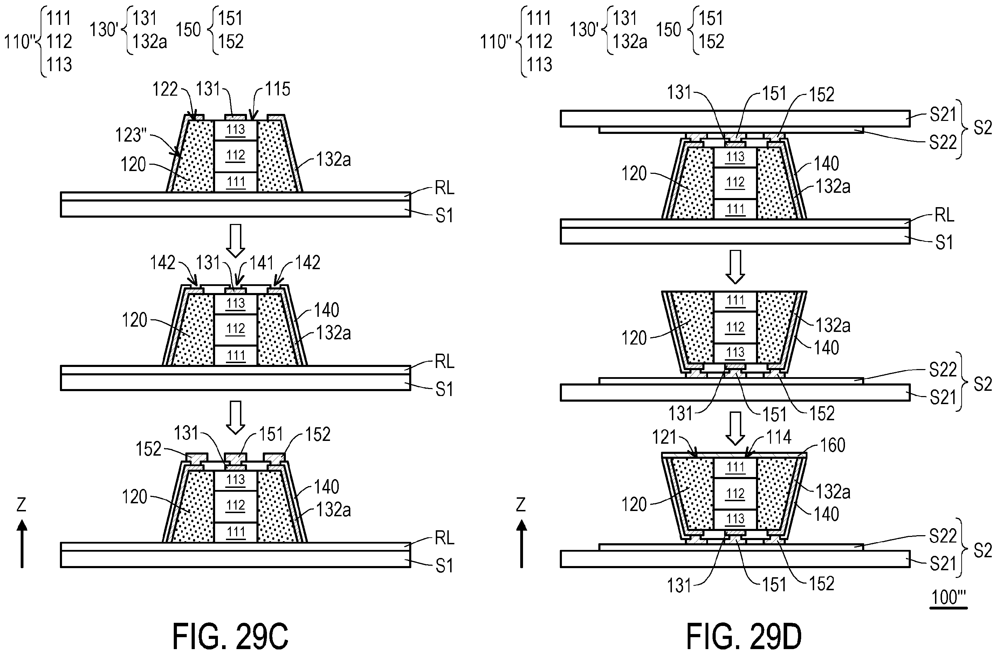

Subsequently, with reference to FIG. 29C, a reflective layer 130' is formed on the semiconductor die 110" and the lateral surface 123" of the filler layer 120; thereafter, an insulating layer 140 is formed on the reflective layer 130'; subsequently, an electrode layer 150 is formed on the reflective layer 130'.

Specifically, the reflective layer 130' includes a first portion 131 and a second portion 132a. The first portion 131 is disposed on the other surface 115 of the semiconductor die 110". The first portion 131 may be in contact with and be electrically connected to the second type semiconductor layer 113 of the semiconductor die 110". The second portion 132a is disposed on the filler layer 120. The second portion 132a is disposed on the lateral surface 123" and the second surface 122 of the filler layer 120. The second portion 132a is separated from the first portion 131. In this embodiment, the material of the reflective layer 130' may include a material with high reflectivity, for the purpose of converging the light emitted from the semiconductor die 110", reducing the light emission angle of the semiconductor die 110", or improving the light output efficiency of the semiconductor die 110".

The insulating layer 140 surrounds the reflective layer 130', and the insulating layer 140 may separate the first portion 131 from the second portion 132a of the reflective layer 130'. The insulating layer 140 has an opening 141 and an opening 142. The opening 141 may expose a portion of the first portion 131, and the opening 142 may expose a portion of the second portion 132a. In the present embodiment, the material of the insulating layer 140 may include, but is not limited to, acrylic-based compounds, epoxy-based compounds, silica, silicon dioxide, silicon nitride, silicon oxynitride, other suitable insulating materials, or combinations thereof.

The electrode layer 150 includes a first electrode 151 and a second electrode 152. The first electrode 151 and the second electrode 152 are separated from each other. The first electrode 151 is disposed on the insulating layer 140 and within the opening 141 of the insulating layer 140, wherein the first electrode 151 is connectable to the first portion 131. The second electrode 152 is disposed on the insulating layer 140 and within the opening 142 of the insulating layer 140, wherein the second electrode 152 may be connected to the second portion 132a. In the present embodiment, the material of the electrode layer 150 may include, but is not limited to, gold, tin, copper, other suitable electrode materials, or combinations thereof. In the present embodiment, the first electrode 151 may be an N-type electrode, and the second electrode 152 may be a P-type electrode, but is not limited thereto. In some embodiments, the first electrode may also be a P-type electrode, and the second electrode may also be an N-type electrode. Herein, an N-type electrode refers to an electrode electrically connected to an N-type semiconductor layer, and a P-type electrode refers to an electrode electrically connected to a P-type semiconductor layer.

Then, referring to FIG. 29D, the second carrier S2 is adhered to the electrode layer 150; subsequently, the structure is inverted and the first carrier S1 is removed, thereby transferring the semiconductor die 110" from the first carrier S1 to the second carrier S2; thereafter, a transparent conductive layer 160 is formed on the surface 114 of the semiconductor die 110".

Specifically, the second carrier S2 includes a substrate S21 and a circuit layer S22. The circuit layer S22 is disposed between the substrate S21 and the electrode layer 150. The circuit layer S22 may include metal traces (not shown), and the circuit layer S22 may be utilized to drive the semiconductor die 110". In the present embodiment, the substrate S21 may include a rigid substrate, a flexible substrate, or a combination thereof. By way of example, the material of the substrate S21 may include, but is not limited to, glass, quartz, sapphire, ceramic, polycarbonate, polyimide, polyethylene terephthalate, other suitable substrate materials, or a combination thereof.

In this embodiment, for example, the separation of the sacrificial layer RL from the semiconductor die 110" is achieved through the application of laser energy to the sacrificial layer RL, thereby facilitating the removal of the sacrificial layer RL and the first carrier S1.

The transparent conductive layer 160 is disposed on the surface 114 of the semiconductor die 110" and on the first surface 121 of the filler layer 120. The transparent conductive layer 160 may be connected to the second portion 132a of the reflective layer 130', and the transparent conductive layer 160 may be in contact with and electrically connect to the first type semiconductor layer 111 of the semiconductor die 110". By this means, the first type semiconductor layer 111 of the semiconductor die 110" may be electrically connected to the second electrode 152 through the transparent conductive layer 160 and the second portion 132a.

In the present embodiment, the step of forming the transparent conductive layer 160 may be subsequent to the step of forming the reflective layer 130'; however, this sequence is not limiting. In some embodiments, the step of forming the transparent conductive layer 160 may precede the step of forming the reflective layer 130'.

Therewith, the fabrication of the semiconductor chip 100 according to the present embodiment has been substantially completed.

In the present embodiment, due to the vertical configuration of the semiconductor die 110", the first type semiconductor layer 111 and the second type semiconductor layer 113 may be electrically connected to the second electrode 152 and the first electrode 151, respectively. Furthermore, the second electrode 152 and the first electrode 151 may be positioned on the same side of the semiconductor chip 100'". Consequently, this configuration enables direct testing or process monitoring of the semiconductor chip 100‴ subsequent to transfer of the semiconductor chip 100‴ onto the second carrier S2, thereby potentially enhancing the transfer yield.

In the present embodiment, as the semiconductor chip 100‴ may be a vertical embedded flip-chip (VEFC), it is possible to implement direct inspection or process monitoring of the semiconductor chip 100‴ subsequent to transfer of the semiconductor chip 100‴ onto the second carrier S2, thereby potentially enhancing the transfer yield.

The following exemplary embodiments are provided for illustrative purposes. It should be noted that these embodiments utilize the same element designations and partially incorporate content from the preceding embodiments. Identical numerals are employed to denote identical or substantially similar elements, and explanations of identical technical content are omitted. For elucidation on the omitted portions, reference may be made to the foregoing embodiments. The subsequent embodiments shall not reiterate redundant information.

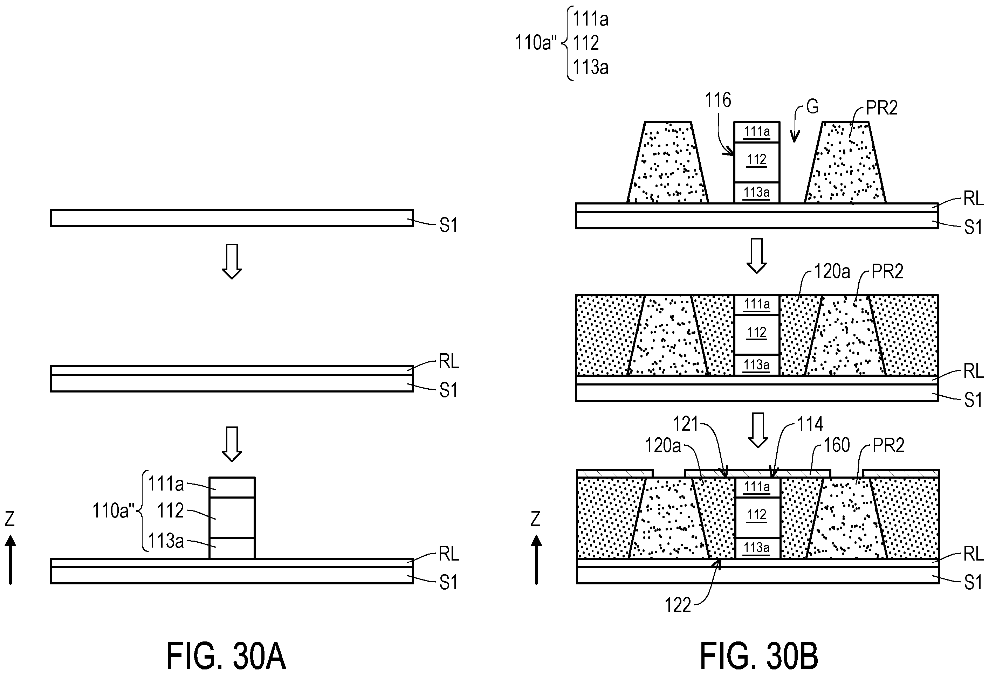

FIG. 30A to FIG. 30E are cross-sectional schematic views illustrating a manufacturing method for a semiconductor chip according to another embodiment of the present disclosure. The embodiment shown in FIG. 30A to FIG. 30E is similar to the embodiment shown in FIG. 29A to FIG. 29D. Therefore, identical or similar elements may be fabricated using the same materials or methods. Consequently, the following description will not reiterate the identical and similar aspects between the two embodiments, but will primarily focus on elucidating the differences between them.

The method of manufacturing the semiconductor chip 100a according to the present embodiment may include the following steps.

Firstly, referring to FIG. 30A, a first carrier S1 is provided; subsequently, a sacrificial layer RL is formed on the first carrier S1; thereafter, a semiconductor die 110a" is transferred onto the first carrier S1. In this embodiment, along the direction Z (for example, the normal direction of the first carrier S1), the semiconductor die 110a" sequentially includes, from bottom to top, the second type semiconductor layer 113a, the active layer 112, and the first type semiconductor layer 111a. The second type semiconductor layer 113a is positioned closer to the first carrier S1 than the first type semiconductor layer 111a, and the active layer 112 is disposed between the first type semiconductor layer 111a and the second type semiconductor layer 113a.

Then, referring to FIG. 30B, the positive photoresist PR2 is formed on the sacrificial layer RL; subsequently, the filler layer 120a is formed on the lateral surface 116 of the semiconductor die 110a" and on the sacrificial layer RL exposed by the positive photoresist PR2; thereafter, a transparent conductive layer 160 is formed on the surface 114 of the semiconductor die 110a" and on the first surface 121 of the filler layer 120a. In this embodiment, the shape of the positive photoresist PR2 may be a positive trapezoid, and the material of the positive photoresist PR2 may include acrylic-based compounds, epoxy-based compounds, siloxane, silica, but is not limited thereto. In this embodiment, the second surface 122 of the filler layer 120a is closer to the first carrier S1 than the first surface 121.

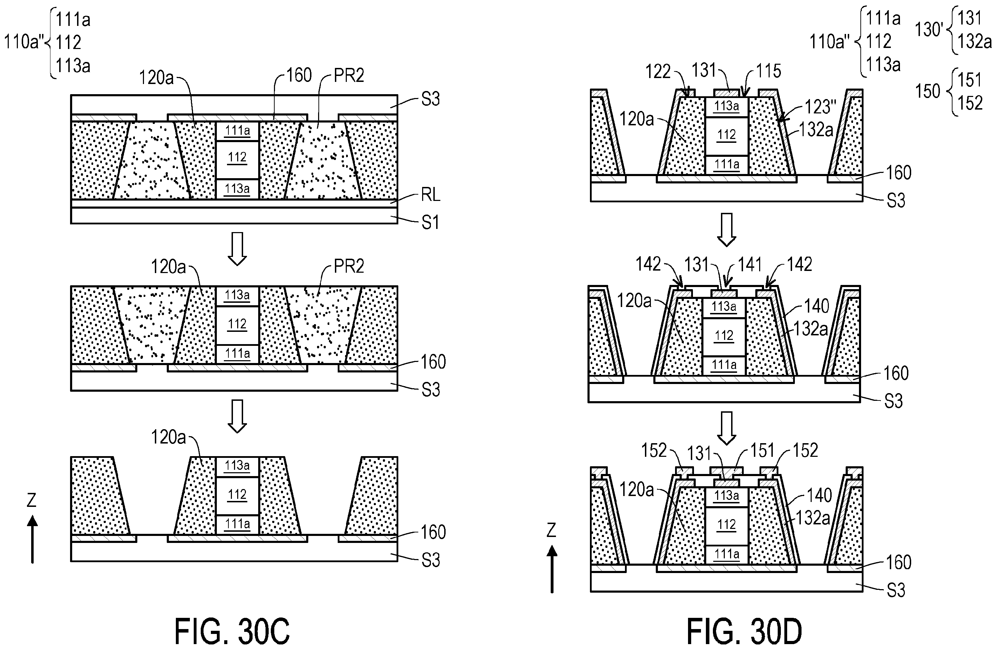

Subsequently, please refer to FIG. 30C, the third carrier S3 is adhered to the transparent conductive layer 160; then, the structure is inverted and the first carrier S1 is removed; thereafter, the positive photoresist PR2 is removed.

Then, please refer to FIG. 30D, a reflective layer 130' is formed on the other surface 115 of the semiconductor die 110a", on the lateral surface 123" of the filler layer 120a, and on the second surface 122 of the filler layer 120a; subsequently, an insulating layer 140 is formed on the reflective layer 130'; thereafter, the first electrode 151 and the second electrode 152 of the electrode layer 150 are formed on the reflective layer 130'.

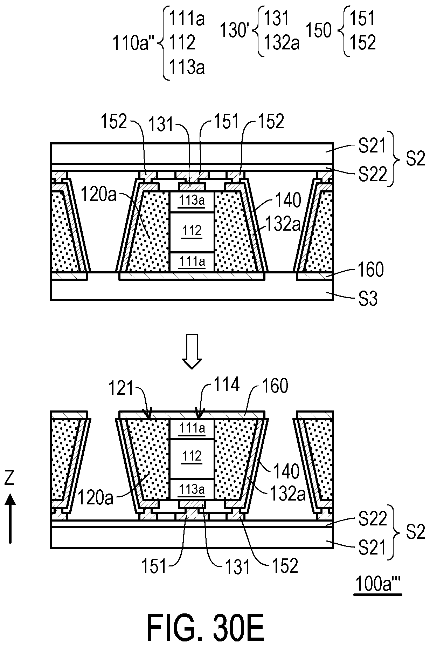

Then, with reference to FIG. 30E, the second carrier S2 is adhered to the electrode layer 150; subsequently, the structure is inverted and the third carrier S3 is removed, thereby transferring the semiconductor die 110a" from the third carrier S3 to the second carrier S2.

Therewith, the semiconductor chip 100a of the present embodiment has been substantially fabricated.

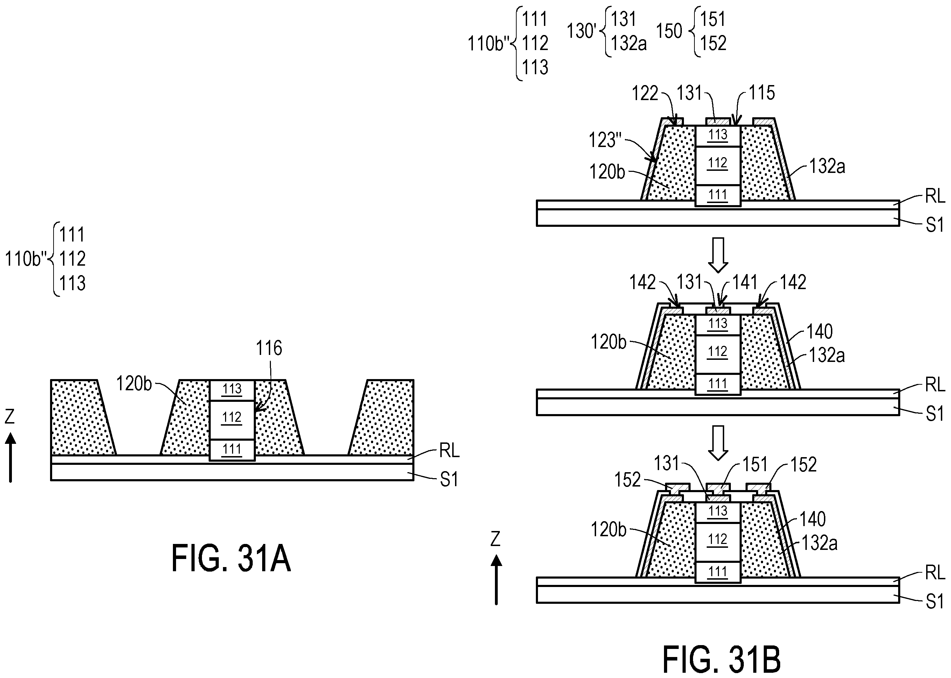

FIG. 31A to FIG. 31C are cross-sectional schematic views illustrating a manufacturing method for a semiconductor chip according to still another embodiment of the present disclosure. The embodiment shown in FIG. 31A to FIG. 31C is similar to the embodiment shown in FIG. 29A to FIG. 29D. Therefore, identical or similar elements may be manufactured using the same materials or methods. Consequently, the following description will not reiterate the identical and similar aspects between the two embodiments, but will primarily focus on elucidating the differences between them.

The manufacturing method of the semiconductor chip 100b in the present embodiment may include the following steps.

First, referring to FIG. 31A, following steps similar to those in FIG. 29A, after providing the first carrier S1 and forming the sacrificial layer RL on the first carrier S1, the semiconductor die 110b" is transferred onto the first carrier S1, and the semiconductor die 110b" is partially embedded in the sacrificial layer RL. Subsequently, the step of using the negative photoresist as shown in FIG. 29B is omitted, the patterning process is directly proceeded after the filler layer 120b is disposed on the lateral surface 116 of the semiconductor die 110b".

Thereafter, please refer to FIG. 31B, the reflective layer 130' is formed on the other surface 115 of the semiconductor die 110b", on the lateral surface 123" of the filler layer 120b, and on the second surface 122 of the filler layer 120b; subsequently, the insulating layer 140 is formed on the reflective layer 130'; thereafter, the first electrode 151 and the second electrode 152 of the electrode layer 150 are formed on the reflective layer 130'.

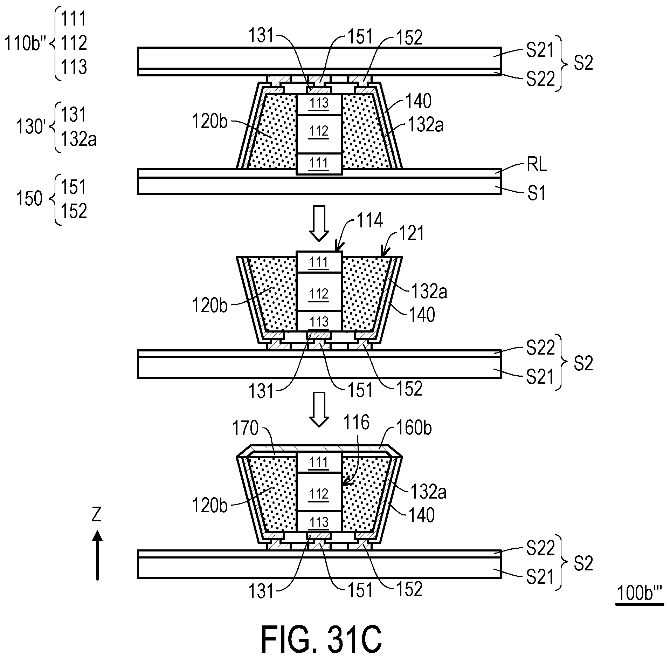

Then, referring to FIG. 31C, the second carrier S2 is adhered to the electrode layer 150; subsequently, the structure is inverted and the first carrier S1 is removed to transfer the semiconductor die 110b" from the first carrier S1 to the second carrier S2; thereafter, prior to the step of forming the transparent conductive layer 160b, the insulating layer 170 is formed on the lateral surface 116 of the semiconductor die 110b" where the filler layer 120b is not formed yet; subsequently, after the step of forming the insulating layer 170, the transparent conductive layer 160b is formed on the insulating layer 170, ensuring that the transparent conductive layer 160b connects to the second portion 132a of the reflective layer 130'. In this embodiment, the insulating layer 170 may have a single-layer or multi-layer structure, and the material of the insulating layer 170 may include organic materials, inorganic materials, or a combination thereof, but is not limited thereto.

At this juncture, the fabrication of the semiconductor chip 100b of the present embodiment has been substantially completed.

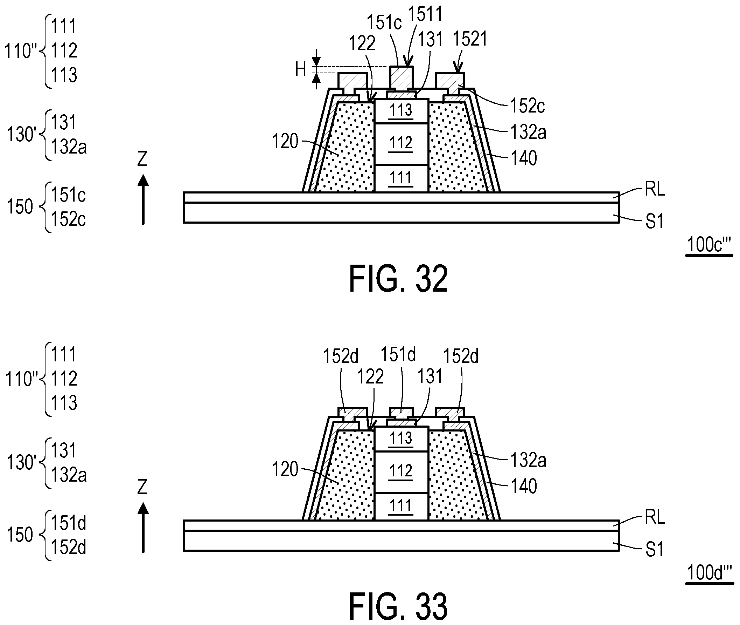

FIG. 32 illustrates a cross-sectional view of a semiconductor chip according to an embodiment of the present disclosure. With reference to both FIG. 32 and FIG. 29C, the semiconductor chip 100c‴ of this embodiment is similar to the semiconductor chip 100‴ shown in FIG. 29C, with the following distinction: in the semiconductor chip 100c‴ of the present embodiment, along the direction Z (for example, the normal direction of the first carrier S1), the first electrode 151c may be positioned at a higher elevation than the second electrode 152c.

Specifically, with reference to FIG. 32, along the direction Z, the other surface 115 of the semiconductor die 110" is elevated above the second surface 122 of the filler layer 120, and the first portion 131 of the reflective layer 130' is elevated above the second portion 132a.

The first electrode 151c has a surface 1511 facing away from the semiconductor die 110", and the second electrode 152c has a surface 1521 facing away from the semiconductor die 110". In the direction Z, the height difference H between the first electrode 151c and the second electrode 152c may be greater than 0 and less than or equal to 1 micrometer (µm) (i.e., 0 < H ≤ 1 µm), but is not limited thereto. Herein, the height difference H is, for example, the minimum distance measured along the direction Z between the surface 1511 of the first electrode 151c and the surface 1521 of the second electrode 152c.

FIG. 33 illustrates a cross-sectional view of a semiconductor chip according to another embodiment of the present disclosure. Referring concurrently to FIG. 33 and FIG. 32, the semiconductor chip 100d‴ of the present embodiment is similar to the semiconductor chip 100c‴ depicted in FIG. 32, with the following distinction: in the semiconductor chip 100d‴ of the present embodiment, the first electrode 151d and the second electrode 152d are formed through distinct processes, resulting in the first electrode 151d and the second electrode 152d being substantially equal in height along the direction Z (for example, the normal direction of the first carrier S1).

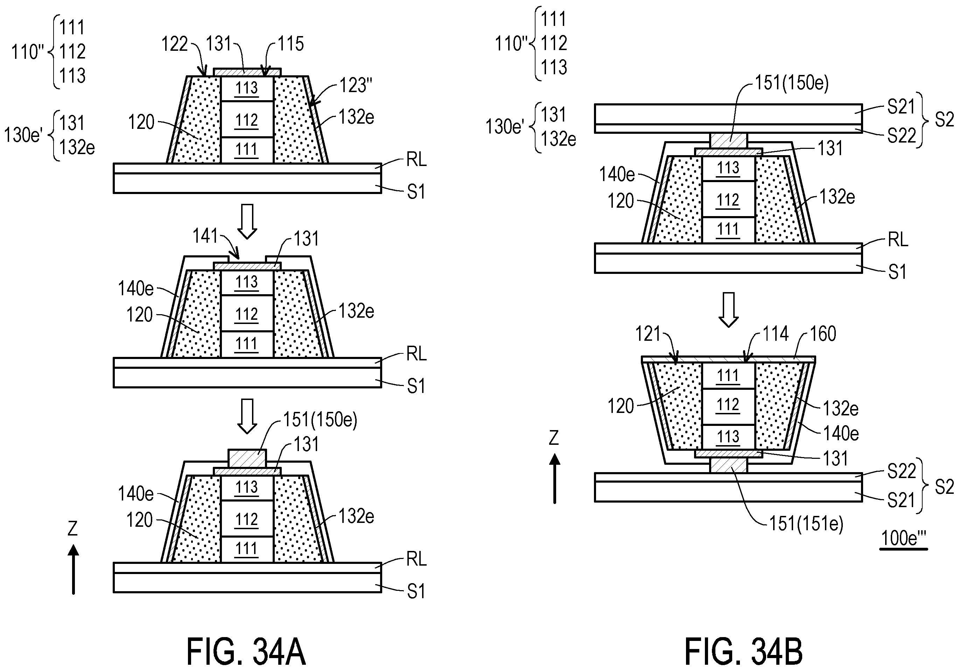

FIG. 34A to FIG. 34B are cross-sectional schematic views of a semiconductor chip in yet another embodiment of the disclosure. FIG. 34A to FIG. 34B represent steps that follow FIG. 29B and replace FIG. 29C to FIG. 29D. The embodiment depicted in FIG. 34A to FIG. 34B employs identical or similar materials and methods for elements that are the same as or similar to those in the embodiment illustrated in FIG. 29A to FIG. 29D. Therefore, the following description will not reiterate the identical or similar aspects of the two embodiments, but will primarily elucidate the differences between them.

The manufacturing method for the semiconductor chip 100e of the present embodiment may include the following steps.

Firstly, referring to FIG. 34A, subsequent to the formation of the structure depicted in FIG. 29B, the first portion 131 of the reflective layer 130e' is formed on the other surface 115 of the semiconductor die 110", and the second portion 132ae of the reflective layer 130e' is formed on the lateral surface 123" of the filler layer 120; subsequently, the insulating layer 140e is formed on the reflective layer 130e', wherein the insulating layer 140e has an opening 141 that exposes a portion of the first portion 131; thereafter, the first electrode 151 of the electrode layer 150e is formed on the insulating layer 140e and within the opening 141 of the insulating layer 140e.

Then, referring to FIG. 34B, the second carrier S2 is adhered to the electrode layer 150e. Subsequently, the structure is inverted and the first carrier S1 is removed, thereby transferring the semiconductor die 110" from the first carrier S1 to the second carrier S2. Thereafter, the transparent conductive layer 160 is formed on the surface 114 of the semiconductor die 110".

At this juncture, the fabrication of the semiconductor chip 100e‴ of the present embodiment has been substantially completed. The semiconductor chip 100e‴ of the present embodiment may be construed as a vertical embedded chip (VEC), but is not limited thereto.

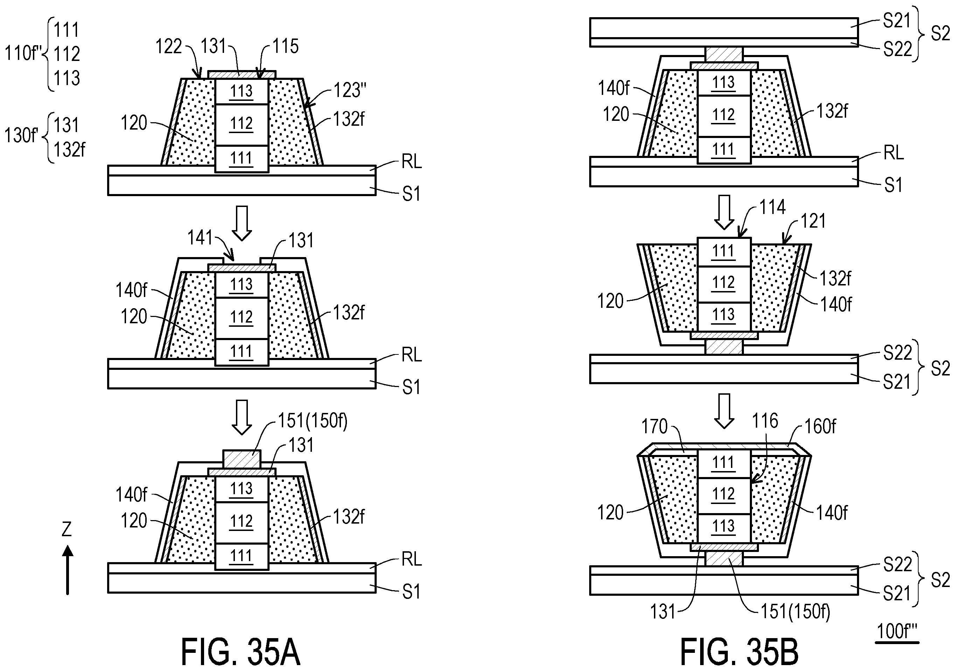

FIG. 35A to FIG. 35B are cross-sectional schematic views of a semiconductor chip in still another embodiment of the disclosure. The embodiment shown in FIG. 35A to FIG. 35B is similar to the embodiment shown in FIG. 34A to FIG. 34B. Therefore, identical or similar elements may be fabricated using the same materials or methods. Consequently, descriptions of identical or similar aspects between the two embodiments will not be repeated hereinafter. The following explanation will primarily focus on elucidating the differences between these two embodiments.

The method of manufacturing the semiconductor chip 100f" of the present embodiment may include the following steps.

First, referring to FIG. 35A, the semiconductor die 110f" of this embodiment may be partially embedded in the sacrificial layer RL. Subsequently, in a manner similar to the steps shown in FIG. 34A, the first portion 131 of the reflective layer 130f is formed on the other surface 115 of the semiconductor die 110f", and the second portion 132af of the reflective layer 130f is formed on the lateral surface 123" of the filler layer 120. Next, an insulating layer 140f is formed on the reflective layer 130f, wherein the insulating layer 140f has an opening 141 that exposes a portion of the first portion 131. Subsequently, the first electrode 151 of the electrode layer 150f is formed on the insulating layer 140f and within the opening 141 of the insulating layer 140f.

Then, referring to FIG. 35B, the second carrier S2 is adhered to the electrode layer 150f; subsequently, the structure is inverted and the first carrier S1 is removed to transfer the semiconductor die 110f' from the first carrier S1 to the second carrier S2; thereafter, prior to the step of forming the transparent conductive layer 160f, the insulating layer 170 is formed on the lateral surface 116 of the semiconductor die 110f" where the filler layer 120 is not formed yet; subsequently, after the step of forming the insulating layer 170, the transparent conductive layer 160f is formed on the insulating layer 170, and the transparent conductive layer 160f is connected to the second portion 132a of the reflective layer 130f. In this embodiment, the insulating layer 170 may have a single-layer structure or a multi-layer structure, and the material of the insulating layer 170 may include organic materials, inorganic materials, or a combination thereof, but is not limited thereto.

At this juncture, the fabrication of the semiconductor chip 100f of the present embodiment has been substantially completed.

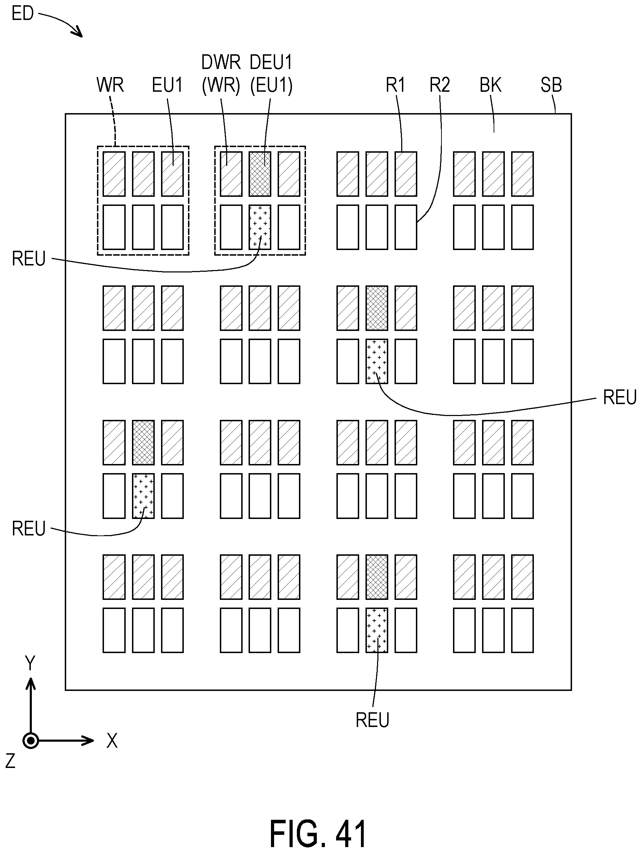

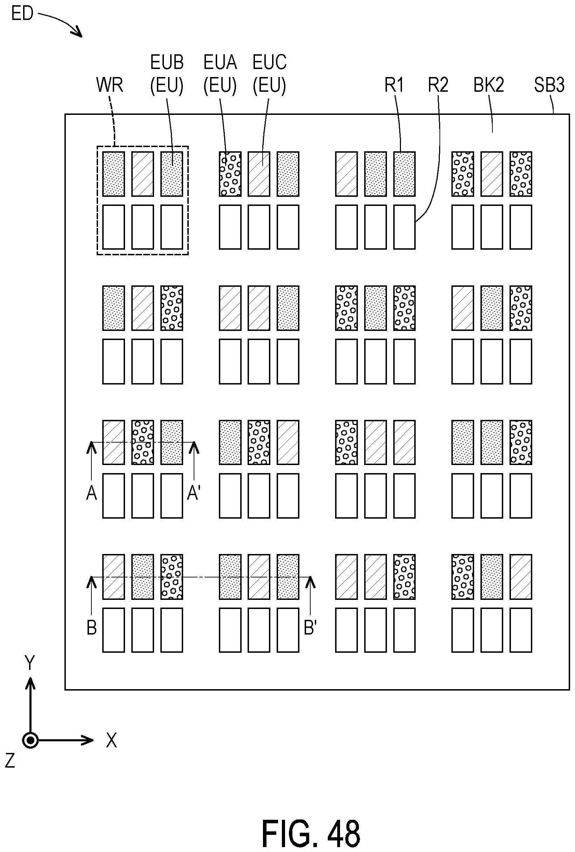

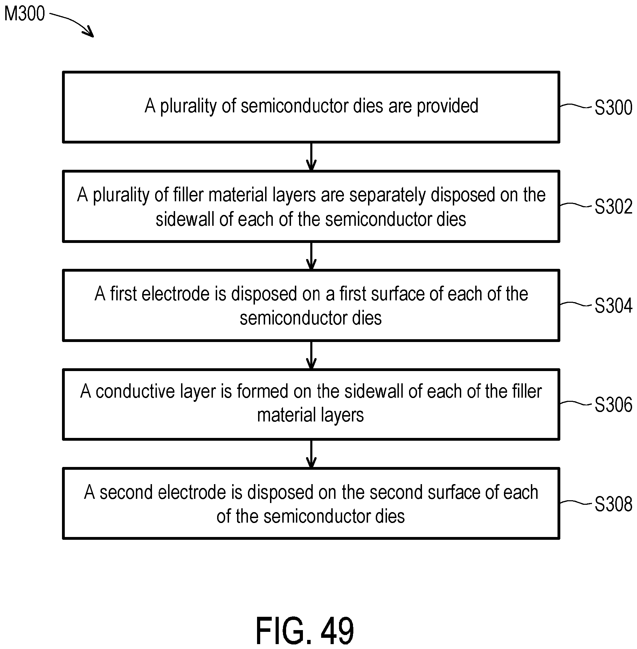

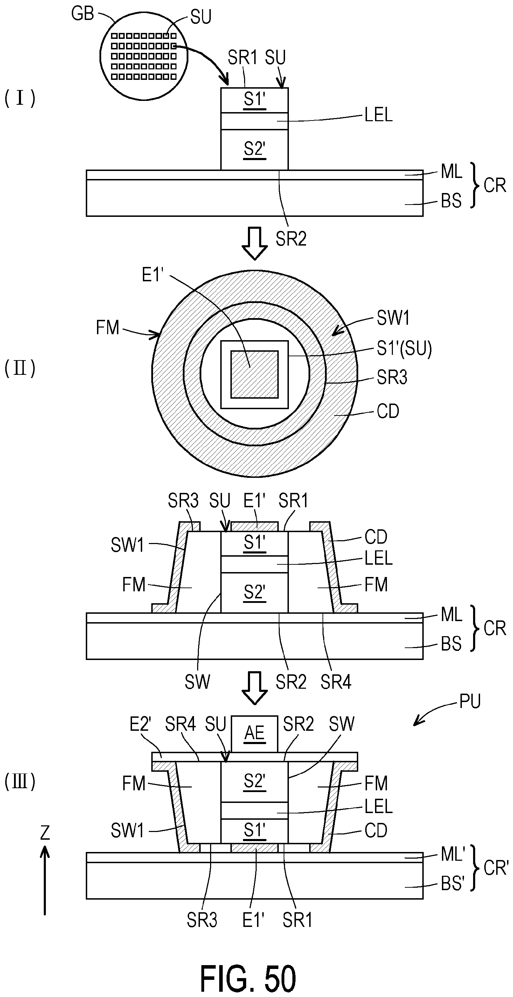

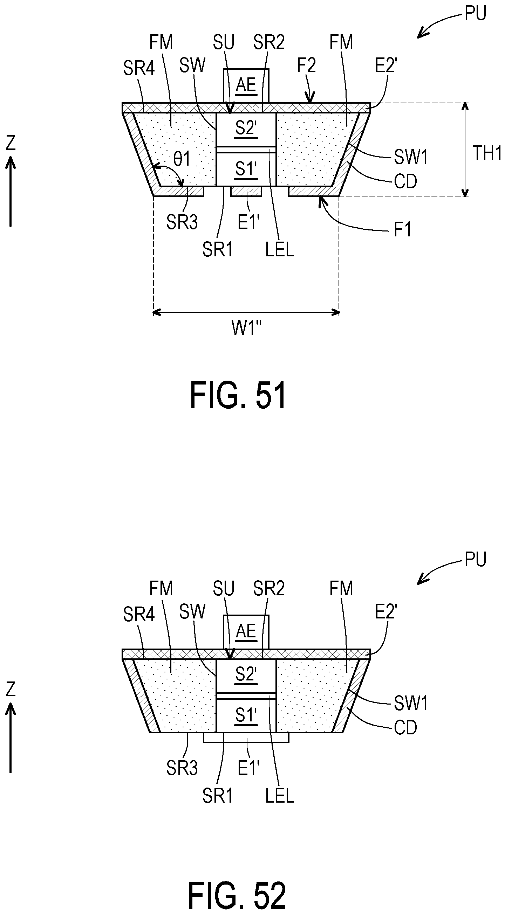

Please refer to FIG. 49 to FIG. 51. FIG. 49 illustrates a flow chart diagram of a manufacturing method for an electronic unit of an electronic device according to an embodiment of the present disclosure. FIG. 50 depicts a process diagram of an electronic unit of an electronic device according to an embodiment of the present disclosure. FIG. 51 shows a cross-sectional view of an electronic unit of an electronic device according to an embodiment of the present disclosure. According to the present disclosure, the electronic unit (e.g., electronic unit EU shown in FIG. 41 and FIG. 48) of the electronic device (e.g., electronic device ED shown in FIG. 41 and FIG. 48) includes a semiconductor chip PU. The semiconductor chip PU includes a semiconductor die SU. The semiconductor die SU may refer to any suitable element including a semiconductor layer or formed through semiconductor processes. The semiconductor die SU may include any suitable elements depending on the type or purpose of the electronic device. For example, in an embodiment, the electronic device may include a display device, and the semiconductor die SU may include a semiconductor unit, such as a light-emitting diode, but is not limited thereto. In some embodiments, the electronic device may include a sensing device, and the semiconductor die SU may include any suitable sensing unit, such as a photodiode, but is not limited thereto. The following description uses an example where the semiconductor die SU includes a light-emitting diode to illustrate the manufacturing method of the electronic device. Specifically, the semiconductor chip PU may be formed by performing a packaging process on the semiconductor die SU. After forming the semiconductor chip PU, a fluidic transfer process may be used to transfer the semiconductor chip PU to a target substrate (e.g., substrate SB shown in FIG. 41 or third substrate SB3 shown in FIG. 48) to form the electronic device. In other words, a packaging process may first be performed on the semiconductor die to form the semiconductor chip PU, followed by a fluidic transfer process to transfer the semiconductor chip PU to the target substrate to form the electronic device. According to this embodiment, the manufacturing method M300 of the semiconductor chip PU may include the following steps.

S300: A plurality of semiconductor dies are provided.

S302: A plurality of filler material layers are separately disposed on the sidewall of each of the semiconductor dies.

S304: A first electrode is disposed on a first surface of each of the semiconductor dies.

S306: A conductive layer is formed on the sidewall of each of the filler material layers.

S308: A second electrode is disposed on the second surface of each of the semiconductor dies.

The following will provide a detailed description of the steps involved in the manufacturing method M300 for the semiconductor chip PU.

The manufacturing method M300 for the semiconductor chip PU includes first performing step S300, which provides a plurality of semiconductor dies SU. Specifically, as shown in process (I) of FIG. 50, a substrate GB and a plurality of semiconductor dies SU disposed on the substrate GB may be provided initially. The substrate GB may include a growth substrate, but is not limited thereto. For example, the semiconductor dies SU may be formed on the substrate GB through epitaxial processes. The spacing between the plurality of semiconductor dies SU on the substrate GB may range from 1 µm to 50 µm. In some embodiments, the substrate GB may be used to carry the semiconductor dies SU or provide support for the semiconductor dies SU. Subsequently, the plurality of semiconductor dies SU may be transferred from the substrate GB to a carrier CR. In this embodiment, the plurality of semiconductor dies SU may be transferred from the substrate GB to the carrier CR through a stamp transfer method, but this is not limiting. For example, the semiconductor dies SU may be picked up from the substrate GB at a specific interval and transferred to the carrier CR, such that adjacent semiconductor dies SU on the carrier CR have the specific interval between them, facilitating subsequent packaging processes for the semiconductor dies SU. In some embodiments, the plurality of semiconductor dies SU may be directly transferred from the substrate GB to a temporary carrier. Subsequently, the semiconductor dies SU may be picked from the temporary carrier at a specified interval and transferred to the carrier CR. In some embodiments, the semiconductor dies SU may be transferred from the substrate GB to the carrier CR through laser transfer methods. The carrier CR may include a base BS and a material layer ML disposed on the base BS, with the semiconductor dies SU adhering to the base BS through the material layer ML. The base BS may include a rigid base or a flexible base. The rigid base may include, for example, glass, quartz, sapphire, ceramic, other suitable materials, or combinations thereof, while the flexible substrate may include, for example, polyimide (PI), polycarbonate (PC), polyethylene terephthalate (PET), other suitable materials, or combinations thereof, but is not limited thereto. The material layer ML may include any suitable material that provides temporary adhesion to the semiconductor dies SU, such as siloxane, acrylics, resins, and so on, to temporarily fix the semiconductor dies SU to the base BS. In this embodiment, the semiconductor dies SU may include inorganic semiconductor dies, but this is not limiting. For example, the semiconductor dies SU may include a first semiconductor layer S1', a second semiconductor layer S2', and an active layer LEL disposed between the first semiconductor layer S1' and the second semiconductor layer S2'. Specifically, the semiconductor dies SU may include a structure formed by sequentially stacking the second semiconductor layer S2', the active layer LEL, and the first semiconductor layer S1' along the normal direction (i.e., direction Z) of the carrier CR, wherein the second semiconductor layer S2' may be in contact with the material layer ML, but this is not limiting. In some embodiments, the semiconductor dies SU may include a structure formed by sequentially stacking the first semiconductor layer S 1', the active layer LEL, and the second semiconductor layer S2' along the normal direction of the carrier CR, wherein the first semiconductor layer S1' may be in contact with the material layer ML. The semiconductor dies SU may further include other suitable film layers, such as ohmic contact layers, and are not limited to the aforementioned film layers. The semiconductor dies SU include a first surface SR1 and a second surface SR2 opposite to the first surface SR1, wherein the first surface SR1 may refer to a surface of one of the semiconductor dies SU that is distal from the carrier CR, while the second surface SR2 may refer to a surface of one of the semiconductor dies SU that is proximal to the carrier CR, or in other words, a surface of one of the semiconductor dies SU that contacts the material layer ML. In this embodiment, the first surface SR1 may be the surface of the first semiconductor layer S 1', while the second surface SR2 may be the surface of the second semiconductor layer S2'. It should be noted that although process (I) of FIG. 50 only shows the structure of transferring one semiconductor die SU to the carrier CR, the carrier CR may include the plurality of semiconductor dies SU transferred from the substrate GB.

After transferring the plurality of semiconductor dies SU onto the carrier CR, proceed to step S302, wherein the plurality of filler material layers FM are respectively disposed on the sidewall SW of each of the semiconductor dies SU. Specifically, as illustrated in process (II) of FIG. 50, the semiconductor dies SU may include sidewalls SW connecting the first surfaces SR1 and the second surfaces SR2. The filler material layer FM may be disposed on the carrier CR, surrounding the sidewalls SW of the semiconductor dies SU. In other words, as shown in process (II) of FIG. 50, when viewing the semiconductor dies SU from above, the filler material layer FM may encircle the semiconductor dies SU. The filler material layer FM may cover the sidewalls of the semiconductor dies SU but not cover the first surfaces SR1 and the second surfaces SR2 of the semiconductor dies SU. Particularly, the filler material layer FM may include a third surface SR3 and a fourth surface SR4 opposite to the third surface SR3. The third surface SR3 is adjacent to the first surface SR1 of the semiconductor die SU, while the fourth surface SR4 is adjacent to the second surface SR2 of the semiconductor die SU. In the normal direction of the carrier CR, the third surface SR3 may be substantially aligned with the first surface SR1, and the fourth surface SR4 may be substantially aligned with the second surface SR2, but this is not limited thereto. The filler material layer FM may include any suitable material with high transmittance, such as acrylic, siloxane, silica, other appropriate materials, or combinations thereof. In this embodiment, the transmittance of the filler material layer FM for visible light may be greater than 90%.

According to the present embodiment, as illustrated in process (II) of FIG. 50, when observing the filler material layer FM from a top view, the outer edges of the third surface SR3 and the fourth surface SR4 of the filler material layer FM may be circular or approximately circular (e.g., elliptical, but not limited thereto). Consequently, the semiconductor chip PU may have a circular contour when viewed from the top of the electronic device ED. Specifically, the third surface SR3 (or the fourth surface SR4) has an annular shape, wherein the outer edge of the annular shape is circular or approximately circular, while the inner edge of the annular shape conforms to the shape of the semiconductor die SU. When observing the semiconductor die SU from a top view, the shape of the semiconductor die SU may include, but is not limited to, rectangular, circular, polygonal, irregular, or other suitable shapes. For instance, in this embodiment, when observing the semiconductor die SU from a top view, the shape of the semiconductor die SU may be rectangular, but is not limited thereto. The filler material layer FM further includes a sidewall SW1 connecting the third surface SR3 and the fourth surface SR4. In some embodiments, the dimension (e.g., area) of the third surface SR3 may differ from the dimension of the fourth surface SR4. For example, the dimension of the third surface SR3 is smaller than the dimension of the fourth surface SR4, and the sidewall SW1 may not be perpendicular to the third surface SR3 and the fourth surface SR4, as shown in process (II) of FIG. 50. In some embodiments, the dimension of the third surface SR3 may be substantially identical to the dimension of the fourth surface SR4, and the sidewall SW1 may be perpendicular to the third surface SR3 and the fourth surface SR4. According to the shape design of the filler material layer FM, a semiconductor die SU and the filler material layer FM surrounding the semiconductor die SU may form a disc-like structure (or cylindrical structure).

The manufacturing method M300 of the semiconductor chip PU in this embodiment further includes step S304, wherein a first electrode E1' is formed on the first surface SR1 of each of the semiconductor dies SU. Specifically, after transferring the semiconductor die SU to the carrier CR, the first electrode E1' may be formed on the first surface SR1 of the semiconductor die SU that is distal from the carrier CR. The first electrode E1' is in contact with the first surface SR1, i.e., in contact with the first semiconductor layer S1'. The first electrode E1' may include any suitable conductive material, such as metallic materials or transparent conductive materials. It should be noted that in some embodiments, after transferring the semiconductor die SU to the carrier CR, the first electrode E1' may be formed prior to the formation of the filler material layer FM. In other embodiments, after transferring the semiconductor die SU to the carrier CR, the filler material layer FM may be formed prior to the formation of the first electrode E1'.

The manufacturing method M300 of the semiconductor chip PU in this embodiment further includes step S306, wherein a conductive layer CD is formed on the sidewall SW1 of each of the filler material layer FM. Specifically, as shown in process (II) of FIG. 50, after the filler material layer FM is disposed, the conductive layer CD may be formed along the sidewall SW1 of the filler material layer FM. The conductive layer CD may be disposed surrounding the sidewall SW1 of the filler material layer FM, thereby covering the sidewall SW1 of the filler material layer FM. In this embodiment, as shown in process (II) of FIG. 50, the conductive layer CD may further extend on the third surface SR3 of the filler material layer FM, but does not contact the first electrode E1' and the first semiconductor layer S1'. In this case, when observing the conductive layer CD from a top view, a portion of the conductive layer CD located on the third surface SR3 may have an annular structure, wherein the annular structure may expose the first electrode E1' and the first semiconductor layer S1'. In some embodiments, the conductive layer CD may not extend on the third surface SR3 of the filler material layer FM or may not contact the third surface SR3; for example, an end of the conductive layer CD adjacent to the third surface SR3 may be substantially aligned with the third surface SR3. Furthermore, although process (II) of FIG. 50 illustrates a structure where the conductive layer CD further extends on the carrier CR (or the material layer ML), the present embodiment is not limited thereto. In some embodiments, the conductive layer CD may not extend on the carrier CR.

According to this disclosure, the conductive layer CD may include or at least partially include a highly reflective material. For instance, in some embodiments, the material of the conductive layer CD may be selected from highly reflective conductive materials, such as, but not limited to, silver (Ag) or aluminum (Al). In some embodiments, the conductive layer CD may include a composite structure including a conductive material layer and a reflective material layer, wherein the reflective material layer is positioned between the conductive material layer and the sidewall SW1 of the filler material layer FM. The conductive material layer may include highly conductive metallic materials, such as, but not limited to, gold (Au) or copper (Cu). The reflective material layer may include any suitable element or film layer with highly reflective properties, such as, but not limited to, a distributed Bragg reflector (DBR). By incorporating high reflectivity into the conductive layer CD, the light output efficiency of the semiconductor chip PU may be enhanced. It should be noted that in the manufacturing method M300, the step of forming the conductive layer CD (step S306) and the step of providing the first electrode E1' (step S304) may be performed in any order or simultaneously, without limitation in this embodiment.

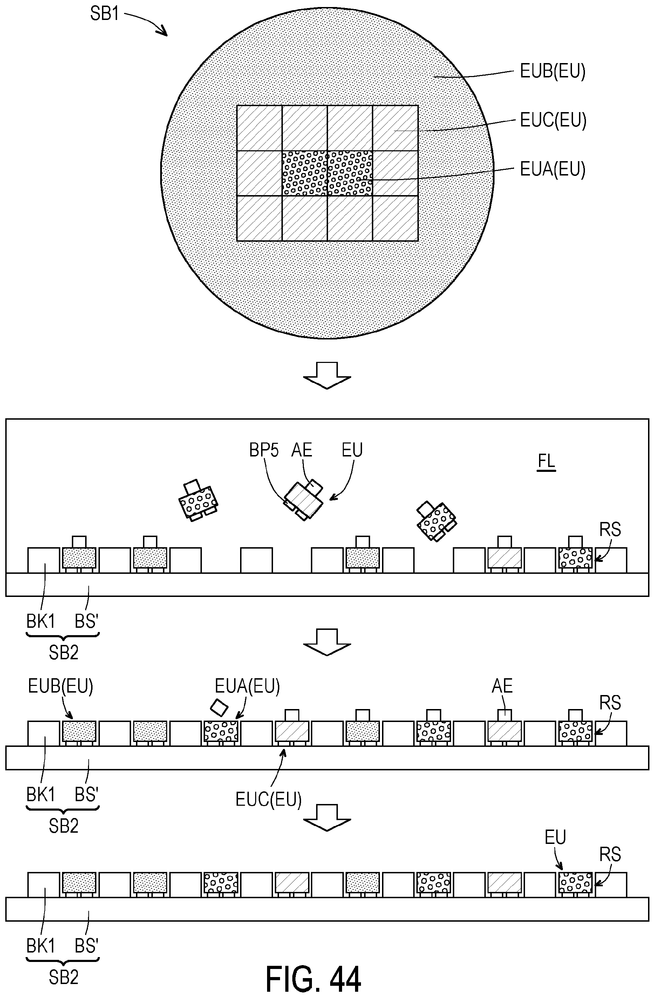

The manufacturing method M300 of the semiconductor chip PU in this embodiment also includes step S308, which involves establishing a second electrode E2' on the second surface SR2 of each of the semiconductor dies SU. Specifically, after forming the structure shown in process (II) of FIG. 50, the structure may be transferred from the carrier CR to the carrier CR'. The carrier CR' may include a base BS' and a material layer ML'. The characteristics of the base BS' and the material layer ML' may refer to the aforementioned descriptions of the base BS and the material layer ML, but are not limited thereto. As illustrated in process (III) of FIG. 50, the substrate bonding and laser lift-off techniques may be utilized for transferring the structure shown in process (II) of FIG. 50 to the carrier CR', the structure may be positioned on the carrier CR' with the first electrode E1' (or the first surface SR1 of the semiconductor die SU) facing downward. In this configuration, the second surface SR2 of the semiconductor die SU may face upward, or in other words, may be distal from the carrier CR'. The material layer ML' may contact the first electrode E1' and/or the conductive layer CD, but is not limited to this arrangement. Subsequently, the second electrode E2' may be established on the second surface SR2. Specifically, the second electrode E2' may be positioned on the second surface SR2 of the semiconductor die SU, the fourth surface SR4 of the filler material layer FM, and the conductive layer CD, making contact with the second semiconductor layer S2' and the conductive layer CD. In this configuration, the second electrode E2' is electrically connected to both the second semiconductor layer S2' and the conductive layer CD, or in other words, the second electrode E2' electrically connects the second semiconductor layer S2' and the conductive layer CD. For example, in this embodiment, the second electrode E2' may be uniformly established across the semiconductor die SU, the filler material layer FM, and the conductive layer CD, but is not limited to this arrangement. In this case, the outer edge of the second electrode E2' may be circular or approximately circular in the normal direction of the carrier CR', depending on the shape of the filler material layer FM. Through this structural design, the second semiconductor layer S2' may be electrically connected to the conductive layer CD through the second electrode E2'. In other words, a portion of the conductive layer CD extending on the third surface SR3 may serve as a bonding element for the second semiconductor layer S2', and is located on the same side as the bonding element of the first semiconductor layer S1' (i.e., the first electrode E1'). This configuration facilitates the subsequent bonding of the semiconductor chip PU to the target substrate when transferring the semiconductor chip PU onto the target substrate. The second electrode E2' may include any suitable transparent conductive materials. The spacing between the plurality of semiconductor chips PU on the carrier CR' may range from 1 µm to 100 µm. In some embodiments, the carrier CR' may replace the second substrate SB2 shown in FIG. 44 to FIG. 46. A portion of the semiconductor chips PU on the carrier CR' may be transferred to the work region WR of the third substrate SB3 through laser transfer process or stamp transfer process. Taking the laser transfer process as an example, a portion of the semiconductor chips PU on the carrier CR' is first transferred to a transfer head using laser, and then the semiconductor chips PU on the transfer head are bonded to the work region WR of the third substrate SB3 by means of laser bonding. In the case of the stamp transfer process, selected semiconductor chips PU are picked up from the carrier CR' by the protruding structure PP of the transfer head TH, and then the selected semiconductor chips PU are bonded to the work region WR of the third substrate SB3 through the protruding structure PP of the transfer head TH. The semiconductor dies SU may be arranged on the substrate GB in the most densely packed manner. The spacing between semiconductor dies SU on the substrate GB may be smaller than the spacing between the semiconductor chips PU on the carrier CR'. Furthermore, the spacing between the semiconductor chips PU on the carrier CR' may be smaller than the spacing (second spacing PS2) between the work regions WR on the third substrate SB3.

After establishing the second electrode E2', the manufacturing method M300 of the semiconductor chip PU in this embodiment may further include configuring an auxiliary element AE. The auxiliary element AE may be positioned on the second electrode E2', or more specifically, on a side of the second electrode E2' opposite to the semiconductor die SU, such that the second electrode E2' is situated between the auxiliary element AE and the second semiconductor layer S2'. Upon configuration of the auxiliary element AE, the semiconductor chip PU may be formed.

It should be noted that FIG. 50 illustratively depicts a schematic view of manufacturing a semiconductor chip PU, and other semiconductor dies SU transferred to the carrier CR may be packaged in the same manner to form the semiconductor chip PU. Furthermore, the manufacturing method of the semiconductor chip PU in this embodiment is not limited to the aforementioned steps, and may include other appropriate steps according to the structural design of the semiconductor chip PU.

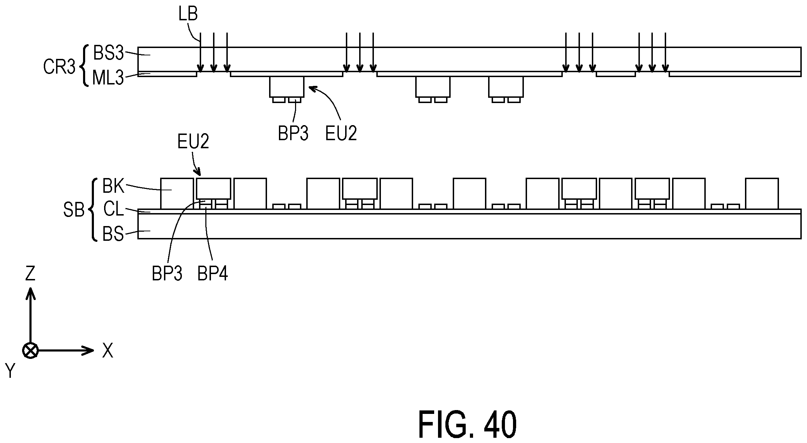

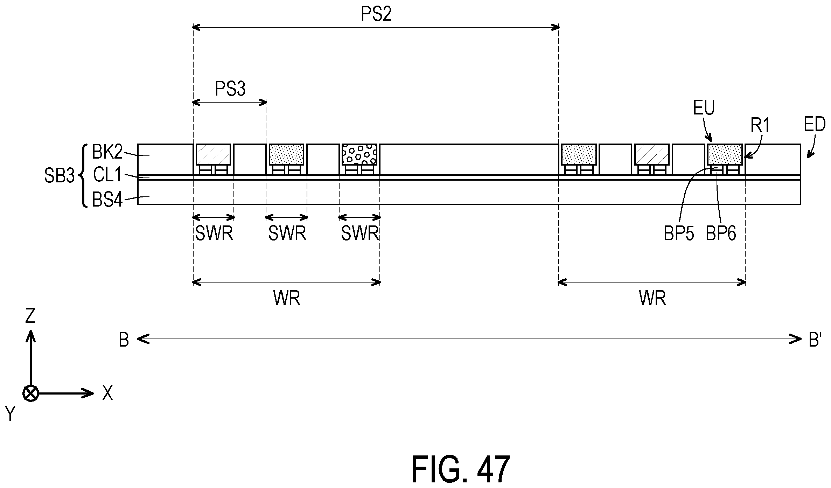

As shown in FIG. 51, the semiconductor chip PU of this embodiment may include the semiconductor die SU, the filler material layer FM surrounding the sidewall SW of the semiconductor die SU, the first electrode E1' and the second electrode E2' respectively disposed on the first surface SR1 and the second surface SR2 of the semiconductor die SU, and the conductive layer CD surrounding the sidewall SW1 of the filler material layer FM. The second electrode E2' contacts the conductive layer CD, thereby electrically connecting the second semiconductor layer S2' to the conductive layer CD. In addition to surrounding the sidewall S W1, the conductive layer CD may further extend on the third surface SR3 of the filler material layer FM. In this case, the semiconductor chip PU may have a vertical embedded flip chip structure. Specifically, the semiconductor die SU in the semiconductor chip PU may include a vertical type semiconductor die element embedded in the filler material layer FM. When subsequently transferring the semiconductor chip PU to a target substrate to form an electronic device, the first semiconductor layer S1' and the second semiconductor layer S2' of the semiconductor die SU may be electrically connected to the bonding pad (e.g., bonding pad BP4 shown in FIG. 40 or bonding pad BP6 shown in FIG. 47) on the target substrate through the first electrode E1' and a portion of the conductive layer CD (i.e., the portion of the conductive layer CD extending on the third surface SR3) located on the same side of the semiconductor die SU as the first electrode E1', respectively. In other words, the semiconductor chip PU may be bonded to the target substrate in a flip chip manner.

In a cross-sectional view of a semiconductor chip PU (as shown in FIG. 51), the semiconductor chip PU has a first side F1 and a second side F2 opposite to the first side F1, wherein the first side F1 is defined as a side where the first semiconductor layer S1' is located within the semiconductor chip PU, while the second side F2 is defined as a side where the second semiconductor layer S2' is located within the semiconductor chip PU. According to this embodiment, the first side F1 of the semiconductor chip PU may have a width W1", wherein the range of width W1" may range from 10 micrometers (µm) to 50 µm (i.e., 10 µm ≤ W1" ≤ 50 µm), but is not limited thereto. The width W1" may be defined as the maximum spacing between the two ends of the first side F1 of the semiconductor chip PU in the cross-sectional view of the semiconductor chip PU. For example, in this embodiment, the width W1" may be the maximum spacing between the two ends of the conductive layer CD located on the first side F1. In some embodiments, the range of the width W1" may range from 15 µm to 45 µm (i.e., 15 µm ≤ W1" ≤ 45 µm). In some embodiments, the range of the width W1" may be from 20 µm to 40 µm (i.e., 20 µm ≤ W1" ≤ 40 µm). According to the present embodiment, the width of the semiconductor dies SU may range from 1 µm to 10 µm.

According to the present embodiment, in a cross-sectional view of the semiconductor chip PU (as illustrated in FIG. 51), the semiconductor chip PU may have a thickness TH1. The thickness TH1 may be defined as the maximum thickness of the semiconductor chip PU in the normal direction thereof. For example, the thickness TH1 may be defined as the maximum spacing in the normal direction of the semiconductor chip PU between the surface of the second electrode E2' opposite to the semiconductor die SU and the surface (or the conductive layer CD) of the first electrode E1' opposite to the semiconductor die SU. In accordance with this embodiment, the range of the thickness TH1 may be from 10 µm to 50 µm (i.e., 10 µm ≤ TH1 ≤ 50 µm), but is not limited thereto. In some embodiments, the range of the thickness TH1 may be from 15 µm to 45 µm (i.e., 15 µm ≤ TH1 ≤ 45 µm). In some embodiments, the range of the thickness TH1 may be from 20 µm to 40 µm (i.e., 20 µm ≤ TH1 ≤ 40 µm).

According to the present embodiment, an angle θ1 may exist between a portion of the conductive layer CD extending on the third surface SR3 and another portion of the conductive layer CD extending on the sidewall SW1. The angle θ1 may also be considered as the angle between the third surface SR3 and the sidewall SW1. In other words, the value of the angle θ1 may be determined by the shape design of the filler material layer FM. Pursuant to this embodiment, the range of the angle Θ1 may be from 90 degrees to 135 degrees (i.e., 90°≤θ1 ≤ 135°), but is not limited thereto. When the angle Θ1 is 90 degrees, the portion of the conductive layer CD extending on the third surface SR3 is perpendicular to another portion of the conductive layer CD extending on the sidewall SW1, or in other words, the third surface SR3 is perpendicular to the sidewall SW1. In some embodiments, the range of the angle θ1 may be from 95 degrees to 130 degrees (i.e., 95° ≤ Θ1 ≤ 130°). In some embodiments, the range of the angle Θ1 may be from 100 degrees to 125 degrees (i.e., 100° ≤ θ1 ≤ 125°). By ensuring that the value of the angle θ1 falls within the aforementioned ranges, the light output effect of the semiconductor chip PU may be improved.

Please refer to FIG. 52, which illustrates a cross-sectional view of an electronic unit of an electronic device according to another embodiment of the present disclosure. One of the main differences between the semiconductor chip PU in this embodiment and the semiconductor chip PU shown in FIG. 51 lies in the positioning of the conductive layer CD. Specifically, as shown in FIG. 52, the conductive layer CD of the semiconductor chip PU in this embodiment may not be disposed on the third surface SR3 of the filler material layer FM, or in other words, may not extend on the third surface SR3. More precisely, the conductive layer CD may extend along the sidewall SW1 of the filler material layer FM and be substantially aligned with the third surface SR3. In this configuration, the semiconductor chip PU may have a vertical embedded chip structure. Specifically, the semiconductor die SU may include a vertical type semiconductor die element embedded within the filler material layer FM. Furthermore, in this embodiment, the first electrode E1' of the semiconductor chip PU may further extend on the third surface SR3 of the filler material layer FM, meaning that the first electrode E1' may simultaneously contact the first surface SR1 of the semiconductor die SU (or the first semiconductor layer S1') and the third surface SR3 of the filler material layer FM. It should be noted that although FIG. 52 depicts that the conductive layer CD is in contact with the second electrode E2', this embodiment is not limited to such a configuration. In some embodiments, the conductive layer CD may not contact the second electrode E2', and the second electrode E2' may be electrically connected to a bonding pad on the target substrate through other traces (not shown).

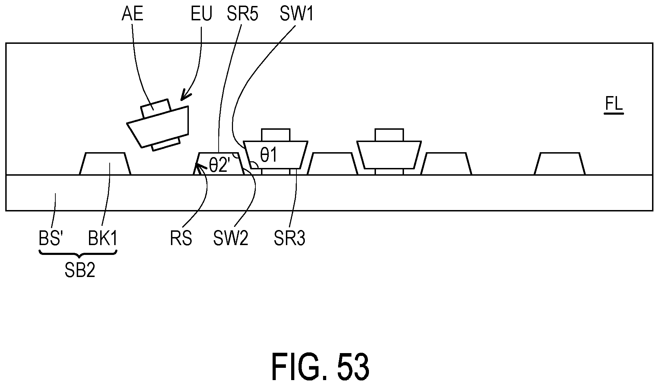

According to this disclosure, after the formation of the semiconductor chip PU through the aforementioned manufacturing method M300, a fluidic transfer process may be employed to transfer the semiconductor chip PU onto a target substrate to form an electronic device. In other words, a packaging process may be performed on the semiconductor die SU prior to the fluidic transfer process. As the semiconductor die SU in this disclosure may include vertical type semiconductor die elements, it is possible to increase the arrangement density of the semiconductor die SU on the substrate (e.g., wafer), thereby improving substrate utilization efficiency. Moreover, by performing a packaging process on the semiconductor die SU before the fluidic transfer process to form the semiconductor chip PU, the bonding element (i.e., the first electrode E1') of the first semiconductor layer S1' and the bonding element (i.e., the portion of the conductive layer CD extending on the third surface SR3) of the second semiconductor layer S2' in the semiconductor die SU may be positioned on the same side of the semiconductor chip PU, facilitating the bonding of the semiconductor chip PU to the target substrate to form an electronic device. The steps of the fluidic transfer process for the semiconductor chip PU will be detailed below. It should be noted that the electronic units EU (including electronic units EUA, EUB, EUC, first electronic unit EU1, second electronic unit EU2) mentioned hereafter may refer to any of the semiconductor chips PU in the above embodiments, and the structure of the electronic unit EU shown in the following figures is merely exemplary, with structural details that can be referenced from FIG. 51, FIG. 53, and the relevant content above.

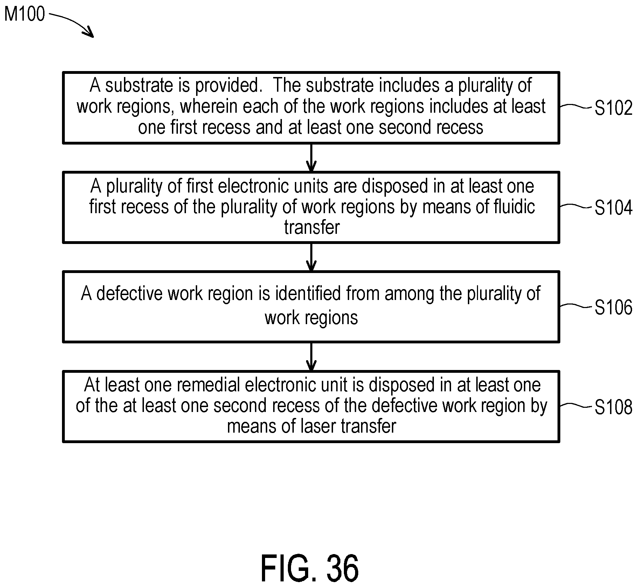

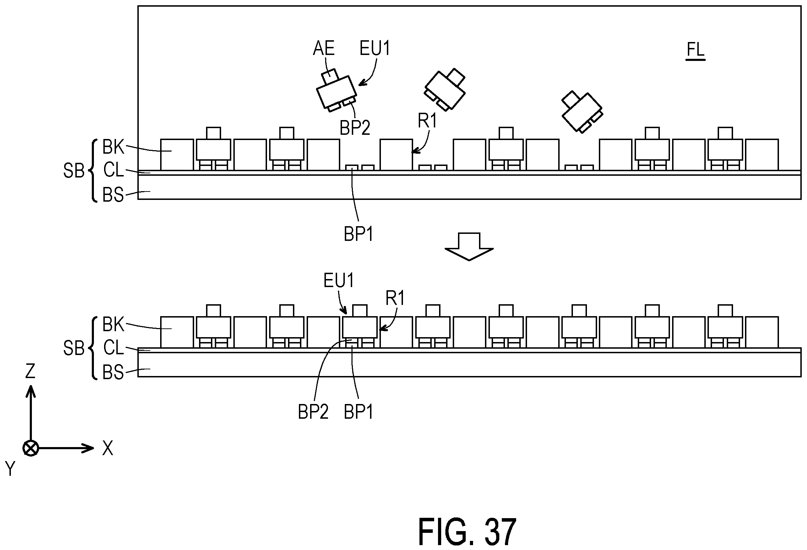

Please refer to FIG. 36 to FIG. 41. FIG. 36 is a flow chart diagram illustrating a method of manufacturing an electronic device according to an embodiment of the present disclosure. FIG. 37 to FIG. 41 depict schematic diagrams of the manufacturing method for the electronic device of this embodiment. Specifically, FIG. 37 to FIG. 41 illustrate the transfer process of the semiconductor chip PU. According to this embodiment, the manufacturing method M100 for the electronic device ED (shown in FIG. 41) may include the following steps.

S102: A substrate is provided. The substrate includes a plurality of work regions, wherein each of the work regions includes at least one first recess and at least one second recess.

S104: A plurality of first electronic units are disposed in at least one first recess of the plurality of work regions by means of fluidic transfer.

S106: A defective work region is identified from among the plurality of work regions.

S108: At least one remedial electronic unit is disposed in at least one of the at least one second recess of the defective work region by means of laser transfer.

The steps of the manufacturing method M100 for the electronic device ED will be elaborated in detail hereinafter.

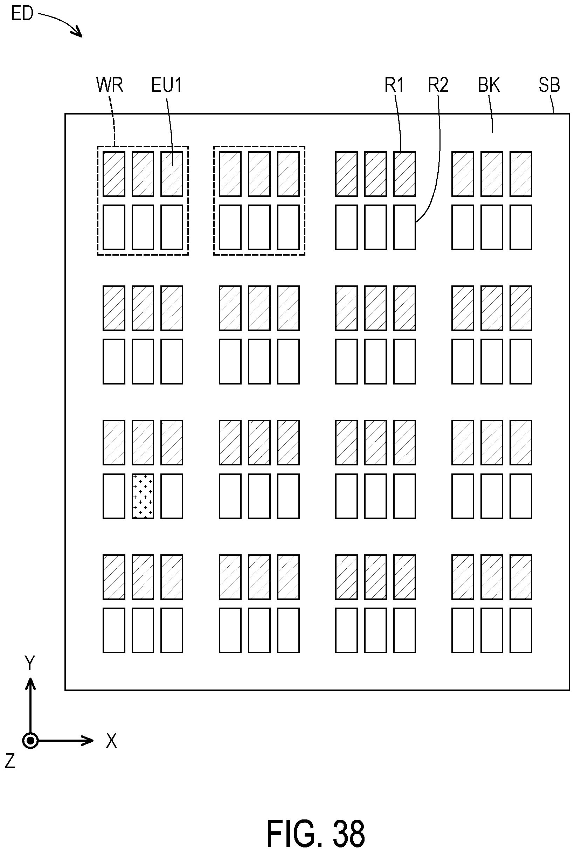

Please refer to FIG. 37 and FIG. 38. FIG. 37 is a schematic view of a fluidic transfer process in an embodiment of this disclosure, and FIG. 38 is a top view of a substrate and electronic units in an embodiment of this disclosure. In this embodiment, the manufacturing method M100 of the electronic device ED includes first performing step S 102 to provide a substrate SB. The substrate SB may include a plurality of work regions WR, and each of the work regions WR may respectively include at least one first recess R1 and at least one second recess R2. As shown in FIG. 37 and FIG. 38, the substrate SB may include the base BS and a circuit layer CL disposed on the base BS. The base BS may include a rigid base or a flexible base. The rigid base may include, but is not limited to, glass, quartz, sapphire, ceramic, other suitable materials, or combinations thereof. The flexible base may include, but is not limited to, polyimide (PI), polycarbonate (PC), polyethylene terephthalate (PET), other suitable materials, or combinations thereof. The circuit layer CL may include various wires, circuits, and electronic units (e.g., active elements and/or passive elements) applicable to the electronic device ED, but is not limited thereto. For example, the circuit layer CL may include a driving unit, which may be electrically connected to subsequently disposed electronic units to drive the electronic units, but is not limited thereto. The circuit layer CL may include thin film transistor (TFT) elements, i.e., including semiconductor layers, gate electrodes, source electrodes, and drain electrodes, among other elements and/or film layers, but is not limited thereto. The semiconductor layer may include silicon or metal oxides, such as low temperature polysilicon (LTPS) semiconductor or amorphous silicon (a-Si) semiconductor, metal oxide semiconductor, which may be, for example, indium gallium zinc oxide (IGZO) semiconductor, but is not limited thereto. It should be noted that the circuit layer CL may include any suitable elements depending on the purpose or type of the electronic device ED and is not limited to the aforementioned. In this embodiment, the substrate SB may be a complementary metal oxide semiconductor (CMOS) substrate or a thin film transistor substrate, but is not limited thereto.

In the present embodiment, the work region WR on the substrate SB may be arranged in a matrix configuration; however, the disclosure is not limited thereto. Each work region WR may include at least one first recess R1 and at least one second recess R2. For example, as illustrated in FIG. 38, each work region WR may include three first recesses R1 and three second recesses R2, wherein the first recess R1 may be arranged in parallel along one direction (e.g., direction X), and the second recess R2 may likewise be arranged in parallel along the same direction. A second recess R2 may be adjacent to a first recess R1, for instance, a second recess R2 may correspond to a first recess R1, but this arrangement is not restrictive. It should be noted that in other embodiments, the number and arrangement of first recesses R1 and second recesses R2 within the work region WR may be adjusted according to the design of the electronic device ED and are not limited to the configuration shown in FIG. 38. Specifically, the substrate SB may further include a barrier structure BK, disposed on the circuit layer CL. The barrier structure BK may be positioned on one side of the circuit layer CL opposite to the base BS. The barrier structure BK may define the first recess R1 and the second recess R2. More precisely, the barrier structure BK may include a plurality of openings, and the plurality of openings may form the first recess R1 and the second recess R2. In other words, the first recess R1 and the second recess R2 may be surrounded by the barrier structure BK. The barrier structure BK may be composed of any suitable insulating materials. According to this embodiment, in subsequent processes, electronic units will be disposed in the work region WR of the substrate SB, for example, the electronic units may be placed within the first recess R1 of the work region WR.

Following the provision of the substrate SB, step S104 may be executed, wherein a plurality of first electronic units EU1 are positioned in at least one first recess R1 of the plurality of work regions WR through a fluidic transfer process. Specifically, a carrier (not shown in the figure) may be provided, wherein the plurality of first electronic units EU1 may be arranged on the carrier. The carrier herein may include a wafer or any other suitable base capable of carrying the first electronic units EU1. Subsequently, the first electronic units EU1 located on the carrier may be transferred to the substrate SB through a fluidic transfer process, ensuring that the first electronic units EU1 are positioned within the first recesses R1 of the work regions WR. As illustrated in the upper portion of FIG. 37, the first electronic units EU1 may be transferred from the carrier to the substrate SB through a fluid FL, entering the first recesses R1, where the first electronic units EU1 may be electrically connected to the circuit layer CL. Specifically, the circuit layer CL may include a plurality of bonding pads BP1 exposed by the first recesses R1. When the first electronic units EU1 enter the first recesses R1, the bonding pads BP2 of the first electronic units EU1 may contact the bonding pads BP1 of the circuit layer CL, thereby electrically connecting the first electronic units EU1 to the circuit layer CL. In this embodiment, the bonding pads BP1 and BP2 may be joined through any suitable process, such as eutectic bonding, conductive film bonding, metal bonding, conductive paste bonding, or other appropriate techniques. Thus, the operation of the first electronic units EU1 may be controlled through the circuit layer CL. It should be noted that the positions of the bonding pads shown in FIG. 37 and subsequent figures are merely exemplary. The positions of the bonding pads (or bonding elements) of the electronic units EU (i.e., semiconductor chips PU) may refer to the structures shown in FIG. 51 and FIG. 52 and the related content above, while the positions of the bonding pads of the circuit layer CL may correspond to the positions of the bonding pads of the electronic units EU. The first electronic units EU1 may include auxiliary elements AE, wherein the auxiliary elements AE may be columnar structures positioned on one side of the first electronic units EU1 opposite to the bonding pads BP2, but are not limited thereto. During the transfer process of the first electronic units EU1, the auxiliary elements AE may assist in orienting the bonding pads BP2 of the first electronic units EU1 downward, or towards the substrate SB, to facilitate contact between the bonding pads BP2 and the bonding pads BP 1. Upon completion of the transfer process for the first electronic units EU1, as shown in the lower portion of FIG. 37 and in FIG. 38, the first electronic units EU1 will be positioned within the first recesses R1 and electrically connected to the circuit layer CL, while the second recesses R2 may remain vacant or unoccupied by the first electronic units EU1. Subsequently, the auxiliary elements AE may be removed.

In the present embodiment, the first electronic unit EU1 may be disposed in the first recess R1 but not in the second recess R2 through a fluidic transfer process. Specifically, such configuration may be achieved by designing the shape or dimensions of the first recess R1 and the second recess R2 to be different, while the shape or dimensions of the first electronic unit EU1 match those of the first recess R1. In some embodiments, although not illustrated, the second recess R2 may have the same shape as the first recess R1, while the dimension of the first recess R1 may be larger than that of the second recess R2. The "dimension of the first recess R1 and the second recess R2" herein may refer to the areas of the first recess R1 and the second recess R2 in the top view direction of the substrate SB (e.g., parallel to direction Z) or the volume of the first recess R1 and the second recess R2, but are not limited thereto. The subsequent references to "dimension" may be interpreted in accordance with the above definition and will not be further elaborated. Furthermore, the dimension of the first electronic unit EU1 may be smaller than or equal to that of the first recess R1 but larger than that of the second recess R2. Consequently, the first electronic unit EU1 may not be disposed in the second recess R2. In some embodiments, although not illustrated, the first recess R1 and the second recess R2 may have different shapes, wherein the shape of the first electronic unit EU1 may match that of the first recess R1 but not that of the second recess R2, thereby enabling the first electronic unit EU1 to be disposed in the first recess R1 but not in the second recess R2. For example, in the top view direction of the substrate SB, the first recess R1 and the first electronic unit EU1 may have a circular contour, while the second recess R2 may have a rectangular contour, but are not limited thereto. It should be noted that the aforementioned shape or dimension of the first electronic unit EU1 may be determined by the design of the shape or dimension of the filler material layer FM of the semiconductor chip PU.

In some embodiments, the electronic device ED may include a sensing device. In such instances, the first electronic unit EU1 (alternatively referred to as the semiconductor die SU) may incorporate any suitable sensing unit, such as, but not limited to, a photodiode. In some embodiments, the electronic device ED may include a display device. In this scenario, the first electronic unit EU1 (alternatively referred to as the semiconductor die SU) may be a semiconductor unit, which may include, but is not limited to, light-emitting diodes. The light-emitting diodes may encompass, for example, organic light-emitting diodes (OLEDs), quantum light-emitting diodes (QLEDs), inorganic light-emitting diodes (LEDs), any other suitable light-emitting elements, or a combination thereof. The inorganic light-emitting diodes may include, but are not limited to, mini LEDs or micro LEDs. In some embodiments, the chip size of the light-emitting diodes may range from approximately 300 micrometers (µm) to 10 millimeters (mm), the chip size of mini LEDs may range from approximately 100 micrometers to 300 micrometers, and the chip size of micro LEDs may range from approximately 1 micrometer to 100 micrometers , without limitation. In some embodiments, the electronic device ED may include a self-luminous display device. In such instances, the electronic device ED may include a display medium layer, wherein the display medium layer may include light-emitting diodes, without limitation. In other embodiments, the electronic device ED may include a non-self-luminous display device. In this case, the electronic device ED may include a display medium layer, wherein the display medium layer may include liquid crystals, without limitation. The following description will elucidate some examples of the transfer process for the first electronic unit EU1 in the present embodiment, using the electronic device ED as a display device for illustrative purposes.

In some embodiments, the first electronic unit EU1 may include semiconductor units emitting light of the same color or wavelength, such as blue semiconductor units, but is not limited thereto. In this scenario, these first electronic units EU1 may be transferred onto the substrate SB and positioned within the first recess R1 through a fluidic transfer process, thereby forming the structure illustrated in FIG. 38. Subsequently, a light conversion layer may be disposed on the substrate SB to convert the color or wavelength of the light emitted by the first electronic unit EU1. For instance, the first electronic unit EU1 may be an optical unit capable of emitting blue light, and through the application of the light conversion layer, a portion of the light emitted by the first electronic unit EU1 may be converted to green or red light, but is not limited thereto. The light conversion layer may be disposed corresponding to the first electronic unit EU1, or more specifically, corresponding to the first recess R1 and/or the second recess R2. In some embodiments, following the disposition of the light conversion layer, each work region WR may encompass three first recesses R1, where one of these three first recesses R1 corresponds to a light conversion layer that converts light to a red wavelength, another corresponds to a light conversion layer that converts light to a green wavelength, while the third may not correspond to any light conversion layer, thereby enabling the first electronic units EU1 in these three first recesses R1 to emit red, green, and blue light respectively, which may be combined to produce white light. In this context, one work region WR may be considered as one pixel, with the three first recesses R1 within this work region WR potentially being regarded as sub-pixels, but is not limited thereto. It should be noted that the aforementioned disposition method and types of light conversion layers are merely exemplary, and the present disclosure is not limited to these examples.

In some embodiments, the first electronic unit EU1 may include semiconductor units capable of emitting light of different colors or wavelengths. For instance, the first electronic unit EU1 may include blue, green, and red semiconductor units, which may collectively be considered as one pixel, without limitation. In some embodiments, each work region WR may contain three first recesses R1, wherein blue, green, and red semiconductor units may be disposed respectively. In this scenario, blue, green, and red semiconductor units may be transferred to the first recesses R1 of the substrate SB through three separate fluidic transfer processes. In some embodiments, the three first recesses R1 in each work region WR may possess first, second, and third dimensions respectively, where the first dimension may be greater than the second dimension, and the second dimension may be greater than the third dimension. During the transfer process of the first electronic unit EU1, the largest semiconductor unit among the blue, green, and red semiconductor units may be transferred first. The dimension of this semiconductor unit may be less than or equal to the first dimension and greater than the second and third dimensions, enabling such semiconductor unit to enter the first recess R1 with the first dimension but not the first recesses R1 with the second and third dimensions. Subsequently, the second largest semiconductor unit among the blue, green, and red semiconductor units may be transferred. The dimension of this semiconductor unit may be less than or equal to the second dimension and greater than the third dimension, allowing such semiconductor unit to enter the first recess R1 with the second dimension but not the first recess R1 with the third dimension. Finally, the smallest semiconductor unit among the blue, green, and red semiconductor units may be transferred. The dimension of this semiconductor unit may be less than or equal to the third dimension, enabling such semiconductor unit to enter the first recess R1 with the third dimension. Through this design, blue, green, and red semiconductor units may be disposed in the first recesses R1 through multiple fluidic transfer processes, with each of the three first recesses R1 in each work region WR containing blue, green, and red semiconductor units respectively. It should be noted that the design of the first recesses R1 is not limited to the aforementioned configuration. In some embodiments, the three first recesses R1 in each work region WR may have different shapes, while the blue, green, and red semiconductor units may respectively have shapes matching one, another, and yet another of these three first recesses R1, allowing semiconductor units of different colors to be disposed in the first recesses R1 corresponding to their shapes. It should be noted that the aforementioned fluidic transfer process for the first electronic unit EU1 may be applied to any suitable embodiment where the first electronic unit EU1 includes different types of electronic elements.

It should be noted that, according to the design or intended use of the electronic device ED, the work region WR may include any number of first recesses R1 and second recesses R2, and the first recesses R1 and second recesses R2 may be arranged in any suitable manner.

Following the transfer of the first electronic unit EU1 to the first recess R1 through a fluidic transfer process, step S106 may be conducted to identify defective work regions from multiple work regions. Specifically, a detection step may be performed on the first electronic unit EU1 in the first recess R1 to identify defective first electronic units or first recesses R1 lacking a first electronic unit EU1. A work region WR may be defined as a defective work region when a first recess R1 within the work region contains a defective first electronic unit or lacks a first electronic unit EU1. In other words, at least one first recess R1 in a defective work region either lacks any first electronic unit or contains a defective first electronic unit. The detection step for the first electronic unit EU1 may be conducted through any suitable means, such as optical inspection via photoluminescence or electroluminescence, but is not limited thereto. FIG. 41 illustrates a top view of the substrate and electronic units after the remedial process in the first embodiment of this disclosure. For instance, as shown in FIG. 41, following the detection step of the first electronic unit EU1, four defective first electronic units DEU1 may be identified, and the work regions WR containing these four defective first electronic units DEU1 are identified and defined as defective work regions DWR. Although not illustrated in FIG. 41, in some embodiments, a work region WR is also considered a defective work region DWR if at least one of the first recesses R1 thereof is vacant.

Following the identification of the defective work region DWR, step S108 may be executed, wherein at least one remedial electronic unit is positioned in at least one of the second recesses within the defective work region using laser transfer technology. Specifically, as illustrated in FIG. 41, subsequent to the identification of the defective work region DWR, the remedial electronic unit REU may be transferred to at least one second recess R2 within the defective work regions DWR via laser transfer process. In this embodiment, each second recess R2 within a work region (WR) may be situated adjacent to a first recess R1, though this configuration is not limiting. In such instances, when positioning the remedial electronic unit REU, the remedial electronic unit REU may be placed in the second recess R2 adjacent to the first recess R1 containing the defective first electronic unit DEU1, though this arrangement is not mandatory. For example, as depicted in FIG. 41, within a defective work region DWR, when the defective first electronic unit DEU1 is situated in the central first recess R1, the remedial electronic unit REU may be positioned in the central second recess R2 of that defective work region DWR. In some embodiments, the remedial electronic unit REU may be placed in a second recess R2 adjacent to a first recess R1 that does not contain a first electronic unit EU1. In some embodiments, when a defective work region DWR encompasses a plurality of first recesses R1 containing defective first electronic unit DEU1, remedial electronic units REU may be positioned in the respective second recesses R2 adjacent to these first recesses R1. It should be noted that the aforementioned descriptions regarding the positioning of remedial electronic units REU are exemplary and not limiting to the disclosure. Optionally, when a defective first electronic unit DEU1 is positioned in a first recess R1, the electrical connection pathway between the defective first electronic unit DEU1 and the driving unit may be cut off either before or after step S108. The method of cutting off the electrical connection pathway may include laser cutting or other suitable techniques, which are not limited by this disclosure. In some embodiments, the remedial electronic unit REU may include a semiconductor chip PU, meaning that the semiconductor die SU may undergo packaging processes prior to the remedial process. In some embodiments, the remedial electronic unit REU may include a semiconductor die SU, indicating that packaging processes for the semiconductor die SU may not be necessary prior to the remedial process.

The following shall set forth multiple variant embodiments of the present implementation for transferring and remedial electronic units through laser transfer methodology.

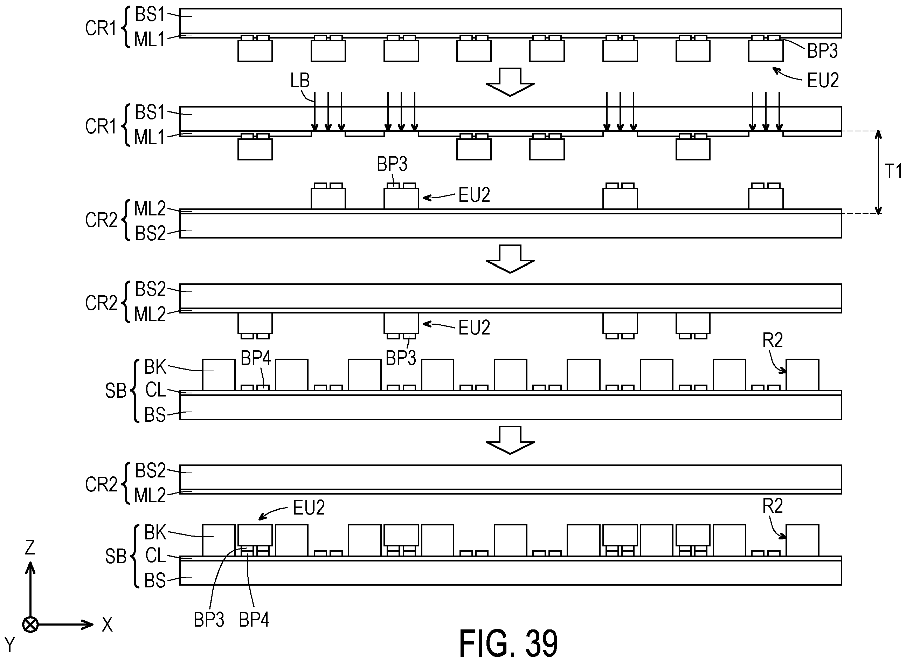

Please refer to FIG. 39, which illustrates a schematic view of setting up a remedial electronic unit according to an embodiment of this disclosure. In some embodiments, the step of setting the remedial electronic unit REU in at least one second recess R2 of the defective work region by laser transfer may first include providing a first carrier CR1. The first carrier CR1 may include a plurality of second electronic units EU2. Specifically, the first carrier CR1 may include a base BS1 and a first material layer ML 1 disposed on the base BS1, wherein the second electronic unit EU2 may be attached to the base BS1 through the first material layer ML1. In this embodiment, the second electronic unit EU2 may be disposed on the first carrier CR1 with bonding pads BP3 thereof facing towards the first material layer ML1. The material of the base BS1 may refer to the aforementioned materials of the base BS, but is not limited thereto. The first material layer ML1 may include any suitable material that may react with laser beam, such as organic materials that may react with laser beam, but is not limited thereto. The aforementioned "first material layer ML1 may react with laser beam" may include scenarios where the first material layer ML1, upon laser irradiation, undergoes vaporization, delamination from the base BS1, disappearance, or gas generation, but is not limited thereto.

Subsequently, a laser beam LB may be directed to irradiate at least one of a plurality of second electronic units EU2, facilitating the transfer of the second electronic units EU2 from the first carrier CR1 to the second carrier CR2. The second carrier CR2 may include a base BS2 and a second material layer ML2 disposed on the base BS2. The material of the base BS2 may reference, but is not limited to, the material of the base BS mentioned above. The second material layer ML2 may include any suitable material exhibiting temporary adhesion to the second electronic unit EU2. For instance, the second material layer ML2 may include silicone, acrylic, resin, photo resin, or other appropriate materials. Specifically, the first carrier CR1 may be positioned above the second carrier CR2, with the first material layer ML1 of the first carrier CR1 facing the second material layer ML2 of the second carrier CR2. Subsequently, the laser beam LB may irradiate a portion of the second electronic unit EU2, whereupon the corresponding portion of the first material layer ML1 may react with the laser beam LB, resulting in its disappearance, vaporization, or gas generation. This process enables the detachment of the irradiated portion of the second electronic unit EU2 from the first carrier CR1, allowing the second electronic unit EU2 to fall onto the second carrier CR2. Consequently, the second electronic unit EU2 may adhere to the base BS2 through the second material layer ML2, effectively transferring to the second carrier CR2. In this configuration, the bonding pad BP3 of the second electronic unit EU2 faces upward, or in other words, the bonding pad BP3 may be far away from the second material layer ML2. In the present embodiment, during the transfer of the second electronic unit EU2 from the first carrier CR1 to the second carrier CR2, a distance T1 may be maintained between the base BS1 of the first carrier CR1 and the base BS2 of the second carrier CR2. According to this embodiment, the range of the distance T1 may span from 1 micrometer (µm) to 200 micrometers, though this range is not restrictive. By maintaining the distance T1 within the aforementioned range, the potential for damage to the second electronic unit EU2 during the process may be mitigated.

After transferring a portion of the second electronic units EU2 to the second carrier CR2, the portion of the second electronic units EU2 may be transferred from the second carrier CR2 to at least one second recess R2 in the defective work region DWR of the substrate SB. Specifically, the second carrier CR2 may be positioned on the substrate SB, wherein the second electronic units EU2 on the second carrier CR2 may correspond to the second recesses R2 where remedial electronic units REU are intended to be placed. The second carrier CR2 may be placed with the second material layer ML2 facing the substrate SB, such that the bonding pads BP3 of the second electronic units EU2 face the second recesses R2. Subsequently, the second carrier CR2 may be moved towards the substrate SB, thereby causing the bonding pads BP3 of the second electronic units EU2 to contact the bonding pads BP4 of the circuit layer CL on the substrate SB, thus electrically connecting the second electronic units EU2 to the circuit layer CL. The bonding pads BP4 in the circuit layer CL may correspond to and be exposed by the second recesses R2. In this embodiment, the bonding pads BP3 and the bonding pads BP4 may be bonded to each other through any suitable process, such as eutectic bonding, conductive film bonding, metal-metal bonding, conductive paste bonding, or other appropriate processes. After bonding the bonding pads BP3 and the bonding pads BP4, the second carrier CR2 may be removed, and the second electronic units EU2 transferred to the second recesses R2 may serve as remedial electronic units REU. Thus, the process of transferring remedial electronic units REU may be completed.

In the present embodiment, when transferring the second electronic units EU2 from the first carrier CR1 to the second carrier CR2, the irradiation position of the laser beam LB on the first carrier CR1, or more specifically, the second electronic units EU2 irradiated by the laser beam LB, may be determined based on the position of the first recess R1 containing the defective first electronic unit DEU1 or the first recess R1 without the first electronic unit EU1. More precisely, the position of the first recess R1 in the defective work region DWR , which contains the defective first electronic unit DEU1 or is vacant, may be initially identified, thereby determining the position of the second recess R2 where the remedial electronic unit REU is to be placed. Subsequently, the portion of the second electronic units EU2 to be irradiated by the laser beam LB may be determined based on the positions of these second recesses R2. Through this design, the second electronic units EU2 on the second carrier CR2 may correspond to the position of the second recess R2 where the remedial electronic unit REU is to be placed, thus enabling the completion of the transfer process for the remedial electronic unit REU in a single operation.

Please refer to FIG. 40, which is a schematic view of a remedial electronic unit according to a variation of an embodiment of the present disclosure. In some embodiments, the step of arranging the remedial electronic unit REU in at least one second recess R2 in the defective work region by laser transfer may first include providing a carrier CR3, wherein the carrier CR3 may include a plurality of second electronic units EU2. The carrier CR3 may include a base BS3 and a third material layer ML3 disposed on the base BS3, wherein the second electronic units EU2 may be attached to the base BS3 through the third material layer ML3. In this embodiment, the second electronic units EU2 may be disposed on the carrier CR3 in such a manner that the bonding pads BP3 thereof are away from the third material layer ML3. The material of the base BS3 may refer to the material of the base BS mentioned above, but is not limited thereto. The third material layer ML3 may include any suitable material that can react with laser beam. The material of the third material layer ML3 may, for example, refer to the material of the above-mentioned first material layer ML1, but is not limited thereto.

Then, a portion of the second electronic units EU2 may be irradiated with the laser beam LB, so that the portion of the second electronic units EU2 is transferred from the carrier CR3 to at least one of the second recesses R2 of the defective work region DWR of the substrate SB. Specifically, the carrier CR3 may be positioned on the substrate SB, wherein the third material layer ML3 of the carrier CR3 may face the substrate SB, so that the bonding pads BP3 of the second electronic units EU2 may face the second recesses R2. Next, a portion of the second electronic units EU2 corresponding to the second recesses R2 where the remedial electronic unit REU is expected to be disposed may be irradiated with the laser beam LB, wherein a portion of the third material layer ML3 of the second electronic units EU2 corresponding to this part may react with the laser beam LB to disappear, vaporize or generate gas, so that the portion of the second electronic units EU2 may be detached from the carrier CR3 and fall into the second recesses R2 where the remedial electronic unit REU is expected to be disposed, and the bonding pads BP3 of the second electronic units EU2 may be in contact with the bonding pads BP4, thereby electrically connecting the second electronic units EU2 to the circuit layer CL. In this embodiment, the bonding pads BP3 and the bonding pads BP4 may be bonded to each other through any suitable process, such as eutectic bonding, conductive film bonding, metal bonding, conductive film bonding, etc. conductive paste bonding or other suitable processes. The second electronic units EU2 transferred into the second recesses R2 may serve as remedial electronic units REU. In this way, the process of transferring the remedial electronic unit REU may be completed. According to this embodiment, the positions of the second recesses R2 where the remedial electronic unit REU is expected to be disposed may be first confirmed, and then a portion of the second electronic units EU2 irradiated by the laser beam LB or the irradiation position of the laser beam LB on the carrier CR3 may be determined based on the positions of the second recesses R2.

According to this embodiment, the manufacturing method of the electronic device ED may first include transferring the first electronic unit to the substrate SB through a fluidic transfer process. In this way, the distribution randomness of the first electronic units may be improved or the wastage of the first electronic units may be reduced. For example, in some embodiments, when the electronic device ED includes a display device, using a fluidic transfer process to transfer the first electronic unit EU1 may reduce uneven brightness distribution of the electronic device ED. In addition, using a fluidic transfer process may improve the proportion of the transferred first electronic unit EU1, thereby reducing production costs. In addition, after transferring the first electronic unit EU1, the manufacturing method of the electronic device ED of this embodiment may further include transferring the remedial electronic unit through a laser transfer process. Through the above process, the yield of the electronic device ED may be improved.

After performing the above steps, the electronic device ED may be formed. In other words, the electronic device ED of this embodiment may be formed by sequentially performing the manufacturing method M300 and the manufacturing method M100. It should be noted that the elements and/or film layers included in the electronic device ED are not limited to the above, and may include other suitable elements and/or film layers according to the type of the electronic device ED. In addition, other steps may be inserted between any steps in the manufacturing method M100 of this embodiment as required. Furthermore, any steps in the manufacturing method M100 may be adjusted in order or deleted according to requirements.

A method for manufacturing an electronic device according to another embodiment of the present disclosure will be described in detail below.

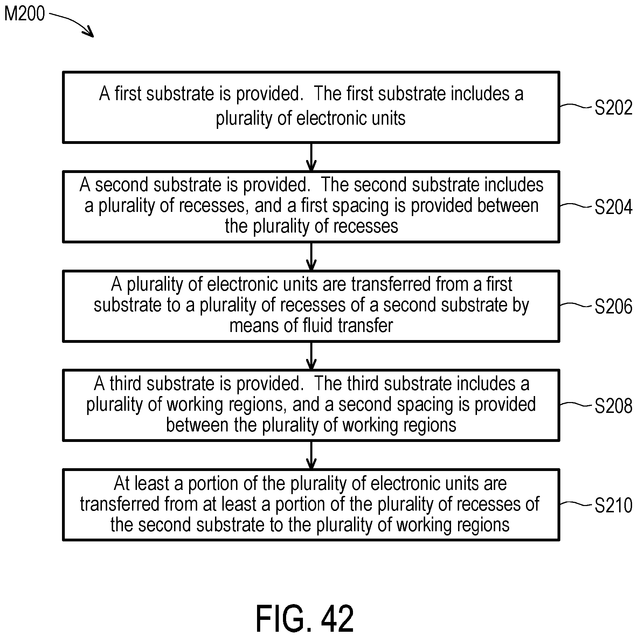

Please refer to FIG. 42 and FIG. 44 to FIG. 48. FIG. 42 is a schematic flowchart of a manufacturing method of an electronic device according to another embodiment of the present disclosure, and FIG. 44 to FIG. 48 illustrate the steps of a manufacturing method of an electronic device according to this embodiment. Specifically, FIG. 44 to FIG. 48 illustrate the transfer process of the semiconductor chip PU. According to this embodiment, the manufacturing method M200 of the electronic device ED may include the following steps.

S202: A first substrate is provided, wherein the first substrate includes a plurality of electronic units.

S204: A second substrate is provided, wherein the second substrate includes a plurality of recesses, and there is a first spacing between the plurality of recesses.

S206: A plurality of electronic units are transferred from the first substrate to the plurality of recesses of the second substrate in a fluidic transfer manner.

S208: A third substrate is provided, wherein the third substrate includes a plurality of work regions, and there is a second spacing between the plurality of work regions.

S210: At least a portion of the plurality of electronic units are transferred from at least a portion of the plurality of recesses of the second substrate to a plurality of work regions.

Each step of the manufacturing method M200 of the electronic device ED will be described in detail below.

Please refer to FIG. 44, which is a schematic view of a fluidic transfer process according to another embodiment of the present disclosure. In this embodiment, the manufacturing method M200 of the electronic device ED may first include step S202 of providing a first substrate SB1, where the first substrate SB1 includes a plurality of electronic units EU. The first substrate SB1 may include any suitable base that may carry the electronic unit EU, and the electronic unit EU may be disposed on the first substrate SB1. The electronic unit EU may be formed on the first substrate SB1, but is not limited thereto. The first substrate SB1 may have any suitable shape. In this embodiment, the first substrate SB1 may be circular, but is not limited thereto. For example, the first substrate SB1 in this embodiment may include a wafer, but is not limited thereto. In some embodiments, the first substrate SB1 may be, for example, a carrier CR' shown in FIG. 50, on which a plurality of electronic units EU (i.e., semiconductor chips PU) are disposed.

Next, step S204 may be performed to provide a second substrate SB2, wherein the second substrate SB2 includes a plurality of recess RS. The structural features of the second substrate SB2 may refer to the above-mentioned substrate SB, but are not limited thereto. For example, the second substrate SB2 may include a base BS' and a barrier structure BK1 disposed on the base BS', wherein the base BS' may include a base and a circuit layer. In some embodiments, the base BS' may include a base but not a circuit layer. The barrier structure BK1 may define the recess RS, that is, the recess RS may be surrounded by the barrier structure BK1. The second base SB2 may have any suitable shape. In this embodiment, the second base SB2 may be rectangular, but is not limited thereto.

It should be noted that the above steps S202 and S204 may be performed in any order or simultaneously.

Next, step S206 may be performed to transfer the plurality of electronic units EU from the first substrate SB1 to the plurality of recess RS of the second substrate SB2 in a fluidic transfer manner. Specifically, the electronic unit EU on the first substrate SB1 may be transferred to the second substrate SB2 through the fluid FL, wherein the electronic unit EU may enter a plurality of recesses RS of the second substrate SB2, so that the electronic unit EU is disposed in the recess RS. In this embodiment, the electronic unit EU may fully fill the recess RS of the second substrate SB2, but is not limited to this. In this embodiment, the electronic unit EU may be transferred from a substrate having one shape to a substrate having another shape, for example, may be transferred from a circular substrate (first substrate SB1) to a rectangular substrate (second substrate SB2), but not limited thereto. The electronic unit EU may include an auxiliary element AE, wherein the auxiliary element AE may assist in making the bonding pad BPS of the electronic unit EU face downward, or toward the second substrate SB2, during the transfer process of the electronic unit EU. After completing the transfer process of the electronic unit EU, the auxiliary element AE may be removed, as shown in FIG. 44.

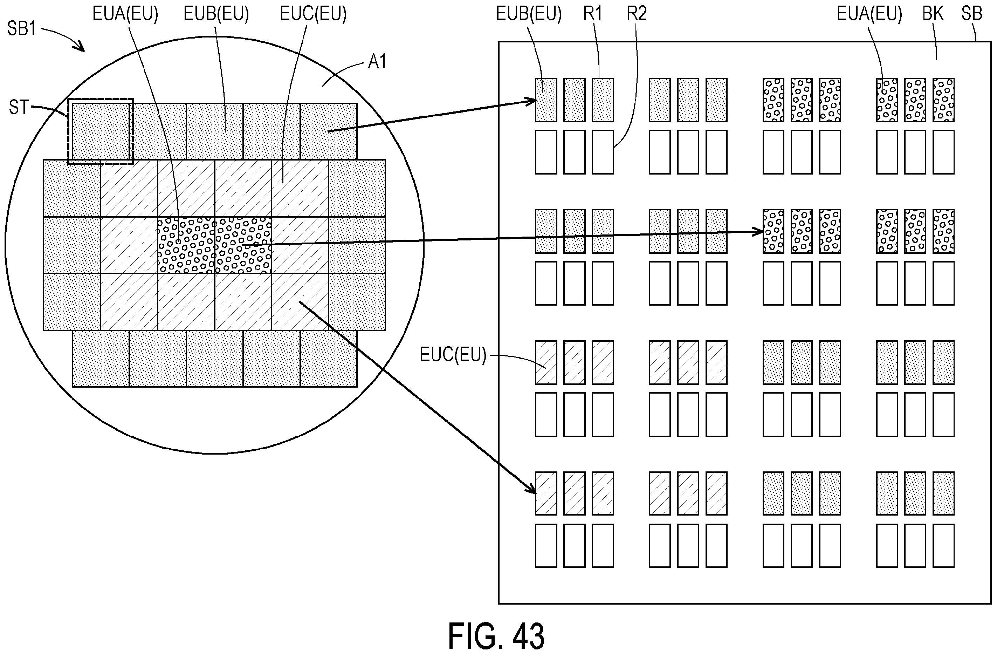

Please refer to FIG. 43, which shows a schematic view of transferring an electronic unit from a first substrate using a stamp transfer method. Specifically, if the stamp transfer method is used to transfer the electronic unit EU on the first substrate SB1, due to the shape restrictions of the stamp tool, a portion of the electronic unit EU on the first substrate SB1 may not be able to be transferred by the stamp transfer method. Consequently, a portion of the electronic unit EU may be wasted, thereby increasing production costs. For example, FIG. 43 shows a situation in which the electronic unit EU is transferred using a stamp transfer method, in which the stamp tool may pick up the electronic unit EU in one region ST at a time, and complete the transfer process of the electronic unit EU through multiple pickups. After the electronic unit EU is picked up by the stamp tool, the electronic unit EU may be transferred to the first recess R1 of the substrate SB. The details may be referred to the above, so they will not be described again. However, in this case, a portion of the electronic unit EU on the first substrate SB1 cannot be picked up by the stamp tool. For example, the electronic unit EU in the region A1 in FIG. 43 cannot be transferred by the stamp transfer process. As such, the electronic unit EU in the region A1 may be wasted, resulting in an increase in the production cost of the electronic device ED.

Furthermore, in some embodiments, the electronic units EU disposed on different regions of the first substrate SB1 may be the same type of electronic units EU, but their specific characteristics may have differences. The above-mentioned characteristic differences may be caused by, for example, the process of the electronic unit EU, but are not limited thereto. Specifically, the electronic unit EU may include an electronic unit EUA, an electronic unit EUB and an electronic unit EUC, which are arranged in different regions on the first substrate SB1, wherein the electronic unit EUA, the electronic unit EUB and the electronic unit EUC may be the same type of electronic unit, but may differ in their specific characteristics. For example, in some embodiments, the electronic unit EU may include a semiconductor unit, and the electronic unit EUA, the electronic unit EUB, and the electronic unit EUC may be semiconductor units of the same color, but the wavelengths of light emitted by the electronic unit EUA, the electronic unit EUB, and the electronic unit EUC may be different. In this case, using the stamp transfer method to transfer the electronic unit EU may result in insufficient randomness in the distribution of the electronic unit EUA, the electronic unit EUB and the electronic unit EUC with different specific characteristics, thereby affecting the performance of the electronic device ED. For example, as shown in FIG. 43, after the electronic units EU are transferred to the substrate SB using the stamp transfer method, the electronic unit EUA, the electronic unit EUB, and the electronic unit EUC are not randomly arranged on the substrate SB. In this case, when the electronic device ED includes a display device, the electronic device ED may have uneven brightness distribution, thereby affecting the display effect of the electronic device ED.

Refer back to FIG. 44. On the other hand, according to the present embodiment, since the electronic unit EU on the first substrate SB1 may be transferred to the second substrate SB2 through the fluidic transfer process, the electronic unit EU may be moved into the recess RS substantially through the fluid FL. In this way, the waste of the electronic unit EU may be reduced. In other words, in this embodiment, the electronic unit EU on a substrate with any shape may be transferred to another substrate, and at the same time, the waste of the electronic unit EU may be reduced. In addition, after the electronic unit EU is transferred into the recess RS by the fluid FL, the electronic units EU on different regions of the first substrate SB1 (for example, the above-mentioned electronic unit EUA, electronic unit EUB and electronic unit EUC) may be randomly placed on the second substrate SB2, or may be randomly arranged in the recess RS. In this way, when the electronic unit EU is subsequently transferred to the third substrate SB3, the electronic unit EUA, the electronic unit EUB and the electronic unit EUC may be randomly distributed on the third substrate SB3 (as shown in FIG. 48), thereby reducing the impact of the difference in characteristics of the electronic unit EUA, the electronic unit EUB and the electronic unit EUC on the performance of the electronic device ED. For example, when the electronic device ED includes a display device, the above design may improve the brightness uniformity of the electronic device ED.

Please refer to FIG. 53, which illustrates a schematic view of a fluidic transfer process for another modified embodiment of the present disclosure. In this modified embodiment, the shape of the barrier structure BK1 may be determined based on the shape of the electronic unit EU. Specifically, as mentioned above, the electronic unit EU may include a semiconductor chip PU, wherein an angle Θ1 may exist between the third surface SR3 of the filler material layer FM (not shown in the figure) of the semiconductor chip PU and the sidewall SW1. In this case, the barrier structure BK1 may have a surface SR5 facing away from the second substrate SB2 and a sidewall SW2. In the cross-sectional view of the barrier structure BK1, an angle θ2' may exist between the surface SR5 and the sidewall SW2 of the barrier structure BK1, wherein the angle θ2' may be substantially similar to the angle θ1, but is not limited thereto. The range of the angle θ2' may refer to the aforementioned range of the angle θ1. Through the aforementioned shape design of the barrier structure BK1, the possibility of the electronic unit EU flipping during the transfer process may be reduced, thereby improving the process yield.

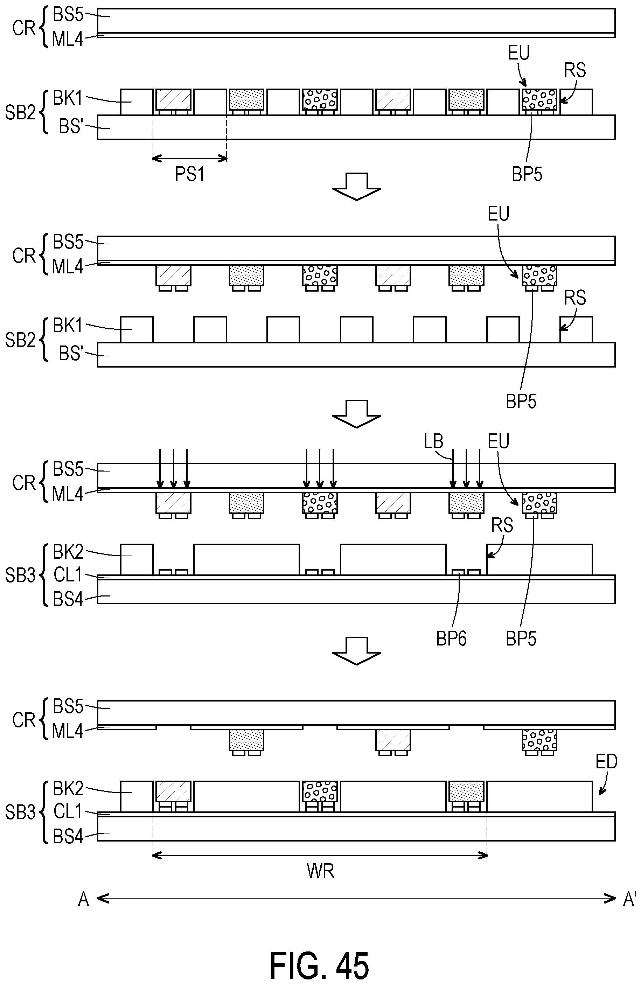

After moving the electronic unit EU into the recess RS of the second substrate SB2, proceed to step S208, which involves providing a third substrate SB3. The third substrate SB3 includes a plurality of work regions WR. The structural characteristics of the third substrate SB3 may be referenced from the aforementioned substrate SB structure description. For example, as illustrated in FIG. 45 to FIG. 47, the third substrate SB3 may include a base BS4, a circuit layer CL1 disposed on the base BS4, and a barrier structure BK2 positioned on the circuit layer CL1. The barrier structure BK2 may define at least one first recess R1 and at least one second recess R2, as shown in FIG. 48. The structural features of the base BS4, the circuit layer CL1, and the barrier structure BK2 may be respectively referenced from the previously described base BS, the circuit layer CL, and the barrier structure BK. As depicted in FIG. 48, the third substrate SB3 may include a plurality of work regions WR, which may be arranged in a matrix pattern, but are not limited to this configuration. Each work region WR of the third substrate SB3 may include at least one first recess R1 and at least one second recess R2, but is not limited to this arrangement.

Subsequently, step S210 may be performed, wherein a portion of the plurality of electronic units EU is transferred from a portion of the plurality of recesses RS of the second substrate SB2 to the plurality of work regions WR. Specifically, a portion of the electronic units EU in the recesses RS of the second substrate SB2 may be transferred to the first recess R1 within the work region WR of the third substrate SB3, such that the electronic units EU are positioned within the first recess R1. The following will detail several variant embodiments of the method for transferring the electronic units EU from the second substrate SB2 to the third substrate SB3 in this embodiment.

Please refer to FIG. 45, which illustrates a schematic view of transfer of electronic units from the second substrate to the third substrate according to another embodiment of the present disclosure. In some embodiments, the method of transferring electronic units EU from the second substrate SB2 to the third substrate SB3 may initially include providing a carrier CR. The carrier CR may include a base BS5 and a fourth material layer ML4 disposed on the base BS5. The material of the base BS5 may be similar to the aforementioned materials of the base BS, but is not limited thereto. The fourth material layer ML4 may include any suitable material capable of reacting with laser beam. The material of the fourth material layer ML4 may, for example, be similar to the aforementioned materials of the first material layer ML1, but is not limited thereto.

Subsequently, the plurality of electronic units EU may be transferred from the recess RS to the carrier CR. Specifically, the carrier CR may be moved towards the second substrate SB2, allowing the fourth material layer ML4 of the carrier CR to come into contact with the electronic units EU situated in the recess RS (for example, contacting the surface SR of the electronic units EU opposite to the bonding pads BPS). Consequently, the electronic units EU may adhere to the base BS5 through the fourth material layer ML4, thereby effectuating the transfer of the electronic units EU from the recess RS to the carrier CR. In this configuration, the bonding pads BP5 of the electronic units EU may be positioned on a side opposite to the fourth material layer ML4.

Subsequently, the laser beam LB may irradiate a portion of the plurality of electronic units EU, causing the portion of the electronic units to transfer from the carrier CR to the third substrate SB3, or more specifically, to the work region WR of the third substrate SB3. Specifically, the laser beam LB may irradiate a portion of the electronic units EU, wherein the corresponding portion of the fourth material layer ML4 of the electronic units EU may react with the laser beam LB, resulting in its disappearance, vaporization, or gas generation, thereby enabling the detachment of the portion of the electronic units EU from the carrier CR. In this embodiment, the portion of electronic units EU irradiated by the laser beam LB may correspond to the recess (specifically, the first recess R1) of the third substrate SB3. This allows the detached portion of electronic units EU to enter the first recess R1 of the third substrate SB3, thereby positioning them within the first recess R1 in the work region WR of the third substrate SB3. In this configuration, the bonding pad BP5 of the electronic unit EU facing the third substrate SB3 may contact the bonding pad BP6 exposed by the first recess R1 in the circuit layer CL1 of the third substrate SB3, thus electrically connecting the electronic unit EU to the circuit layer CL1. Upon transferring the electronic units EU to the third substrate SB3, an electronic device ED is formed. It should be noted that the electronic device ED may include other suitable elements and/or film layers, and is not limited to the configuration shown in FIG. 45.

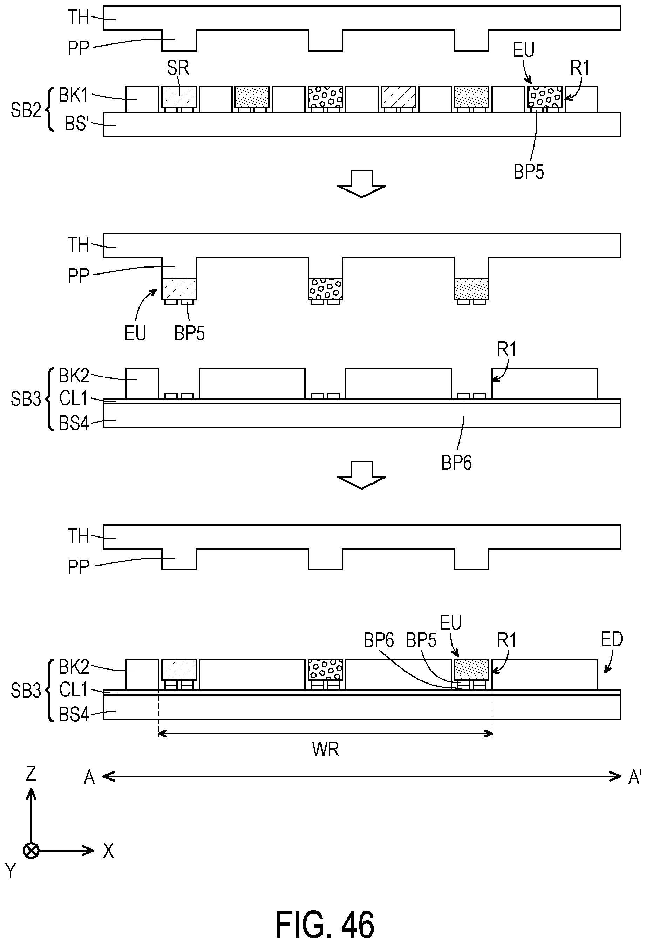

Please refer to FIG. 46, which illustrates a schematic view of transferring electronic units from a second substrate to a third substrate in another variation of an embodiment of the present disclosure. In some embodiments, the method of transferring electronic units EU from the second substrate SB2 to the third substrate SB3 may initially include picking up a portion of the electronic units EU from a portion of the recess RS. For example, a transfer head TH may be utilized to pick up a portion of the electronic units EU from a portion of the recess RS of the second substrate SB2. Specifically, the transfer head TH may include a plurality of protruding structures PP, wherein the protruding structures PP may correspond to the electronic units EU intended for pickup. Subsequently, the transfer head TH may be moved towards the second substrate SB2, and each of the protruding structures PP may contact the surface SR of its corresponding electronic unit EU, thereby picking up its corresponding electronic unit EU. The spacing of the protruding structures PP may be determined based on the spacing of the first recess R1 of the third substrate SB3, but is not limited thereto. Furthermore, the structural design of the transfer head TH and the method of picking up the electronic units EU shown in FIG. 46 are merely exemplary, and the present disclosure is not limited thereto.

Subsequently, a portion of the electronic units EU picked up by the transfer head TH may be transferred to the third substrate SB3, or more specifically, to the work region WR of the third substrate SB3. Specifically, the protruding structure PP of the transfer head TH may first be aligned with the first recess R1 of the third substrate SB3. Then, the transfer head TH may be moved towards the third substrate SB3, thereby causing the electronic unit EU to enter the first recess R1, thus positioning the electronic unit EU within the first recess R1 in the work region WR of the third substrate SB3. In this configuration, the bonding pad BP5 of the electronic unit EU facing the third substrate SB3 may come into contact with the bonding pad BP6 of the circuit layer CL1 of the third substrate SB3, thereby electrically connecting the electronic unit EU to the circuit layer CL1. Upon transferring the electronic unit EU to the third substrate SB3, an electronic device ED is formed. It should be noted that the electronic device ED may include other suitable elements and/or film layers, and is not limited to the configuration shown in FIG. 46.

Please note that after transferring the electronic unit EU to the work region WR of the third substrate SB3, it is optionally possible to perform an inspection step on the electronic unit EU and/or to execute a step for configuring and remedial electronic unit. The details of these procedures may be referenced in the aforementioned first embodiment, and therefore will not be reiterated herein.

Please refer to FIG. 45 to FIG. 47. FIG. 47 illustrates a cross-sectional view of an electronic device according to another embodiment of the present disclosure. Specifically, the electronic device ED shown in FIG. 45 and FIG. 46 may represent a cross-sectional view taken along line A-A' of the electronic device ED shown in FIG. 48, while the electronic device ED shown in FIG. 47 may represent a cross-sectional view taken along line B-B' of the electronic device ED shown in FIG. 48. According to this embodiment, as described above, when transferring the electronic unit EU from the second substrate SB2 to the third substrate SB3 to form the electronic device ED, only a portion of the electronic unit EU on the second substrate SB2 may be transferred, but this is not limited thereto. In other words, the electronic unit EU in the electronic device ED may be a portion of the electronic unit EU on the second substrate SB2. In this case, the electronic unit EU on the second substrate SB2 may be used in a plurality of transfer processes, or a single second substrate SB2 may be used to form a plurality of electronic devices ED. Specifically, the electronic unit EU on the first substrate SB1 may first be transferred to the second substrate SB2 through a fluidic transfer process and may be arranged on the second substrate SB2. Subsequently, a portion of the electronic unit EU on the second substrate SB2 (for example, through laser transfer process or stamp transfer process, but not limited thereto) may be transferred to the work region WR of the third substrate SB3. In some embodiments, in the second substrate SB2, there may be a spacing between the transferred portion of the electronic unit EU, where the spacing may be determined based on the spacing of the first recess R1 of the third substrate SB3, but is not limited thereto. In this case, the spacing of the recess RS of the second substrate SB2 may be smaller than the spacing of the work region WR of the third substrate SB3. For example, as shown in FIG. 45 and FIG. 47, there may be a spacing PS1 between the recesses RS of the second substrate SB2, while there may be a second spacing PS2 between the work regions WR of the third substrate SB3, wherein the second spacing PS2 is greater than the first spacing PS1. In the cross-sectional view of the second substrate SB2, the first spacing PS1 may be defined as the distance between the same side edges of two adjacent recesses RS. For example, the first spacing PS1 may be the distance between the left side edges of two adjacent recesses RS, but is not limited thereto. In the cross-sectional view of the third substrate SB3, the second spacing PS2 may be defined as the distance between the same side edges of two adjacent work regions WR. For example, the second spacing PS2 may be the distance between the left side edges of two adjacent work regions WR, but is not limited thereto. In this embodiment, the first spacing PS1 may be the spacing between two adjacent recesses RS in the arrangement direction of the recesses RS, while the second spacing PS2 may be the spacing between two adjacent work regions WR in the same direction. For example, the first spacing PS1 may be the spacing between two adjacent recesses RS in the direction X, while the second spacing PS2 may be the spacing between two adjacent work regions WR in the direction X, but is not limited thereto. In some embodiments, the first spacing PS1 may be the spacing between two adjacent recesses RS in the direction Y, while the second spacing PS2 may be the spacing between two adjacent work regions WR in the direction Y. In some embodiments, the second spacing PS2 may be an integer multiple of the first spacing PS1 (i.e., P2 = n * P1, where n is a positive integer).

In some embodiments, as illustrated in FIG. 47, each work region WR may include a plurality of sub-work regions SWR, wherein a sub-work region SWR may include, for example, a first recess R1 and/or or a second recess R2 adjacent to the first recess R1. When the electronic device ED includes a display device, a sub-work region SWR may be considered as a sub-pixel, but is not limited thereto. In this scenario, a third spacing PS3 may exist between sub-work regions SWR within a work region WR. In the cross-sectional view of the third substrate SB3, the third spacing PS3 may be defined as the distance between the same side edges of two adjacent sub-work regions SWR. For instance, the third spacing PS3 may be the distance between the left side edges of two adjacent sub-work regions SWR, but is not limited to this configuration. The third spacing PS3 may be defined in the same direction as the first spacing PS1 and the second spacing PS2. For example, the first spacing PS1 may be the spacing between two adjacent recesses RS in the direction X, while the third spacing PS3 may be the spacing between two adjacent sub-work regions SWR in the direction X. According to this embodiment, the third spacing PS3 is greater than the first spacing PS1. Furthermore, in some embodiments, the third spacing PS3 may be an integer multiple of the first spacing PS1 (i.e., P3 = n * P1, where n is a positive integer).

It should be noted that the electronic unit EU of the electronic device ED in this embodiment may be transferred to the third substrate SB3 through one or multiple transfer processes, and this disclosure is not limited thereto. In some embodiments, the electronic unit EU may be transferred to the third substrate SB3 through a single transfer process. In some embodiments, the electronic unit EU may include different types of electronic elements (for example, but not limited to, the aforementioned semiconductor units of different colors), and the electronic unit EU may be transferred to the third substrate SB3 through a plurality of transfer processes, enabling different types of electronic elements to be transferred respectively to their corresponding first recesses R1. Through the design of the aforementioned first spacing PS1, second spacing PS2, and third spacing PS3, it is conducive to utilizing a single second substrate SB2 for a plurality of transfer processes to form a plurality of electronic devices ED under various transfer processes of electronic units EU, thereby simplifying the process of the electronic device ED or reducing the production cost of the electronic device ED.

In conclusion, the present disclosure provides a method for manufacturing an electronic device, which includes utilizing a fluidic transfer technique to transfer electronic units and employing a laser transfer technique for the remedial process of electronic units. Consequently, this method may reduce the waste of electronic units or improve the yield of electronic devices. Furthermore, the disclosure presents a method for manufacturing an electronic device that involves using a fluidic transfer technique to transfer electronic units to a substrate, and subsequently transferring a portion of the electronic units from the substrate to another substrate. As a result, this approach may minimize the waste of electronic units, simplify the manufacturing process of electronic devices, or reduce production costs. Moreover, the disclosed method for manufacturing electronic devices includes a packaging process for semiconductor dies to form semiconductor chips prior to the fluidic transfer process. This is particularly advantageous when the semiconductor dies incorporate vertical embedded flip-chip structures or vertical embedded chip structures, as it facilitates the bonding of semiconductor chips to the target substrate during the fluidic transfer process.

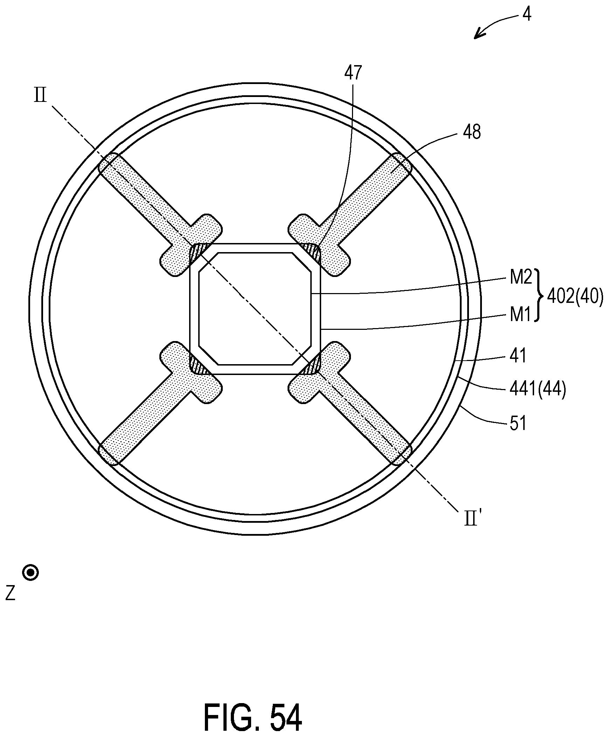

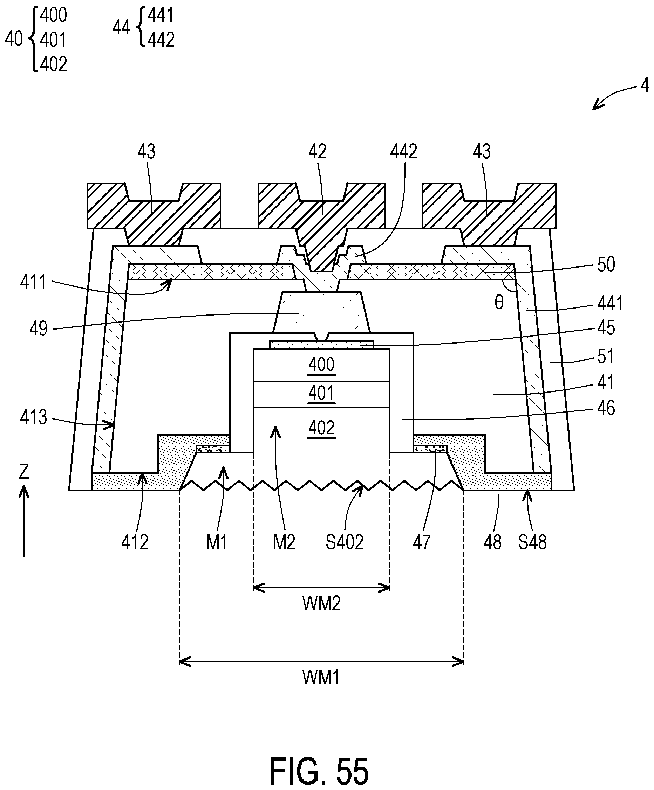

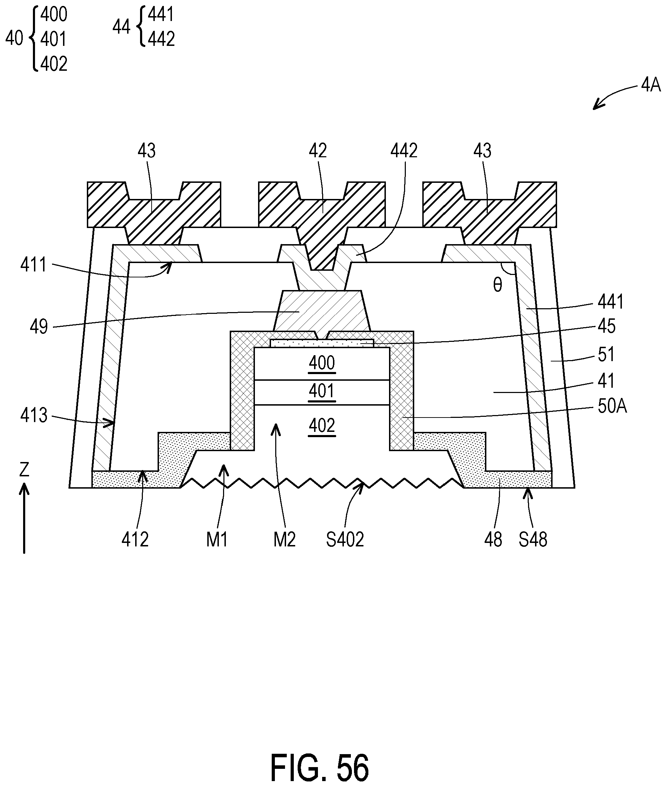

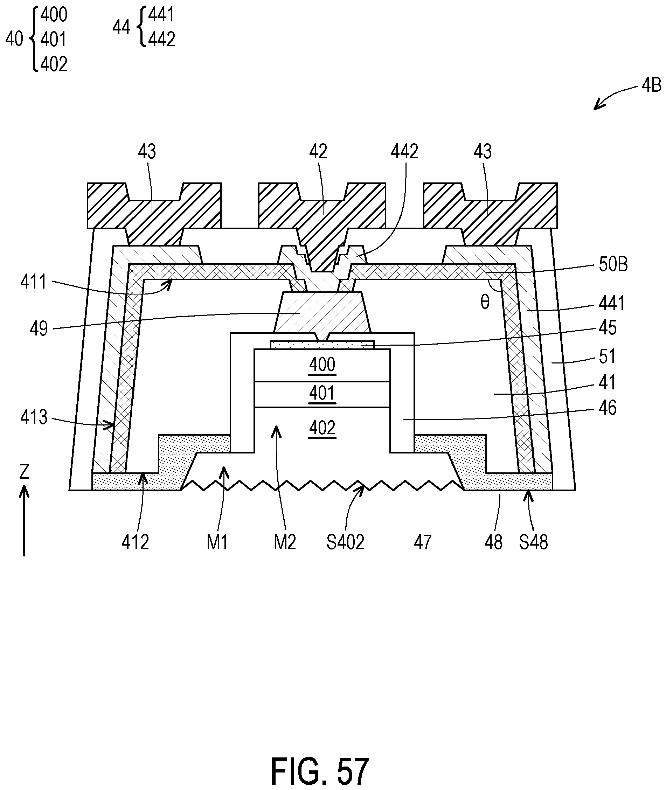

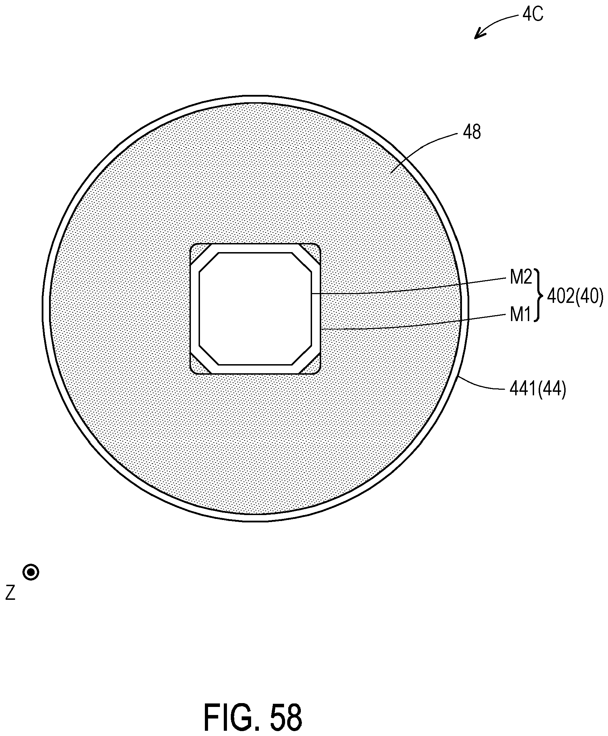

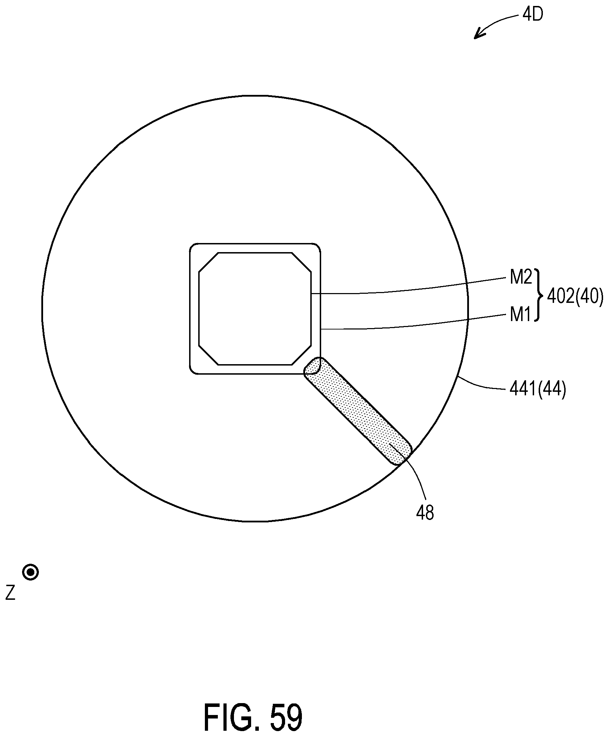

FIG. 54 is a top view of a semiconductor chip according to an embodiment of the present disclosure. FIG. 55 is a cross-sectional view corresponding to the cross-sectional line II-II' in FIG. 54. FIG. 56 and FIG. 57 are partial cross-sectional views of two types of semiconductor chips according to other embodiments of the present disclosure. FIG. 58 and FIG. 59 are top views of two types of semiconductor chips according to other embodiments of the present disclosure. In FIG. 54, FIG. 58, and FIG. 59, for the sake of clarity in the drawings, some elements of the semiconductor chip are omitted from illustration.

Please refer to FIG. 54 and FIG. 55. The semiconductor chip 4 may include, but is not limited to, a semiconductor die 40, a filler layer 41, a first electrode 42, a second electrode 43, and a reflective layer 44. Depending on various requirements, the semiconductor chip 4 may also include additional elements or film layers. As illustrated in FIG. 55, the semiconductor chip 4 may further include an ohmic contact layer 45, an insulating layer 46, an ohmic contact layer 47, a conductive layer 48, a conductive layer 49, a reflective layer 50, and an insulating layer 51.

The semiconductor die 40 may be a vertical type chip. In the direction Z, the semiconductor die 40 includes, from top to bottom, a first type semiconductor layer 400, an active layer 401, and a second type semiconductor layer 402, and the active layer 401 is disposed between the first type semiconductor layer 400 and the second type semiconductor layer 402.

In the present embodiment, the semiconductor die 40 may be a light-emitting element (e.g., an organic light-emitting diode, sub-millimeter light-emitting diode, micro-light-emitting diode, or quantum dot light-emitting diode, but not limited thereto), without limitation. In the present embodiment, the first type semiconductor layer 400 may be a P-type semiconductor layer, and the second type semiconductor layer 402 may be an N-type semiconductor layer, without limitation. In some embodiments, the first type semiconductor layer may also be an N-type semiconductor layer, and the second type semiconductor layer may also be a P-type semiconductor layer. In the present embodiment, the active layer 401 may be a light-emitting layer, without limitation.

In some embodiments, as illustrated in FIG. 55, the second type semiconductor layer 402 may have a first mesa M1 and a second mesa M2, wherein the second mesa M2 is disposed on and in contact with the first mesa M1, and the width WM2 of the second mesa M2 may be less than the width WM1 of the first mesa M1. The active layer 401 and the first type semiconductor layer 400 are disposed on the second mesa M2 in sequence, and the active layer 401 and the first type semiconductor layer 400 may have the same width as the second mesa M2, but are not limited thereto.

In some embodiments, as illustrated in FIG. 55, the surface S402 of the first mesa M1 facing away from the second mesa M2 may be a rough surface. By way of example, and without limitation, the surface S402 may be roughened through an etching process. In alternative embodiments, although not depicted, the surface S402 of the first mesa M1 facing away from the second mesa M2 may be a planar surface. When the surface S402 is planar, the surface S402 may, without limitation, be aligned with the bottom surface S48 (e.g., the surface of the conductive layer 48 away from the filler layer 41) of the conductive layer 48. Subsequent embodiments may be modified accordingly, and such modifications will not be reiterated hereinafter.

The ohmic contact layer 45 is disposed on the first type semiconductor layer 400. By way of example, the material of the ohmic contact layer 45 may include chromium, titanium, aluminum, indium tin oxide, or other conductive materials.

The insulating layer 46 is disposed on the ohmic contact layer 45 and laterally surrounds the first type semiconductor layer 400, the active layer 401, and the second mesa M2. The material of the insulating layer 46 may include, but is not limited to, acrylic-based compounds, epoxy-based compounds, siloxane, silicon dioxide, silicon nitride, silicon oxynitride, other suitable insulating materials, or combinations thereof.

The ohmic contact layer 47 is disposed on the first mesa M1 and positioned between the conductive layer 48 and the first mesa M1. The material of the ohmic contact layer 47 may be referenced to the material of the ohmic contact layer 45, which shall not be reiterated herein.

The conductive layer 48 is disposed on the first mesa M1 and covers the ohmic contact layer 47. The inner edge of the conductive layer 48 may contact the insulating layer 46, and the outer edge of the conductive layer 48 may extend beyond the side edge of the first mesa M1 in a direction away from the second mesa M2. The material of the conductive layer 48 may include indium tin oxide, chromium, platinum, titanium, nickel, aluminum, gold, titanium tungsten, copper, or other conductive materials. In some embodiments, as shown in FIG. 54, the shape of the conductive layer 48 in top view may be T-shaped or of another configuration. By modulating the shape of the conductive layer 48 in top view to reduce the area occupied by the conductive layer 48, it is possible to decrease the shielding or absorption of light by the conductive layer 48, enhance light extraction efficiency, and alter the light pattern or light intensity distribution of the emitted light.

The conductive layer 49 is disposed on the insulating layer 46 and penetrates through the insulating layer 46 to electrically connect with the ohmic contact layer 45. The material of the conductive layer 49 may be referenced to the material of the conductive layer 48, which will not be reiterated herein.

The filler layer 41 surrounds the semiconductor die 40. For instance, the filler layer 41 may partially cover the conductive layer 49 and the conductive layer 48, and the filler layer 41 may laterally encompass the insulating layer 46 and the conductive layer 49. The filler layer 41 has a first surface 411, a second surface 412, and a side surface 413. The first surface 411 and the second surface 412 are opposite to each other, and the side surface 413 connects the first surface 411 and the second surface 412. In this embodiment, the angle θ between the first surface 411 and the side surface 413 may range from 90 degrees to 150 degrees, serving to converge the light emitted from the semiconductor die 40, reduce the light emission angle of the semiconductor die 40, or enhance the light output efficiency of the semiconductor die 40, but is not limited thereto.

The reflective layer 50 is disposed on the first surface 411 and partially exposes the conductive layer 49. The reflective layer 50, for example, is a Bragg reflector layer, which may be utilized to enhance the light conversion efficiency of the semiconductor chip 4, improve the color purity of the semiconductor chip 4, or increase the light utilization efficiency. In some embodiments, the semiconductor chip 4 may not include the reflective layer 50.

The reflective layer 44 is disposed on the filler layer 41 and the semiconductor die 40. The material of the reflective layer 44 may include materials with high reflectivity, for the purpose of converging the light emitted from the semiconductor die 40, reducing the light emission angle of the semiconductor die 40, or enhancing the light output efficiency of the semiconductor die 40.

In some embodiments, the reflective layer 44 may include a first portion 441 and a second portion 442. The first portion 441 and the second portion 442 are separated from each other. The first portion 441 is, for example, disposed on the side surface 413 of the filler layer 41, wherein one end of the first portion 441 may contact and be electrically connected to the conductive layer 48, and the other end of the first portion 441 may extend upward to the reflective layer 50 located on the first surface 411. The second portion 442 may contact a portion of the conductive layer 49 exposed by the filler layer 41 and the reflective layer 50.

The insulating layer 51 is disposed on the reflective layer 44 and the reflective layer 50, and laterally surrounds the first portion 441 and the conductive layer 48. The material of the insulating layer 51 may be referenced to the material of the insulating layer 46, which will not be reiterated herein.

The first electrode 42 is disposed on the insulating layer 51 and penetrates through the insulating layer 51 to be electrically connected with the second portion 442. Consequently, the first electrode 42 is capable of electrically connecting to the first type semiconductor layer 400 through the second portion 442, the conductive layer 49, and the ohmic contact layer 45.

The second electrode 43 is disposed on the insulating layer 51 and penetrates through the insulating layer 51 to be electrically connected with the first portion 441. Consequently, the second electrode 43 is capable of being electrically connecting with the second type semiconductor layer 402 through the first portion 441, the conductive layer 48, and the ohmic contact layer 47.

The materials of the first electrode 42 and the second electrode 43 may include, but are not limited to, gold, tin, copper, other suitable electrode materials, or combinations thereof. In some embodiments, the first electrode 42 may be a P-type electrode, and the second electrode 43 may be an N-type electrode, but this configuration is not limited thereto. In other embodiments, the first electrode 42 may be an N-type electrode, and the second electrode 43 may be a P-type electrode. Herein, an N-type electrode refers to an electrode electrically connected to an N-type semiconductor layer, and a P-type electrode refers to an electrode electrically connected to a P-type semiconductor layer.

Through the architecture illustrated in FIG. 55, it is possible to form the elements and film layers in the semiconductor chip 4 on a single carrier sequentially, and to perform electrical testing directly through the first electrode 42 and the second electrode 43. This method eliminates the necessity of inverting the chip to form conductive layers (for example, conductive layer 48 and/or conductive layer 50) as demonstrated in the steps depicted in FIG. 29C and FIG. 29D, for example.

Please refer to FIG. 56. The primary differences between the semiconductor chip 4A and the semiconductor chip 4 in FIG. 55 are elucidated as follows. In the semiconductor chip 4A, the insulating layer 46 depicted in FIG. 55 is supplanted by a reflective layer 50A (e.g., a Bragg reflector layer), and the reflective layer 50 shown in FIG. 55 is omitted. Furthermore, the semiconductor chip 4A may or may not incorporate the ohmic contact layer 47 present in FIG. 55.

Please refer to FIG. 57. The main differences between the semiconductor chip 4B and the semiconductor chip 4 in FIG. 55 are explained as follows. In the semiconductor chip 4B, the reflective layer 50B (e.g., a Bragg reflector layer) further covers the side surface 413 of the filler layer 41, thereby enhancing light extraction efficiency and modifying the light pattern or light intensity distribution of the emitted light. Moreover, the semiconductor chip 4B may or may not include the ohmic contact layer 47 depicted in FIG. 55.

Please refer to FIG. 58 and FIG. 59. The primary differences between the semiconductor chips 4C, 4D, and the semiconductor chip 4 in FIG. 54 lie in the shape of the conductive layer 48 (e.g., Bragg reflector layer) in top view or occupied area. In the semiconductor chip 4C, the conductive layer 48 covers a majority of the second surface 412 of the filler layer 41. In the semiconductor chip 4D, the area occupied by the conductive layer 48 on the second surface 412 of the filler layer 41 is reduced. This reduction serves to decrease the shielding or absorption of light by the conductive layer 48, enhance light extraction efficiency, modify the light pattern or light intensity distribution of the emitted light, and so on.

The aforementioned embodiments are presented solely for the purpose of elucidating the technical solutions disclosed herein and should not be construed as limitations thereof. Notwithstanding the detailed exposition of the present disclosure with reference to the precedings, it should be understood by those skilled in the art that: modifications may still be made to the technical solutions described in the forward embodiments, or equivalent substitutions may be implemented for part or all of the technical features thereof; and such modifications or substitutions shall not cause the essence of the corresponding technical solutions to deviate from the scope of the technical solutions of the embodiments of the present disclosure.

Although the embodiments and their advantages have been disclosed as above, it should be understood that those skilled in the art may make modifications, substitutions, and improvements within the spirit and scope of this disclosure, and the features between them may be arbitrarily mixed and replaced to form other new embodiments. Furthermore, the scope of protection of this disclosure is not limited to the specific embodiments, processes, machines, manufactures, compositions of matter, means, methods, and steps described in the specification. Any person skilled in the art may understand from the content disclosed herein that current or future developed processes, machines, manufactures, compositions of matter, means, methods, and steps that perform substantially the same function or achieve substantially the same result as described in the embodiments herein may be used according to this disclosure. Therefore, the scope of protection of this disclosure includes the aforementioned processes, machines, manufactures, compositions of matter, means, methods, and steps. Additionally, each claim constitutes a separate embodiment, and the scope of protection of this disclosure also includes combinations of the individual claims and embodiments. The scope of protection of this disclosure shall be construed in accordance with the accompanying claims.

## Claims

1. A semiconductor chip, comprising:
a semiconductor die (110'), comprising a first type semiconductor layer (111), an active layer (112), and a second type semiconductor layer (113) stacked in sequence;
a filler layer (120), surrounding the semiconductor die (110');
a first electrode (130A), electrically connected to the first type semiconductor layer (111);
a second electrode (140A), electrically connected to the second type semiconductor layer (113); and
a reflective layer (150A), disposed on the filler layer (120).

2. The semiconductor chip according to claim 1, wherein the second electrode (140A) is electrically connected to the reflective layer (150A).

3. The semiconductor chip according to claim 1 or 2, wherein the filler layer (120) comprises a first surface (121), a second surface (122) opposite to the first surface (121), and a lateral surface (123') located between the first surface (121) and the second surface (122), and the reflective layer (150A) comprises a first portion (151A) disposed on the lateral surface (123').

4. The semiconductor chip according to claim 3, wherein the reflective layer (150A) further comprises a second portion (152A) disposed on the first surface (121), the second electrode (140A) is electrically connected to the first portion (151A), and the first portion (151A) is electrically connected to the second portion (152A).

5. The semiconductor chip according to claim 4, wherein the first electrode (130A) and the second portion (152A) of the reflective layer (150A) are disposed on a same side of the semiconductor die (110').

6. The semiconductor chip according to any one of claims 3 to 5, wherein the second electrode (140A) is at least partially disposed on the second surface (122) of the filler layer (120).

7. The semiconductor chip according to any one of claims 3 to 6, wherein the lateral surface (123') forms an angle (01') with respect to the first surface (121), and the angle (01') ranges from 90 degrees to 150 degrees.

8. The semiconductor chip according to any one of claims 1 to 7, wherein the filler layer (120) comprises a light conversion material (124).

9. The semiconductor chip according to any one of claims 1 to 8, further comprising:
a light-shielding electrode (160A), disposed between the second type semiconductor layer (113) and the second electrode (140A), and electrically connected to the second type semiconductor layer (113) and the second electrode (140A), wherein, with respect to a visible light spectrum, a transmittance of the light-shielding electrode (160A) is less than a transmittance of the second electrode (140A).

10. The semiconductor chip according to any one of claims 1 to 9, wherein the semiconductor die comprises a first side (E1) where the first type semiconductor layer (SL1) is located and a second side (E2) where the second type semiconductor layer (SL2) is located, the filler layer (102) has a first width (W1) on the first side (E1) and a second width (W2) on the second side (E2), wherein the second width (W2) is greater than the first width (W1).

11. An electronic device, comprising:
a substrate (210'),
a circuit layer (220"), disposed on the substrate (210'); and
a semiconductor chip (100"), disposed on the substrate (210') and electrically connected to the circuit layer (220"), wherein the semiconductor chip (100") comprises:
a semiconductor die (110'), comprising a first type semiconductor layer (111), an active layer (112), and a second type semiconductor layer (113) stacked in sequence;
a filler layer (120), surrounding the semiconductor die (110');
a first electrode (130A), electrically connected to the first type semiconductor layer (111);
a second electrode (140A), electrically connected to the second type semiconductor layer (113); and
a reflective layer (150A), disposed on the filler layer (120).

12. The electronic device according to claim 11, further comprising:
a unit defining layer (230A), disposed on the circuit layer (220"), and comprising an opening (O1') for accommodating the semiconductor chip (100"); and
a bottom filler layer (240'), disposed within the opening (O1') and surrounding the semiconductor chip (100").

13. A method of manufacturing an electronic device, comprising:
providing a plurality of semiconductor dies (S300);
performing a packaging process on the plurality of semiconductor dies to form a plurality of semiconductor chips, wherein the packaging process comprises:
respectively disposing a plurality of filler material layers on a sidewall of each of the plurality of semiconductor dies (S302);
disposing a first electrode on a first surface of the each of the plurality of semiconductor dies (S304); and
disposing a conductive layer on a sidewall of each of the plurality of filler material layers (S306);
providing a substrate, wherein the substrate comprises a plurality of work regions, each of the plurality of work regions comprises at least one first recess (S102); and
disposing the plurality of semiconductor chips in the at least one first recess of the plurality of work regions by means of fluidic transfer (S 104).

14. The method for manufacturing the electronic device according to claim 13, wherein the each of the plurality of work regions further comprise at least one second recess (S 102).

15. The method for manufacturing the electronic device according to claim 14, further comprising:
identifying a defective work region from the plurality of work regions (S 106), wherein in the defective work region, at least one of the at least one first recess does not contain any of the semiconductor chip or contains a defective semiconductor chip; and
placing at least one remedial semiconductor chip in at least one of the at least one second recess within the defective work region (S108).
